# EUROPÄISCHE PATENTSCHRIFT

(11) **EP 2 044 169 B1**
(45) Veröffentlichungstag und Bekanntmachung des Hinweises auf die Patenterteilung: **25.11.2009**
(21) Anmeldenummer: 07786839.6
(22) Anmeldetag: 25.06.2007
(51) Int. Cl.: C09K 11/06, H05B 33/14, C07F 15/00

(54) **VERWENDUNG VON PT- UND PD-BIS- UND TETRACARBENKOMPLEXEN MIT VERBRÜCKTEN CARBENLIGANDEN IN OLEDS**
USE OF PT- AND PD-BIS- AND TETRA-CARBON COMPLEXES WITH BRIDGED CARBON LIGANDS IN OLEDS
UTILISATION DE COMPLEXES PT- ET PD-BIS- ET TÉTRACARBÈNE AVEC DES LIGANDS CARBÈNE PONTÉS DANS DES DIODES ÉLECTROLUMINESCENTES ORGANIQUES

(30) Priorität: 26.06.2006 EP 06116100
(43) Veröffentlichungstag der Anmeldung: 08.04.2009
(73) Patentinhaber: BASF SE, 67056 Ludwigshafen (DE); Technische Universität Dresden, 01069 Dresden (DE)
(72) Erfinder: STRASSNER, Thomas, 01156 Dresden (DE); UNGER, Yvonne, 01159 Dresden (DE); ZELLER, Alexander, 86199 Augsburg (DE)
(74) Vertreter: Isenbruck, Günter
(86) Internationale Anmeldenummer: PCT/EP2007/056331
(87) Internationale Veröffentlichungsnummer: WO 2008/000726

(56) Entgegenhaltungen:
- WO-A-2005/113704

## Beschreibung

Die vorliegende Erfindung betrifft die Verwendung von Pt- und Pd-Bis- und Tetracarbenkomplexen, mit verbrückten Carbenliganden in organischen Leuchtdioden, organische Leuchtdioden, enthaltend mindestens einen vorstehend genannten Pt- oder Pd-Carbenkomplex, organische Leuchtdioden, wobei der mindestens eine Übergangsmetallcarbenkomplex der allgemeinen Formel I und/oder II in der Licht-emittierenden Schicht, einer Blockschicht für Elektronen, einer Blockschicht für Excitonen und/oder einer Blockschicht für Löcher vorliegt, eine Licht-emittierende Schicht, enthaltend mindestens einen vorstehend genannten Pt- oder Pd-Carbenkomplex, organische Leuchtdioden, enthaltend mindestens eine erfindungsgemäße Licht-emittierende Schicht sowie Vorrichtungen, die mindestens eine erfindungsgemäße organische Leuchtdiode enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, z. B. für Anwendungen in Handys, Laptops, usw.

Die Grundprinzipien der Funktionsweise von OLEDs sowie geeignete Aufbauten (Schichten) von OLEDs sind z. B. in WO 2005/113704 und deren zitierten Literatur genannt.

Im Stand der Technik wurden bereits zahlreiche Materialien vorgeschlagen, die bei der Anregung durch elektrischen Strom Licht emittieren.

In WO 2005/019373 ist erstmals die Verwendung von neutralen Übergangsmetallkomplexen, die mindestens einen Carbenliganden enthalten, in OLEDs offenbart. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

WO 2005/113704 betrifft lumineszente Verbindungen, die Carbenliganden tragen. Gemäß WO 2005/113704 sind zahlreiche Übergangsmetallkomplexe mit verschiedenen Carbenliganden genannt, wobei die Übergangsmetallkomplexe bevorzugt als phosphoreszierendes-lichtemittierendes Material, besonders bevorzugt als Dotiersubstanz, eingesetzt werden.

Sowohl die in WO 2005/019373 als auch die in WO 2005/113704 offenbarten Übergangsmetallcarbenkomplexe weisen Carbenliganden auf, die durch Cyclometallierung an das Übergangsmetallatom gebunden sind. Dabei erfolgt die Verknüpfung des oder der Carbenliganden mit dem Übergangsmetall zum Einen über das Carbenkohlenstoffatom und des Weiteren über ein weiteres Kohlenstoff- oder Heteroatom.

Aufgabe der vorliegenden Erfindung gegenüber dem vorstehend genannten Stand der Technik ist es, weitere Übergangsmetallcarbenkomplexe für die Verwendung in OLEDs bereitzustellen, die ein ausgewogenes Eigenschaftsspektrum zeigen, z. B. gute Stabilität, gute Effizienzen und/oder eine verbesserte Lebensdauer.

Diese Aufgabe wird gelöst durch die Verwendung von Übergangsmetallkomplexen ausgewählt aus Übergangsmetallcarbenkomplexen der allgemeinen Formeln (I) und (II) in organischen Leuchtdioden. 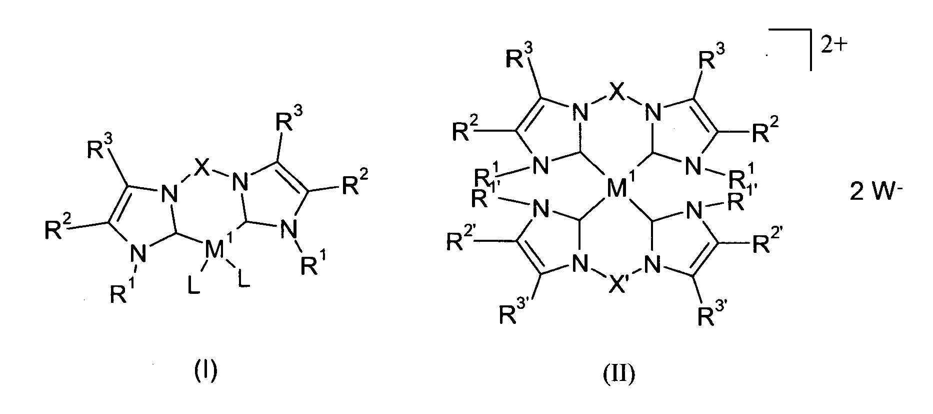 worin die Symbole die folgenden Bedeutungen aufweisen:
- M¹: Pt(II), Pd(II);
- L: monodentater monoanionischer Ligand;
- R¹, R^{1'}: jeweils unabhängig voneinander Wasserstoff, Alkyl, Cycloalkyl, Aryl, Heteroaryl, Aralkyl;
- R², R³, R^{2'}, R^{3'}: unabhängig voneinander Wasserstoff, Alkyl, Aryl, oder R² und R³ oder R^{2'} und R^{3'} bilden jeweils gemeinsam eine Brücke aus 3, 4 oder 5, bevorzugt 4 Kohlenstoffatomen, die gesättigt oder ein oder zweifach ungesättigt sein kann und gegebenenfalls mit einem oder mehreren C₁- bis C₆-Alkylresten substituiert sein kann, bevorzugt eine unsubstituierte zweifach ungesättigte Brücke aus 4 Kohlenstoffatomen, die die folgende Struktur aufweist: 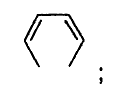
- X, X': unabhängig voneinander Alkylen, 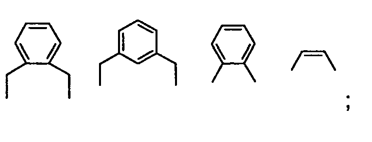
- W⁻: monoanionisches Gegenion;

Die vorstehend genannten erfindungsgemäß verwendeten Übergangsmetallcarbenkomplexe der allgemeinen Formeln I und II weisen keine Cyclometallierung der Carbenliganden über ein weiteres Kohlenstoff- oder Heteroatom auf. Es wurde überraschenderweise gefunden, dass ausreichend stabile, zur Verwendung in OLEDs geeignete Übergangsmetallcarbenkomplexe bereitgestellt werden können, ohne dass eine Cyclometallierung der oder des Carbenliganden über ein weiteres Kohlenstoff- oder Heteroatom erforderlich ist.

Falls verschiedene Isomere der erfindungsgemäß verwendeten Übergangsmetallcarbenkomplexe der Formeln I oder II vorliegen können, umfasst die vorliegende Erfindung sowohl jeweils die einzelnen Isomere der Übergangsmetallcarbenkomplexe der Formel I als auch Gemische verschiedener Isomere in jedem beliebigen Mischungsverhältnis. Im Allgemeinen können verschiedene Isomere der Metallkomplexe der Formeln I und II nach dem Fachmann bekannten Verfahren, z. B. durch Chromatographie, Sublimation oder Kristallisation, getrennt werden.

Die Übergangsmetallcarbenkomplexe der Formeln I und II können in jeder Schicht eines OLEDs eingesetzt werden, wobei das Ligandgerüst oder Zentralmetall zur Anpassung an gewünschte Eigenschaften der Metallkomplexe variiert werden kann. Beispielsweise ist der Einsatz der Übergangsmetallcarbenkomplexe der Formeln I und II in einer Blockschicht für Elektronen, einer Blockschicht für Excitonen, einer Blockschicht für Löcher oder der Licht-emittierenden Schicht des OLEDs möglich. Bevorzugt werden die Verbindungen der Formeln I und II als Emittermoleküle in OLEDs verwendet.

Unter einem monodentaten Liganden ist ein Ligand zu verstehen, der an einer Stelle des Liganden mit dem Übergangsmetallatom M¹ koordiniert.

Übergangsmetallcarbenkomplexe, die ausschließlich eine Verknüpfung des oder der Carbenliganden mit dem Übergangsmetallatom über Carbenkohlenstoffatome aufweisen, sind im Stand der Technik bekannt.

W. J. Youngs et al., J. Organomet. Chem. 671 (2003) 183 bis 186 betrifft die Synthese und strukturelle Charakterisierung von zwei Bis(imidazol-2-ylidenrPt(II)-Komplexen. Eine Anwendung dieser Komplexe ist jedoch nicht angegeben.

M. Albrecht et al., Inorganica Chimica Acta 359 (2006) 1929-1938 betrifft die Synthese und strukturelle Analyse von Palladium-Biscarbenkomplexen, die Bisimidazolium-Liganden tragen. Insbesondere betrifft M. Albrecht et al. mechanistische Untersuchungen der Metallierung des Bisimidazolium-Liganden.

Ch.-M. Che et al., Organometallics 1998, 17, 1622 bis 1630 betrifft eine Untersuchung der spektroskopischen Eigenschaften von lumineszierenden Rhenium(I)-N-heterocyclischen Carbenkomplexen, die aromatische photoaktive Diiminliganden tragen. Die Untersuchung der spektroskopischen Eigenschaften der Komplexe dient dazu, die elektronischen Verhältnisse in diesen Komplexen besser zu verstehen. Eine Anwendung der N-heterocyclischen Rhenium(I)-Carbenkomplexe sowie mögliche elektrolumineszente Eigenschaften sind in Ch.-M. Che nicht angegeben.

Des Weiteren sind in DE-A 10 2005 058 206 N-heterocyclische Biscarbenkomplexe des Platins und Palladiums, deren Herstellung und deren Verwendung als Katalysator, insbesondere als Katalysator zur partiellen Oxidation von Kohlenwasserstoffen oder kohlenwasserstoffhaltigen Beschickungen, offenbart. DE-A 10 2005 058 206 enthält jedoch keine Information bezüglich der Lumineszenzeigenschaften der offenbarten Komplexe.

Die Eignung von Übergangsmetallcarbenkomplexen der Formeln I und II gemäß der vorliegenden Erfindung zur Anwendung in OLEDs ist in keinem der vorstehend genannten Dokumente erwähnt. Es wurde somit gefunden, dass die Übergangsmetallcarbenkomplexe der Formeln I und II gemäß der vorliegenden Anmeldung zum Einsatz in OLEDs geeignet sind.

Geeignete monoanionische Liganden L, die monodentat sind, sind die üblicherweise als monodentate monoanionische Liganden eingesetzten Liganden.

Üblicherweise werden als Liganden L nicht-photoaktive Liganden eingesetzt. Geeignete Liganden L sind Halogenide, insbesondere Cl⁻, Br⁻, I⁻, Pseudohalogenide, insbesondere CN⁻, und Alkoxy und OAc⁻ sowie CF₃COO⁻, bevorzugte Liganden L sind Br⁻, I⁻ und OAc⁻ sowie CF₃COO⁻.

Geeignete monoanionische Gegenionen W⁻ sind z. B. Halogenide, insbesondere Cl⁻, Br⁻, I⁻, Pseudohalogenide, insbesondere CN⁻, Alkoxy, OAc⁻, BF₄⁻, PF₆⁻, SbF₆⁻, AsF₆⁻, SCN⁻, OCN⁻ und ClO₄⁻, bevorzugte monoanionische Gegenionen sind Br⁻ und I⁻.

Im Sinne der vorliegenden Anmeldung haben die Begriffe Arylrest oder -gruppe, Alkylrest oder -gruppe, Cycloalkylrest oder -gruppe, Aralkylrest oder -gruppe, Alkoxyrest oder -gruppe die folgenden Bedeutungen:

Unter einem Arylrest (oder -gruppe) ist ein Rest mit einem Grundgerüst von 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl. Bevorzugt ist der Arylrest ein C₆-Arylrest, der mit mindestens einem der vorstehend genannten Substituenten substituiert ist. Besonders bevorzugt weist der C₆-Arylrest, einen, zwei oder drei Alkylreste auf, wobei der eine Substituent in ortho-, meta- oder para-Position zur weiteren Verknüpfungsstelle des Arylrestes angeordnet ist, und - im Falle von zwei Substituenten - können diese jeweils in meta-Position oder ortho-Position zur weiteren Verknüpfungsstelle des Arylrestes angeordnet sein oder ein Rest ist in ortho-Position und ein Rest in meta-Position angeordnet oder ein Rest ist in ortho- oder meta-Position angeordnet und der weitere Rest ist in para-Position angeordnet. Im Falle von drei Substituenten sind diese bevorzugt in ortho- (zwei der drei Substituenten) und p-Position (dritter Substituent) zur weiteren Verknüpfungsstelle des Arylrests angeordnet.

Unter einem Alkylrest oder einer Alkylgruppe ist ein Rest mit 1 bis 8 Kohlenstoffatomen, bevorzugt 1 bis 4 Kohlenstoffatomen zu verstehen. Dieser Alkylrest kann verzweigt oder unverzweigt sein. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl, iso-Propyl und n-Butyl.

Unter einem Alkoxyrest oder einer Alkoxygruppe ist ein O-Alkylrest zu verstehen. Geeignete Alkylreste sind vorstehend genannt.

Unter einem Cycloalkylrest oder einer Cycloalkylgruppe ist ein Rest mit 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Besonders bevorzugt ist Cyclohexyl.

Unter einem Aralkylrest (oder -gruppe) ist ein Rest mit einem Grundgerüst von 6 bis 18 Kohlenstoffatomen zu verstehen, der unsubstutiert oder mit den bezüglich der Arylgruppen genannten Resten substituiert sein kann. Bevorzugt bedeutet die Aralkylgruppe Benzyl.

Der Begriff Alkylen, hat im Sinne der vorliegenden Anmeldung die bezüglich der Alkylreste genannten Bedeutungen mit dem Unterschied, dass die Alkylengruppe zwei Bindungsstellen zu den Stickstoffatomen der Biscarbenliganden in den Übergangsmetallcarbenkomplexen der Formeln I und II aufweisen. Bevorzugte Alkylengruppen sind (CR⁴₂)ₙ, wobei R⁴ H oder Alkyl, bevorzugt H, Methyl oder Ethyl, besonders bevorzugt H und n 1 bis 3, bevorzugt 1 oder 2, besonders bevorzugt 1 bedeutet. Ganz besonders bevorzugt ist die Alkylengruppe CH₂.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Bevorzugt weisen die Symbole und Reste R¹, R², R³, R^{1'}, R^{2'}, R^{3'}, X, X^{'}, M¹, L und W⁻ in den Übergangsmetallcarbenkomplexen der Formeln I und II die folgenden Bedeutungen auf:
- M¹: Pt(II), Pd(II), bevorzugt Pt(II);
- L: monodentater monoanionischer Ligand, bevorzugt unabhängig voneinander ausgewählt aus Halogeniden, Pseudohalogeniden und Alkoxy, OAc⁻ sowie CF₃COO, besonders bevorzugt Cl⁻, Br⁻, I⁻, CN⁻ oder OAc⁻ sowie CF₃COO, ganz besonders bevorzugt OAc⁻, Br⁻ oder I⁻ sowie CF₃COO⁻;
- R¹, R^{1'}: unabhängig voneinander Wasserstoff, Alkyl, Cycloalkyl, Aryl, Aralkyl, bevorzugt, C₁-C₄-Alkyl, Cyclohexyl, 2,4,6-Trimethylphenyl oder Benzyl, besonders bevorzugt Methyl, iso-Propyl, n-Butyl;
- R², R³, R^{2'}, R³,: unabhängig voneinander Wasserstoff oder Alkyl, bevorzugt Wasserstoff, oder R² und R³ oder R^{2'} und R^{3'} bilden jeweils gemeinsam eine Brücke aus 3, 4 oder 5, bevorzugt 4 Kohlenstoffatomen, die gesättigt oder ein oder zweifach ungesättigt sein kann und gegebenenfalls mit einem oder mehreren C₁- bis C₆-Alkylresten substituiert sein kann, bevorzugt eine unsubstituierte zweifach ungesättigte Brücke aus 4 Kohlenstoffatomen, die die folgende Struktur aufweist: 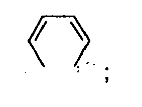
- X, X': unabhängig voneinander Alkylen oder 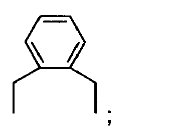 bevorzugt (CR⁴₂)ₙ, 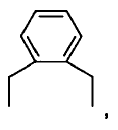 wobei R⁴ H, Alkyl, bevorzugt H, Methyl oder Ethyl, besonders bevorzugt H und n 1 bis 3, bevorzugt 1 oder 2, besonders bevorzugt 1, bedeuten, ganz besonders bevorzugt CH₂, 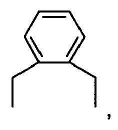 insbesondere ganz besonders bevorzugt CH₂;
- W⁻: monoanionisches Gegenion, bevorzugt Halogenid, Pseudohalogenid oder OAc⁻, besonders bevorzugt Cl⁻, Br⁻, I⁻, CN⁻, OAc⁻, ganz besonders bevorzugt Br⁻ oder I⁻.

In einer Ausführungsform betrifft die vorliegende Anmeldung die Verwendung von Pt- und Pd-Biscarbenkomplexen der allgemeinen Formel (I) 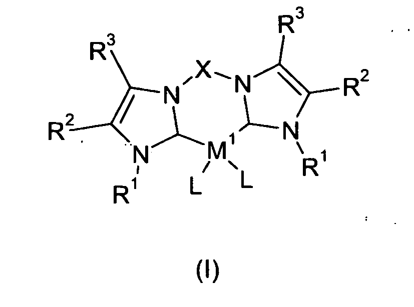 worin bedeuten:
- M¹: Pt(II), Pd(II);
- X: CH₂ oder 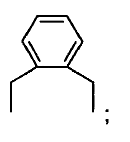
- R¹: unabhängig voneinander C₁-C₄-Alkyl, Cyclohexyl, 2,4,6-Trimethylphenyl oder Benzyl, bevorzugt Methyl, iso-Propyl, n-Butyl, Cyclohexyl, 2,4,6-Trimethylphenyl oder Benzyl;
- R², R³: unabhängig voneinander Wasserstoff oder Alkyl, bevorzugt Wasserstoff, oder R² und R³ bilden gemeinsam eine Brücke aus 3, 4 oder 5, bevorzugt 4 Kohlenstoffatomen, die gesättigt oder ein oder zweifach ungesättigt sein kann und gegebenenfalls mit einem oder mehreren C₁- bis C₆-Alkylresten substituiert sein kann, bevorzugt eine unsubstituierte zweifach ungesättigte Brücke aus 4 Kohlenstoffatomen, die die folgende Struktur aufweist: 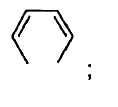
- L: unabhängig voneinander ausgewählt aus Halogeniden, Pseudohalogeniden und OAc⁻ sowie CF₃COO⁻, bevorzugt Cl⁻, Br⁻, I⁻, CN⁻ oder OAc⁻ sowie CF₃COO⁻, besonders bevorzugt Br⁻, I⁻ oder OAc⁻ sowie CF₃COO⁻.

Bevorzugt weisen R¹, R² und R³ in dem Biscarbenkomplex der Formel I jeweils dieselben Bedeutungen auf, so dass der Biscarbenligand symmetrisch ist.

In einer weiteren Ausführungsform betrifft die vorliegende Erfindung Tetracarbenkomplexe, die zwei Biscarbenliganden tragen. Bei den Tetracarbenkomplexen kann es sich um homoleptische Tetracarbenkomplexe handeln, das heißt, die beiden Biscarbenliganden in den homoleptischen Tetracarbenkomplexen sind identisch. Es kann sich jedoch auch um heteroleptische Tetracarbenkomplexe handeln, das heißt, die beiden Biscarbenliganden in den heteroleptischen Tetracarbenkomplexen sind nicht identisch.

Die gemäß der vorliegenden Anmeldung verwendeten Tetracarbenkomplexe weisen die allgemeine Formel (II) auf 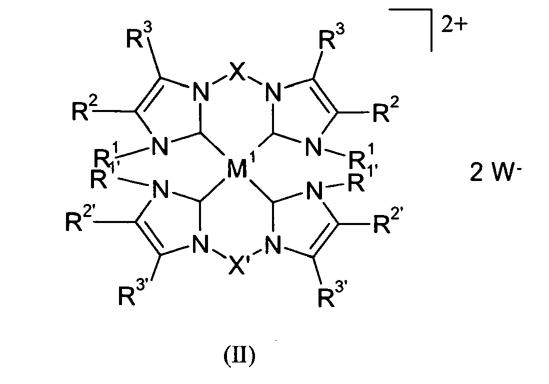 worin bedeuten:
- M¹: Pt(II), Pd(II);
- X, X': unabhängig voneinander Alkylen oder 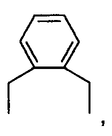 bevorzugt Alkylen, besonders bevorzugt (CR⁴₂)ₙ, wobei R⁴ H, Alkyl, bevorzugt H, Methyl oder Ethyl, besonders bevorzugt H und n 1 bis 3, bevorzugt 1 oder 2, besonders bevorzugt 1 bedeutet, ganz besonders bevorzugt CH₂;
- R¹, R^{1'}: unabhängig voneinander Wasserstoff, Alkyl, Cycloalkyl, Aryl, Aralkyl, bevorzugt Wasserstoff, C₁-C₄-Alkyl, Cyclohexyl, 2,4,6-Trimethylphenyl oder Benzyl, besonders bevorzugt Methyl, iso-Propyl, n-Butyl, Cyclohexyl, Benzyl, 2,4,6-Trimethylphenyl;
- R², R³, R^{2'}, R^{3'}: Wasserstoff oder Alkyl, bevorzugt Wasserstoff, oder R² und R³ oder R^{2'} und R^{3'} bilden jeweils gemeinsam eine Brücke aus 3, 4 oder 5, bevorzugt 4 Kohlenstoffatomen, die gesättigt oder ein oder zweifach ungesättigt sein kann und gegebenenfalls mit einem oder mehreren C₁- bis C₆-Alkylresten substituiert sein kann, bevorzugt eine unsubstituierte zweifach ungesättigte Brücke aus 4 Kohlenstoffatomen, die die folgende Struktur aufweist: 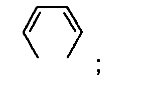
- W⁻: Halogenid, Pseudohalogenid oder OAc⁻, bevorzugt Cl⁻_{,} Br⁻, I⁻, CN⁻, OAc⁻, ganz besonders bevorzugt Br⁻ oder I⁻.

In den homoleptischen Tetracarbenkomplexen der Formel II haben die Symbole ganz besonders bevorzugt die folgenden Bedeutungen:
- M¹: Pt(II);
- X, X': jeweils CH₂;
- R¹, R^{1'}: jeweils CH₃, iso-Propyl, n-Butyl oder Cyclohexyl;
- R², R³, R^{2'}, R^{3'}: jeweils Wasserstoff, oder R² und R³ oder R^{2'} und R^{3'} bilden jeweils gemeinsam eine Brücke eine unsubstituierte zweifach ungesättigte Brücke aus 4 Kohlenstoffatomen, die die folgende Struktur aufweiset: 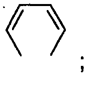
- W⁻: I⁻ oder Br⁻.

In den heteroleptischen Tetracarbenkomplexen der Formel II haben die Symbole und Reste ganz besonders bevorzugt die folgenden Bedeutungen:
- M¹: Pt(II);
- X, X^{'}: jeweils CH₂;
- R¹, R^{1'}: unabhängig voneinander CH₃, iso-Propyl, n-Butyl, Cyclohexyl, Benzyl oder 2,4,6-Trimethylphenyl, wobei R¹ und R^{1'} verschiedene Bedeutungen aufweisen;
- R², R³, R^{2'}, R^{3'}: jeweils Wasserstoff,
oder R² und R³ oder R^{2'} und R^{3'} bilden jeweils eine unsubstituierte zweifach ungesättigte Brücke aus 4 Kohlenstoffatomen, die die folgende Struktur aufweist: 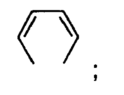
- W⁻: I⁻ oder Br⁻.

Die erfindungsgemäß verwendeten Übergangsmetallcarbenkomplexe der Formeln I und II können grundsätzlich gemäß dem Fachmann bekannten Verfahren bzw. analog zu dem Fachmann bekannten Verfahren hergestellt werden. Geeignete allgemeine Verfahren zur Herstellung von Carbenkomplexen sind z. B. in den Übersichtsartikeln W. A. Hermann et al., Advances in Organometallic Chemistry, 2001, Vol. 48, 1 bis 69, W. A. Hermann et al., Angew. Chem. 1997, 109, 2256 bis 2282 und G. Bertrand et al., Chem. Rev. 2000, 100, 39 bis 91 und der darin zitierten Literatur aufgeführt. Weitere Herstellungsverfahren sind z. B. in Ch.-M. Che et al., Organometallics 1998, 17, 1622 bis 1630, M. Albrecht et al., Inorganica Chimica Acta 359 (2006) 1929-1938 und W. J. Youngs et al., J. Organomet. Chem. 671 (2003) 183 bis 186, sowie in DE-A 10 2005 058 206 genannt.

Üblicherweise werden die Übergangsmetallcarbenkomplexe der Formeln I und II aus den Carbenliganden entsprechenden Vorläufern und geeigneten, das gewünschte Metall enthaltenden, Metallkomplexen hergestellt.

Geeignete Ligandvorläufer der Carbenliganden der erfindungsgemäß verwendeten Übergangsmetallcarbenkomplexe sind Bisimidazoliumsalze der allgemeinen Formel III 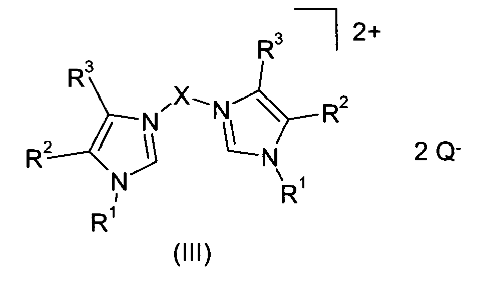 worin
- Q⁻: ein monoanionisches Gegenion, bevorzugt Halogenide, insbesondere Cl⁻, Br⁻, I⁻, Pseudohalogenide, insbesondere CN⁻, Alkoxy, OAc⁻, BF₄⁻, PF₆⁻, SbF₆⁻, AsF₆⁻, SCN⁻, OCN⁻ und ClO₄⁻, bevorzugte monoanionische Gegenionen sind Br⁻ und I⁻.

Die Bisimidazoliumsalze der Formel III können gemäß dem Fachmann bekannten Verfahren bzw. analog zu dem Fachmann bekannten Verfahren hergestellt werden. Geeignete Verfahren sind zum Beispiel in M. Albrecht et al., Organometallics 2002, 21, (17), 3596 bis 3604, G. Maletz et al., "Palladium or Platinum Carbene Complexes as Catalyst for Partial Oxidation of Alkanes", 2001 - 10151660, 10151660, 20011019., 2003 und M. Muehlhofer et al., Journal of Organometallic Chemistry 2002, 660, (2), 121 bis 126, sowie in DE-A 10 2005 058 206 genannt.

Beispielsweise sind die Bisimidazoliumsalze der Formel III durch Umsetzung der entsprechend substituierten Imidazole mit CH₂Z₂, wobei Z Cl, Br oder I bedeuten kann, erhältlich. Die entsprechend substituierten Imidazole können gemäß dem Fachmann bekannten Verfahren hergestellt werden bzw. sind kommerziell erhältlich.

Bei den geeigneten, das gewünschte Metall enthaltenden, Metallkomplexen handelt es sich im Allgemeinen um Pt(II)- oder Pd(II)-Metallkomplexe. Geeignete Metallkomplexe sind dem Fachmann bekannt. Beispiele für geeignete Metallkomplexe sind Pt(acac)₂, worin acac Acetylacetonat bedeutet, PtCl₂, Pt(OAc)₂, Pd(acac)₂, PdCl₂, Pd(OAc)₂, Pt(cod)Cl_{2,} worin cod Cyclooctadien bedeutet.

Die weitere Umsetzung der Bisimidazoliumsalze zu den gewünschten Übergangsmetallcarbenkomplexen der Formeln I und II ist von den gewünschten Übergangsmetallcarbenkomplexen abhängig.

In dem Fall, dass der gewünschte Übergangsmetallcarbenkomplex ein Biscarbenkomplex der allgemeinen Formel I ist, werden der eingesetzte Ligandvorläufer der Formel III und der entsprechende Metallkomplex in einem molaren Verhältnis von 0,75 : 1 bis 1 : 0,75, bevorzugt 0,9 : 1 bis 1 : 0,9, besonders bevorzugt 1 : 1 eingesetzt.

In dem Fall, dass es sich bei dem gewünschten Übergangsmetallcarbenkomplex um einen homoleptischen Übergangsmetallcarbenkomplex der Formel II handelt, ist es zum einen möglich, dass ein Ligandvorläufer der allgemeinen Formel III mit einem geeigneten Metallkomplex in einem molaren Verhältnis von im Allgemeinen 3 : 1 bis 2 : 1, bevorzugt 2,5 : 1 bis 2 : 1, besonders bevorzugt 2 : 1 umgesetzt wird, wobei der gewünschte homoleptische Tetracarbenkomplex der Formel II direkt erhalten wird. Zum anderen ist es möglich, zunächst einen Biscarbenkomplex durch Umsetzung eines Ligandvorläufers der Formel III mit einem entsprechenden Metallkomplex in den vorstehend genannten zur Herstellung von Biscarbenkomplexen geeigneten stöchiometrischen Verhältnissen herzustellen, und diesen erhaltenen Biscarbenkomplex, bevorzugt in situ, ohne weitere Aufarbeitung, mit weiterem Ligandvorläufer der Formel III umzusetzen, wobei das molare Verhältnis des bevorzugt in situ erhaltenen Biscarbenkomplexes zu dem weiteren Ligandvorläufer im Allgemeinen 0,75 : 1 bis 1 : 0,75, bevorzugt 0,9 : 1 bis 1 : 0,9, besonders bevorzugt 1 : 1 beträgt.

In dem Fall, dass es sich bei den gewünschten Übergangsmetallcarbenkomplexen um heteroleptische Tetracarbenkomplexe der allgemeinen Formel II handelt, erfolgt im Allgemeinen zunächst die Herstellung eines Biscarbenkomplexes, wobei der eingesetzte Ligandvorläufer der Formel III und der Metallkomplex in den vorstehend zur Herstellung von Biscarbenkomplexen genannten stöchiometrischen Verhältnissen eingesetzt werden. Der erhaltene Biscarbenkomplex wird anschließend, bevorzugt in situ, ohne weitere Aufarbeitung, mit einem zweiten Ligandvorläufer der Formel III (wobei R¹, R², R³ und X in dem zweiten Ligandvorläufer der Formel III durch R^{1'}, R^{2'}, R^{3'} und X' ersetzt sind), der sich von dem ersten Ligandvorläufer der Formel III unterscheidet, umgesetzt. Das molare Verhältnis zwischen dem Biscarbenkomplex und dem zweiten Ligandvorläufer der Formel III beträgt im Allgemeinen 0,75 : 1 bis 1 : 0,75, bevorzugt 0,9 : 1 bis 1 : 0,9, besonders bevorzugt 1 : 1.

Die weiteren Reaktionsbedingungen zur Herstellung der Übergangsmetallcarbenkomplexe der allgemeinen Formeln I und II aus den entsprechenden Bisimidazoliumsalzen (Ligandvorläufer der Formel III) entsprechen denen in dem Fachmann bekannten Verfahren oder analog zu dem Fachmann bekannten Verfahren bei dem Fachmann bekannten Reaktionsbedingungen bzw. analog zu dem Fachmann bekannten Reaktionsbedingungen.

Im Anschluss an die vorstehend erwähnte Umsetzung des Metallkomplexes mit einem oder mehreren Ligandvorläufern der Formel III wird der erhaltene Übergangsmetallcarbenkomplex der Formeln I oder II nach dem Fachmann bekannten Verfahren aufgearbeitet und gegebenenfalls gereinigt. Üblicherweise erfolgen Aufarbeitung und Reinigung durch Extraktion, Säulenchromatographie und/oder Umkristallisation gemäß dem Fachmann bekannten Verfahren.

Die Übergangsmetallcarbenkomplexe der Formeln I und II werden in organischen Leuchtdioden (OLEDs) verwendet. In einer bevorzugten Ausführungsform betrifft die vorliegende Anmeldung die Verwendungen von Übergangsmetallcarbenkomplexen der Formel II. Die Übergangsmetallcarbenkomplexe der Formeln I und II eignen sich als Emittersubstanzen, da sie eine Emission (Elektrolumineszenz) im sichtbaren Bereich des elektromagnetischen Spektrums aufweisen. Mithilfe der erfindungsgemäß eingesetzten Übergangsmetallcarbenkomplexe der Formeln I und II als Emittersubstanzen ist es möglich, Verbindungen bereitzustellen, die Elektrolumineszenz im gesamten Bereich des elektromagnetischen Spektrums mit guter Effizienz zeigen. Dabei ist die Quantenausbeute hoch und die Stabilität der erfindungsgemäß eingesetzten Übergangsmetallcarbenkomplexe der Formeln I und II im Device hoch.

Des Weiteren sind die erfindungsgemäß verwendeten Übergangsmetallcarbenkomplexe der Formeln I und II als Elektronen- , Exzitonen- oder Lochblocker oder Lochleiter, Elektronenleiter, Lochinjektionsschicht oder Matrixmaterial in OLEDs geeignet, in Abhängigkeit von den eingesetzten Liganden und dem eingesetzten Zentralmetall.

Organische Leuchtdioden (OLEDs) sind grundsätzlich aus mehreren Schichten aufgebaut:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die Übergangsmetallcarbenkomplexe der Formeln I und II können in verschiedenen Schichten eines OLEDs eingesetzt werden. Ein weiterer Gegenstand der vorliegenden Erfindung ist daher ein OLED enthaltend mindestens einen Übergangsmetallcarbenkomplex der Formeln I und/oder II. Bevorzugt liegt der mindestens eine Übergangsmetallcarbenkomplex der allgemeinen Formel I und/oder II in der Licht-emittierenden Schicht, einer Blockschicht für Elektronen, einer Blockschicht für Excitonen und/oder einer Blockschicht für Löcher vor. Die Übergangsmetallcarbenkomplexe der Formeln I und II werden bevorzugt in der Licht-emittierenden Schicht, besonders bevorzugt als Emittermoleküle, eingesetzt. Ein weiterer Gegenstand der vorliegenden Erfindung ist daher eine Licht-emittierende Schicht enthaltend mindestens einen Übergangsmetallcarbenkomplex der Formeln I und II, bevorzugt als Emittermolekül. Bevorzugte Übergangsmetallcarbenkomplexe der Formeln I und II sind vorstehend genannt.

Die erfindungsgemäß verwendeten Übergangsmetallcarbenkomplexe der Formeln I und II können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich und bevorzugt, dass neben den Übergangsmetallcarbenkomplexen der Formeln I und/oder II weitere Verbindungen in den Schichten, bevorzugt in der Licht-emittierenden Schicht, vorliegen. Beispielsweise kann in der Licht-emittierenden Schicht ein fluoreszierender Farbstoff anwesend sein, um die E-missionsfarbe des als Emittermoleküls eingesetzten Übergangsmetallcarbenkomplexes der Formel I oder II zu verändern. Des Weiteren kann - in einer bevorzugten Ausführungsform - ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß, bevorzugt als Emittersubstanzen, verwendeten Übergangsmetallcarbenkomplexe der Formeln I und II angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löchertransportierenden Schicht (2);
- eine Blockschicht für Elektronen und/oder Excitonen zwischen der Löchertransportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z.B. in WO2005/113704 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinander folgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen Übergangsmetallcarbenkomplex der Formeln I und/oder II ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (1) 500 bis 5000 Å, bevorzugt 1000 bis 2000 Å; Löcher-transportierende Schicht (2) 50 bis 1000 Å, bevorzugt 200 bis 800 Å, Licht-emittierende Schicht (3) 10 bis 1000 Å, bevorzugt 100 bis 800 Å, Elektronen transportierende Schicht (4) 50 bis 1000 Å, bevorzugt 200 bis 800 Å, Kathode (5) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der Übergangsmetallcarbenkomplexe der Formeln I und/oder II in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Kameras, insbesondere Digitalkameras, Fahrzeugen sowie Zielanzeigen an Bussen und Bahnen.

Weiterhin können die Übergangsmetallcarbenkomplexe der Formeln I und II in OLEDs mit inverser Struktur eingesetzt werden. Bevorzugt werden die erfindungsgemäß eingesetzten Übergangsmetallcarbenkomplexe der allgemeinen Formeln I und II in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die nachfolgenden Beispiele erläutern die Erfindung zusätzlich:

### Beispiele

### 1 Synthese von aliphatischen und aromatischen N-substituierten Imidazolen

### Arbeitsvorschriften:

Die hier vorgezeigten Imidazole wurden mittels den Synthesen in der genannten Literatur (Arduengo, A. J., et al., III Process for manufacture of imidazoles. 98-193700, 6177575, 19981117., 2001; Liu, J. et al., A modified procedure for the synthesis of 1-arylimidazoles. Synthesis 2003, (17), 2661-2666) dargestellt.

### A) 1-^{iso}Propylimidazol 1

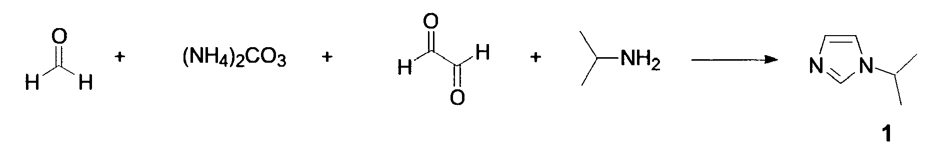

1,05 mol Paraformaldehyd (31,500 g) wird in 120 mL Methanol vorgelegt. Dazu tropft man vorsichtig 1 mol *^{iso}*Propylamin (59,110 g, 85,67 mL) in 120 mL Methanol unter Eiskühlung. Bei einer Temperatur von 0 °C sind 0,5 mol Ammoniumcarbonat (48,047 g) und 1 mol 40%ige Glyoxallösung (145,070 g, 114,7 mL) in 250 mL Methanol zuzugeben. Danach wird das Reaktionsgemisch auf Raumtemperatur erwärmt und über Nacht gerührt, damit das entstehende Kohlendioxid entweichen kann. Letztendlich ist das Lösungsmittel zu entfernen und das Produkt im Hochvakuum über eine Kolonne zu destillieren.

| | |
|---|---|
| **Summenformel:** C₆H₁₀N₂ | M = 110,16 g/mol |
| **Ausbeute:** 47,575 g (43,2 % d. Th.) | |

**¹H-NMR** (ppm, CDCl₃, 300,13 MHz):
δ = 7,47 (s, 1H, NCHN); 6,97 (s, 1H, NCHCHN); 6,89 (s, 1H, NCHCHN); 4,27 (sept, 1H, J = 6,7 Hz, ((CH₃)₂CHN); 1,40 (d, 6H, J = 6,7 Hz, CH₃-Gruppe)

### B) 1-^{tert}utylimidazol 2

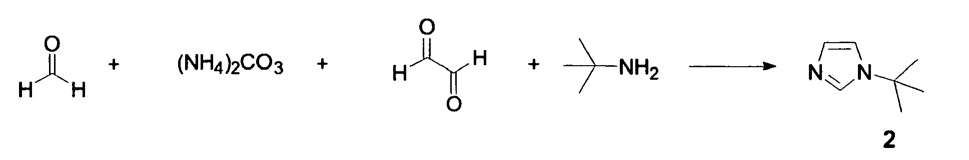

0,62 mol Paraformaldehyd (18,600 g) wird in 80 mL Methanol vorgelegt. Dazu tropft man vorsichtig 0,6 mol *^{tert}*Butylamin (43,884 g, 63,32 mL) in 80 mL Methanol unter Eiskühlung. Bei einer Temperatur von 0 °C sind 0,3 mol Ammoniumcarbonat (28,820 g) und 0,6 mol 40%ige Glyoxallösung (87,040 g, 68,8 mL) in 160 mL Methanol zuzugeben. Danach wird das Reaktionsgemisch auf Raumtemperatur erwärmt und über Nacht gerührt, damit das entstehende Kohlendioxid entweichen kann. Letztendlich ist das Lösungsmittel zu entfernen und das Produkt im Hochvakuum über eine Kolonne zu destillieren.

| | |
|---|---|
| **Summenformel:** C₇H₁₂N₂ | M = 124,186 g/mol |
| **Ausbeute:** 21,945 g (29,5 % d. Th.) | |

**¹H-NMR** (ppm, CDCl₃, 300,13 MHz):
δ = 7,61 (s, 1 H, NCHN); 7,04 (d, J = 1,8 Hz, 1 H, NCHCHN); 7,03 (d, J = 1,2 Hz, 1 H, NCHCHN); 1,55 (s, 9H, CH₃-Gruppe)

C) 1-(2,4,6-Trimethyl-phenyl)-imidazol **3** (Liu, J. et al., A modified procedure for the synthesis of 1-arylimidazoles. Synthesis 2003, (17), 2661-2666)

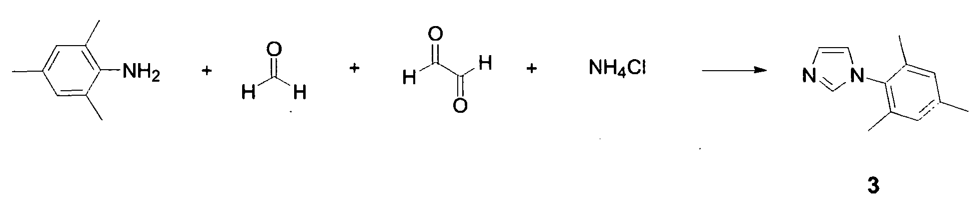

0,1 mol 1,3,5-Trimethylanilin (13,521 g; 14,08 mL) wird in 150 mL Methanol gelöst. Zu dieser Lösung gibt man unter Rühren 0,1 mol 40%ige Glyoxallösung (11,4 mL) und rührt bei Raumtemperatur bis ein Feststoff entsteht. Danach werden 0,2 mol festes Ammoniumchlorid (10,700 g), 0,6 mol 37%iger Formaldehyd (16 mL) und 400 mL Methanol zugegeben und eine Stunde unter Rückfluss gekocht. Nun sind 14 mL 85%ige Phosphorsäure über zehn Minuten zuzugeben und weitere vier bis acht Stunden unter Rückfluss zu rühren. Danach wird das Lösungsmittel entfernt, 300 g Eis zum Reaktionsgemisch gegeben, die Lösung mit 40%iger Kalilauge auf einen pH-Wert von 9 gebracht und mehrmals mit Diethylether extrahiert. Die Etherphase ist über Magnesiumsulfat zu trocknen und danach ist der Ether zu entfernen, wobei der braune Feststoff **3** entsteht. Anschließend wird eine Umkristallisation aus Essigester vorgenommen.

| | |
|---|---|
| Summenformel: **C₁₂H₁₄N₂** | **M = 186,252 g/mol** |
| Ausbeute: **11,746 g (63,0 % d. Th.)** | |
| Schmelzpunkt: **108,6 °C** | |

**¹H-NMR** (ppm, CDCl₃, 300,13MHz):
δ = 7,48 (s, 1H, NCHN); 7,24 (s, 1H, NCHCHN); 6,96 (s, 2H, CH von C₆H₂); 6,88 (s, 1H, NCHCHN); 2,32 (s, 3H, 4-CH₃ von C₆H₂); 1,97 (s, 6H, 2,6-CH₃ von C₆H₂)

### 2 Verbrückte Imidazole

**2.1 Synthese von 1,1'-Methylendiimidazol 4** (Diez-Barra, E. et al., Phase transfer catalysis without solvent. Synthesis of bisazolylalkanes. Heterocycles 1992, 34, (7), 1365-1373)

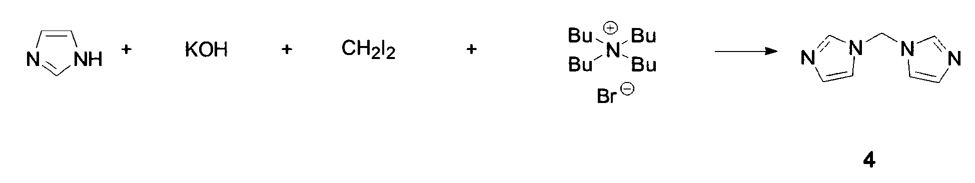

Ein Gemisch aus 30 mmol Imidazol (2,040 g), 60 mmol feingepulvertes Kaliumhydroxid (3,360 g) und einer Spatelspitze Tertbutylammoniumbromid wird solange vorsichtig erhitzt und gut gerührt bis es flüssig wird. Nach dem Abkühlen sind 15 mmol Diiodmethan (4,000 g; 1,21 mL) zuzugeben. Anschließend wird für 90 Minuten auf 50 °C erhitzt und für weitere 90 Minuten auf 70 °C. Die entstandene Masse ist zweimal mit 10 mL Ethanol zu extrahieren, das Lösungsmittel zu entfernen und der Rückstand zu sublimieren.

| | |
|---|---|
| **Summenformel**: C₇H₈N₄ | M = 148,174 g/mol |
| **Ausbeute:** 1,053 g (47,3 % d. Th.) | |
| **Schmelzpunkt:** 154,8 °C | |

**¹H-NMR** (ppm, CDCl₃, 300,13 MHz):
7,93 (s, 2H, NCHN); 7,39 (s, 2H, NCHCHN); 6,90 (s, 2H, NCHCHN); 6,21 (s, 2H, NCH₂N)

### 3 Bisimidazoliumsalze

### Arbeitsvorschrift:

Die verschiedenen Bisimidazoliumsalze wurden nach leicht modifizierten Synthesen der genannten Literatur (Albrecht, M. et al.; Chelated Iridium(III) Bis-carbene Complexes as Air-Stable Catalysts for Transfer Hydrogenation. Organometallics 2002, 21, (17), 3596-3604; Maletz, G. et al.; Palladium or platinum carbene complexes as catalyst for partial oxidation of alkanes. 2001-10151660, 10151660, 20011019., 2003; Muehlhofer, M. et al.; Synthesis and structural characterization of novel bridged platinum(II) biscarbene complexes. Journal of Organometallic Chemistry 2002, 660, (2), 121-126) hergestellt.

### 3.1 1,1'-Dimethyl-3,3'-methylen-diimidazoliumsalze

### A) Synthese von 1,1'-Dimethyl-3,3'-methylendümidazoliumdichlorid 5

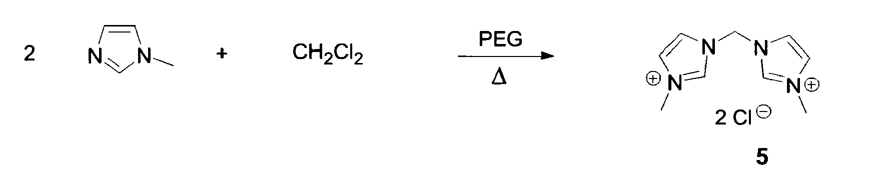

0,073 mol Methylimidazol (6,000 g; 5,83 mL), 0,073 mol Dichlormethan (6,200 g; 4,70 mL) und 10 mL Polyethylenglykol 400 (PEG 400) werden unter Rückfluss für 12 Stunden auf 140 °C erhitzt. Nach dem Abkühlen wird der entstandene Feststoff abfiltriert und mehrmals mit wenig Tetrahydrofuran gewaschen. Es wird ein weißer Feststoff **5** erhalten.

| | |
|---|---|
| **Summenformel:** C₉H₁₄N₄Cl₂ | M = 249,142 g/mol |
| **Ausbeute:** 2,641 g (29,0 % d. Th.) | |
| **Schmelzpunkt:** Zersetzung bei > 276 °C | |

**¹H** (ppm, d₆-DMSO, 300,13 MHz):
9,88 (s, 2H, NCHN); 8,28 (s, 2H, NCHCHN); 7,82 (s, 2H, NCHCHN); 6,91 (s, 2H, NCH₂N); 3,90 (s, 6H, CH₃)

### B) 1,1'-Dimethyl-3,3'-methylen-dümidazoliumdibromid 6

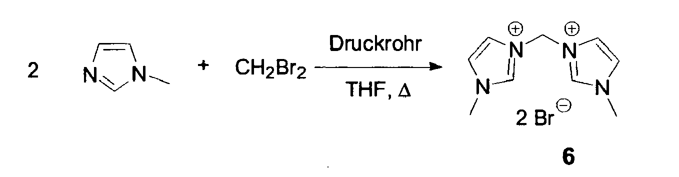

0,024 mol Methylimidazol (2,000 g; 1,94 mL) werden in einem ACE-Druckrohr mit 0,012 mol Dibrommethan (2,086 g; 0,84 mL) und 5 mL Tetrahydrofuran versetzt. Das Gemisch wird 24 Stunden bei 130 °C gerührt, der ausfallende Feststoff wird abfiltriert und mehrmals mit wenig Tetrahydrofuran gewaschen. Es wird der weiße Feststoff **6** erhalten.

| | |
|---|---|
| **Summenformel:** C₉H₁₄N₄Br₂ | M = 338,042 g/mol |
| **Ausbeute:** 4,051 g (99,0 % d. Th.) | |
| **Schmelzpunkt:** Zersetzung bei > 278 °C | |

**¹H** (ppm, d₆-DMSO, 300,13 MHz):
3,90 (s, 6H, CH₃); 6,71 (s, 2H, NCH₂N); 7,81 (s, 2H, NCHCHN); 8,03 (s, 2H, NCHCHN); 9,49 (s, 2H, NCHN)

### C) 1,1'-Dimethyl-3,3'-methylen-diimidazoliumdiiodid 7

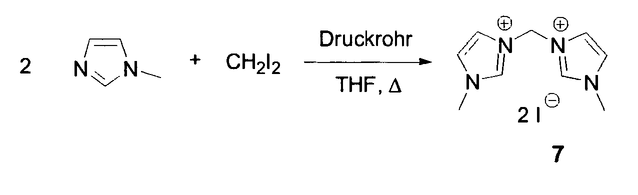

0,024 mol Methylimidazol (2,000 g; 1,94 mL) werden in einem ACE-Druckrohr mit 0,012 mol Diiodmethan (3,214 g; 0,97 mL) und 5 mL Tetrahydrofuran versetzt. Das Gemisch wird 20 Stunden bei 110 °C gerührt, der ausfallende Feststoff wird abfiltriert und mehrmals mit wenig Tetrahydrofuran gewaschen. Es wird der weiße Feststoff **7** erhalten.

| | |
|---|---|
| **Summenformel:** C₉H₁₄N₄I₂ | M = 432,042 g/mol |
| **Ausbeute:** 5,198 g (99,9 % d. Th.) | |
| **Schmelzpunkt:** Zersetzung bei > 277 °C | |

**¹H** (ppm, d₆-DMSO, 300,13 MHz):
δ = 9,35 (s, 2H, NCHN); 7,96 (t, 2H, J = 1,7 Hz, NCHCHN); 7,80 (t, 2H, J = 1,7 Hz, NCHCHN); 6,64 (s, 2H, NCH₂N); 3,90 (s, 6H, CH₃-Gruppe)

### 3.2 Darstellung weiterer aliphatischer Bisimidazoliumsalze

### A) 1,1'-Diisopropyl-3,3'-methylen-diimidazoliumdibromid 8

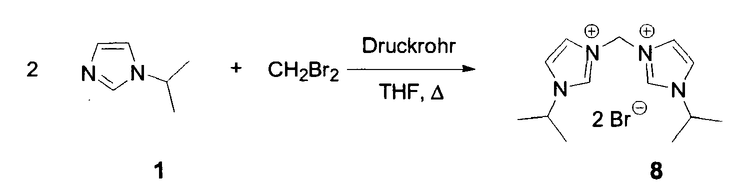

Zu 0,018 mol *^{iso}*Propylimidazol 1 (2,000 g) werden in einem ACE-Druckrohr 0,009 mol Dibrommethan (1,564 g; 0,63 mL) und 5 mL Tetrahydrofuran gegeben. Das Reaktionsgemisch wird 20 Stunden bei 80 °C gerührt. Der ausfallende Feststoff ist mehrmals mit wenig Tetrahydrofuran zu waschen. Es wird ein weißer Feststoff **8** erhalten.

| | |
|---|---|
| **Summenformel:** C₁₃H₂₂N₄Br₂ | M = 394,154 g/mol |
| **Ausbeute:** 1,302 g (36,7 % d. Th.) | |
| **Schmelzpunkt:** Zersetzung bei > 172 °C | |

**¹H** (ppm, d₆-DMSO, 300,13 MHz):
δ = 9,68 (s, 2H, NCHN); 8,11 (t, 2H, J = 1,75 Hz, NCHCHN); 8,04 (t, 2H, J = 1,75 Hz, NCHCHN); 6,66 (s, 2H, NCH₂N); 4,70 (sept, 2H, J = 6,6 Hz, (CH₃)₂CHN); 1,50 (d, 12H, J = 6,6 Hz, CH₃-Gruppe)

### B) 1,1'-Diisopropyl-3,3'-methylen-diimidazoliumdiiodid 9

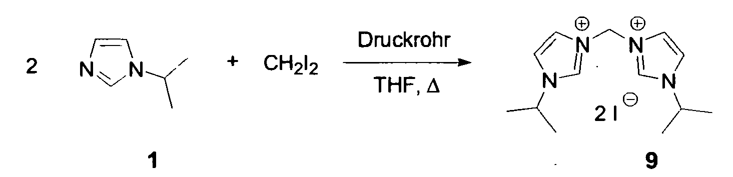

Zu 0,027 mol *^{iso}*Propyiimidazoi **1** (3,000 g) werden in einem ACE-Druckrohr 0,0135 mol Diiodmethan (3,616 g; 1,09 mL) in 7 mL Tetrahydrofuran gegeben. Das Gemisch wird

17 Stunden bei 80 °C gerührt, der entstandene Feststoff wird abfiltriert und mehrmals mit wenig Tetrahydrofuran gewaschen. Es entsteht ein weißer Feststoff **9**.

| | |
|---|---|
| **Summenformel:** C₁₃H₂₂N₄I₂ | M = 488,146 g/mol |
| **Ausbeute:** 4,832 g (73,3 % d. Th.) | |
| **Schmelzpunkt:** Zersetzung bei > 247 °C | |

**¹H** (ppm, d₆-DMSO, 300,13 MHz):
δ = 9,50 (s, 2H, NCHN); 8,04 (s, 4H, NCHCHN); 6,59 (s, 2H, NCH₂N); 4,72 (sept, 2H, J = 6,6 Hz, (CH₃)₂CHN); 1,50 (d, 12H, J = 6,6 Hz, CH₃-Gruppe)

### C) 1,1'-Dicyclohexyl-3,3'-methylen-diimidazoliumdibromid 10

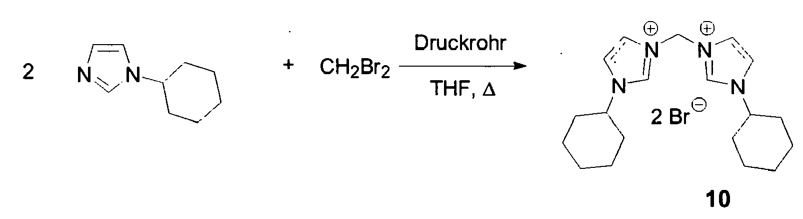

Zu 0,013 mol Cyclohexylimidazol (2,000 g) werden in einem ACE-Druckrohr 0,0065 mol Dibrommethan (1,130 g; 0,46 mL) und 5 mL Tetrahydrofuran gegeben. Das Reaktionsgemisch wird 20 Stunden bei 80 °C gerührt. Der ausfallende Feststoff ist mehrmals mit wenig Tetrahydrofuran zu waschen. Es wird ein weißer Feststoff **10** erhalten.

| | |
|---|---|
| **Summenformel:** C₁₉H₃₀N₄Br₂ | M = 474,278 g/mol |
| **Ausbeute:** 1,003 g (32,5 % d. Th.) | |
| **Schmelzpunkt:** Zersetzung bei > 288 °C | |

**¹H** (ppm, d₆-DMSO, 300,13 MHz):
δ = 9,65 (s, 2H, NCHN); 8,09 (s, 2H, NCHCHN); 8,02 (s, 2H, NCHCHN); 6,67 (s, 2H, NCH₂N); 4,35 (t, 2H, J = 11,6 Hz, CH von Cyclohexyl-Ring); 2,09 (d, 4H, J = 10,5 Hz, CH₂ von Cyclohexyl-Ring); 1,84 (d, 4H, J = 13,3 Hz, CH₂ von Cyclohexyl-Ring); 1,69 (d, 4H, J = 12,0 Hz, CH₂ von Cyclohexyl-Ring); 1,38 (quart, 4H, J = 12,7 Hz, CH₂ von Cyclohexyl-Ring); 1,22 (t, 4H, J = 12,5 Hz, CH₂ von Cyclohexyl-Ring)

### D) 1,1'-Dicyclohexyl-3,3'-methylen-diimidazoliumdiiodid 11

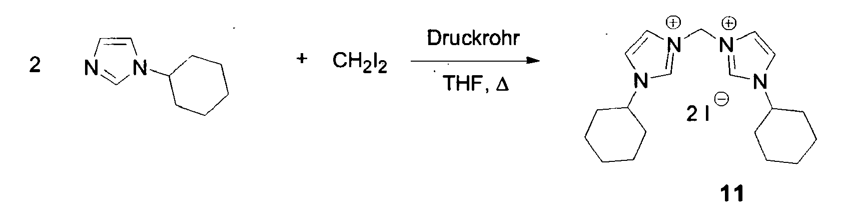

Zu 0,013 mol Cyclohexylimidazol (2,000 g) werden in einem ACE-Druckrohr 0,0065 mol Diiodmethan (1,741 g; 0,52 mL) und 5 mL Tetrahydrofuran gegeben. Das Reaktionsgemisch wird 3 Stunden bei 80 °C gerührt. Der ausfallende Feststoff ist mehrmals mit wenig Tetrahydrofuran zu waschen. Es wird der weiße Feststoff **11** erhalten.

| | |
|---|---|
| **Summenformel:** C₁₉H₃₀N₄I₂ | M = 568,270 g/mol |
| **Ausbeute:** 0,891 g (24,1 % d. Th.) | |
| **Schmelzpunkt:** Zersetzung bei > 286 °C | |

**¹H** (ppm, d₆-DMSO, 300,13 MHz):
δ = 9,45 (s, 2H, NCHN); 8,01 (dd, 4H, J = 1,6 Hz, NCHCHN); 6,58 (s, 2H, NCH₂N); 4,36 (t, 2H, J = 11,7 Hz, CH von Cyclohexyl-Ring); 2,09 (d, 4H, J = 9,7 Hz, CH₂ von Cyclohexyl-Ring); 1,85 (d, 4H, J = 13,3 Hz, CH₂ von Cyclohexyl-Ring); 1,68 (d, 4H, J = 12,3 Hz, CH₂ von Cyclohexyl-Ring); 1,40 (quart, 4H, J = 12,7 Hz, CH₂ von Cyclohexyl-Ring); 1,23 (t, 4H, J = 12,5 Hz, CH₂ von Cyclohexyl-Ring)

### E) 1,1'-Ditertbutyl-3,3'-methylen-dümidazoliumdibromid 12

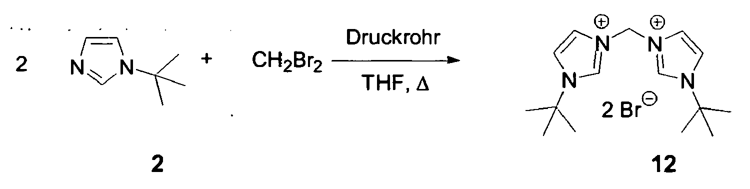

Zu 0,016 mol *^{tert}*Butylimidazol **2** (2,000 g) werden in einem ACE-Druckrohr 0,008 mol Dibrommethan (1,391 g; 0,56 mL) und 5 mL Tetrahydrofuran gegeben. Das Reaktionsgemisch wird 20 Stunden bei 80 °C gerührt. Der ausfallende Feststoff ist mehrmals mit wenig Tetrahydrofuran zu waschen. Es wird ein weißer Feststoff **12** erhalten.

| | |
|---|---|
| **Summenformel:** C₁₅H₂₆N₄Br₂ | M = 422,206 g/mol |
| **Ausbeute:** 1,449 g (42,9 % d. Th.) | |
| **Schmelzpunkt:** Zersetzung bei > 230 °C | |

**¹H** (ppm, d₆-DMSO, 300,13 MHz):
δ = 9,85 (s, 2H, NCHN); 8,21 (s, 2H, NCHCHN); 8,17 (s, 2H, NCHCHN); 6,67 (s, 2H, NCH₂N); 1,62 (s, 18H, CH₃-Gruppe)

### F) 1,1'-Ditertbutyl-3,3'-methylen-diimidazoliumdiiodid 13

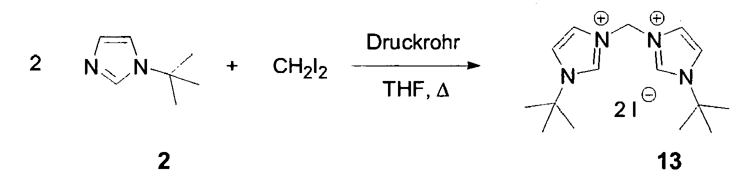

Zu 0,016 mol *^{tert}*Butylimidazol **2** (2,000 g) werden in einem ACE-Druckrohr 0,008 mol Diiodmethan (2,143 g; 0,64 mL) und 5 mL Tetrahydrofuran gegeben. Das Reaktionsgemisch wird 3 Stunden bei 80 °C gerührt. Der ausfallende Feststoff ist mehrmals mit wenig Tetrahydrofuran zu waschen. Es wird der weiße Feststoff **13** erhalten.

| | |
|---|---|
| **Summenformel:** C₁₅H₂₆N₄I₂ | M = 516,198 g/mol |
| **Ausbeute:** 1,444 g (35,0 % d. Th.) | |
| **Schmelzpunkt:** Zersetzung bei > 249 °C | |

**¹H** (ppm, d₆-DMSO, 300,13 MHz):
δ = 9,55 (s, 2H, NCHN); 8,17 (s, 2H, NCHCHN); 8,06 (s, 2H, NCHCHN); 6,54 (s, 2H, NCH₂N); 1,61 (s, 18H, CH₃-Gruppe)

### G) 1,1'-Di-n-butyl-3,3'-methylen-diimidazoliumdibromid 14

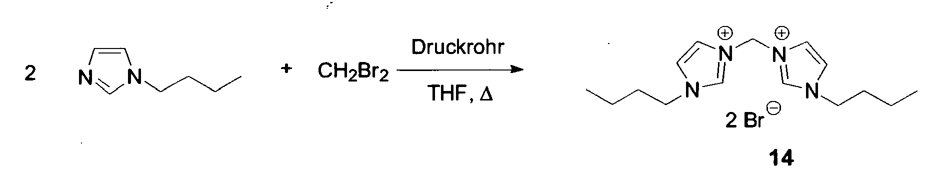

Zu 0,024 mol n-Butylimidazol (3,000 g; 3,17 mL) werden im ACE-Druckrohr 0,012 mol Dibrommethan (2,086 g; 0,84 mL) und 7 mL Tetrahydrofuran zugegeben. Das Reaktionsgemisch wird 5 Tage bei Raumtemperatur und 72 Stunden bei 80 °C gerührt. Der ausfallende Feststoff ist mehrmals mit wenig Tetrahydrofuran zu waschen. Es wird der weiße Feststoff **14** erhalten.

| | |
|---|---|
| Summenformel: **C₁₅H₂₆N₄Br₂** | **M = 422,206 g/mol** |
| Ausbeute: **4,437 g (87,6 % d. Th.)** | |
| Schmelzpunkt: **178,6 °C** | |

**¹H** (ppm, d₆-DMSO, 300,13 MHz):
δ = 9,68 (s, 2H, NCHN); 8,12 (t, 2H, J = 1,7 Hz, NCHCHN); 7,93 (t, 2H, J = 1,7 Hz, NCHCHN); 6,74 (s, 2H, NCH₂N); 4,24 (t, 4H, J = 7,2 Hz, N-CH₂-CH₂-CH₂-CH₃); 1,80 (quint, 4H, J = 7,3 Hz, N-CH2-CH₂-CH₂-CH₃); 1,30 (sext, 4H, J = 7,4 Hz, N-CH₂-CH₂-CH₂-CH₃); 0,91 (t, 6H, J = 7,3 Hz, N-CH₂-CH₂-CH₂-CH₃)

### H) 1,1'-Di-n-butyl-3,3'-methylen-diimidazoliumdiiodid 15

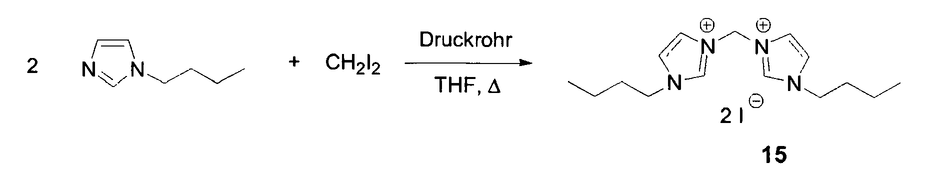

Zu 0,024 mol n-Butylimidazol (3,000 g; 3,17 mL) werden im ACE-Druckrohr 0,012 mol Diiodmethan (3,214 g; 0,97 mL) und 7 mL Tetrahydrofuran zugegeben. Das Reaktionsgemisch wird 5 Tage bei Raumtemperatur und 72 Stunden bei 80 °C gerührt. Der ausfallende Feststoff ist mehrmals mit wenig Tetrahydrofuran zu waschen. Es wird der hellrote Feststoff 15 erhalten.

| | |
|---|---|
| Summenformel: **C₁₅H₂₆N₄I₂** | **M = 516,198 g/mol** |
| Ausbeute: **5,929 g (95,7 % d. Th.)** | |
| Schmelzpunkt: **151,4 °C** | |

**¹H** (ppm, d₆-DMSO, 300,13 MHz):
δ = 9,44 (s, 2H, NCHN); 8,00 (s, 2H, NCHCHN); 7,92 (s, 2H, NCHCHN); 6,63 (s, 2H, NCH₂N); 4,23 (t, 4H, J = 7,2 Hz, N-CH₂-CH2-CH2-CH3); 1,79 (quint, 4H, J = 7,3 Hz, N-CH2-CH₂-CH₂-CH₃); 1,31 (sext, 4H, J = 7,4 Hz, N-CH₂-CH₂-CH₂-CH3); 0,91 (t, 6H, J = 7,3 Hz, N-CH₂-CH₂-CH₂-CH₃)

### 3.3 Darstellung aromatischer Bisimidazoliumsalze

### A) 1,1'-Di-(2,4,6-trimethylphenyl)-3,3'-methylendiimidazoliumdibromid 16

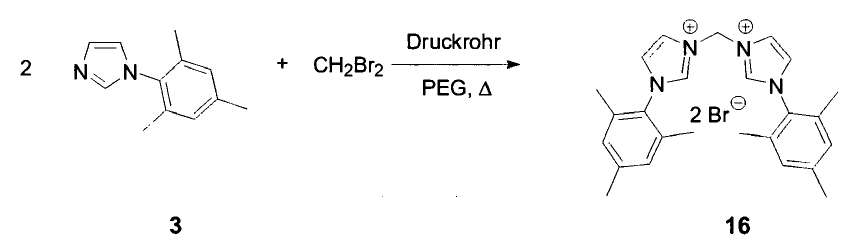

0,011 mol 1-(2,4,6-Trimethylphenyl)-imidazol **3** (2,000 g), 0,0054 mol Dibrommethan (0,939 g; 0,38 mL) und 5 mL PEG 400 werden über Nacht bei 120 °C im Druckrohr gerührt. Der ausgefallene Feststoff ist abzufiltern und mit wenig Tetrahydrofuran mehrmals zu waschen.

| | |
|---|---|
| Summenformel: **C₂₅H₃₀N₄Br₂** | **M = 546,33 g/mol** |
| Ausbeute: **1,581 g (53,6 % d. Th.)** | |
| Schmelzpunkt: **Zersetzung bei > 285 °C** | |

**¹H** (ppm, d₆-DMSO, 300,13 MHz):
δ = 9,95 (s, 2H, NCHN); 8,43 (s, 2H, NCHCHN); 8,10 (s, 2H, NCHCHN); 7,18 (s, 4H, CH von C₆H₂); 6,91 (s, 2H, NCH₂N); 2,34 (s, 6H, p-CH₃ von C₆H₂); 2,05 (s, 12H, o-CH₃ von C₆H₂)

### B) 1,1'-Di-(2,4,6-trimethylphenyl)-3,3'-methylendümidazoliumdiiodid 17

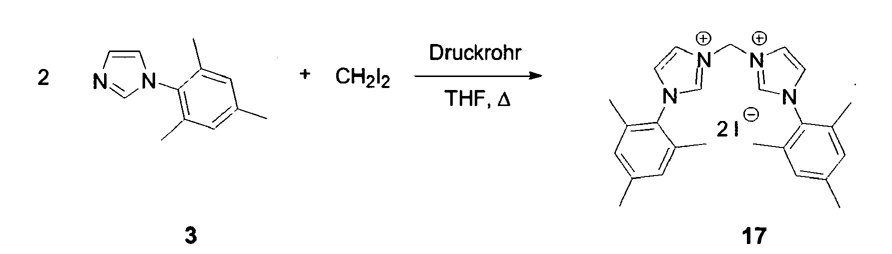

0,011 mol 1-(2,4,6-Trimethylphenyl)-imidazol **3** (2,000 g), 0,0054 mol Diiodmethan (1,438 g; 0,43 mL) und 5 mL THF werden über Nacht bei Raumtemperatur und danach 9 Stunden bei 120 °C im Druckrohr gerührt. Der ausgefallene Feststoff ist abzufiltern und mit wenig Tetrahydrofuran mehrmals zu waschen.

| | |
|---|---|
| Summenformel: **C₂₅H₃₀N₄I₂** | **M = 640,33 g/mol** |
| Ausbeute: **1,053 g (30,5 % d. Th.)** | |
| Schmelzpunkt: **Zersetzung bei > 310 °C** | |

**¹H** (ppm, d₆-DMSO, 300,13 MHz):
δ = 9,79 (s, 2H, NCHN); 8,35 (t, 2H, J = 1,7 Hz, NCHCHN); 8,11 (t, 2H, J = 1,6 Hz, NCHCHN); 7,18 (s, 4H, CH von C₆H₂); 6,86 (s, 2H, NCH₂N); 2,34 (s, 6H, p-CH₃ von C₆H₂); 2,05 (s, 12H, o-CH₃ von C₆H₂)

### C) 1,1'-Di-(4-methylphenyl)-3,3'-methylendiimidazoliumdibromid 18

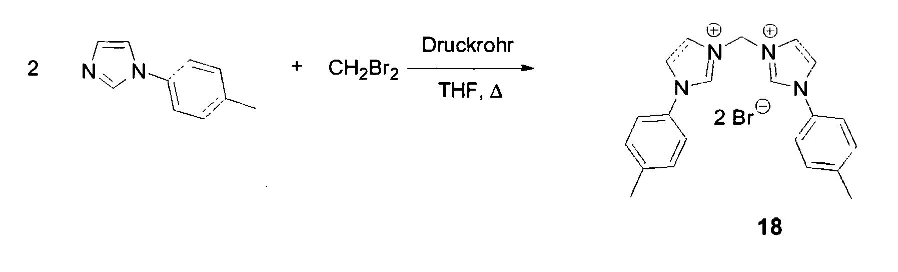

0,013 mol 1-(4-Methylphenyl)-imidazol (2,000 g), 0,0063 mol Dibrommethan (1,099 g; 0,45 mL) und 5 mL THF werden über Nacht bei Raumtemperatur und danach 9 Stunden bei 120 °C im Druckrohr gerührt. Der ausgefallene Feststoff ist abzufiltern und mit wenig Tetrahydrofuran mehrmals zu waschen.

| | |
|---|---|
| Summenformel: **C₂₁H₂₂N₄Br₂** | **M = 490,234 g/mol** |
| Ausbeute: 0,779 g (25,2 % d. Th.) | |
| Schmelzpunkt: Zersetzung bei > 300 **°C** | |

**¹H** (ppm, d₆-DMSO, 300,13 MHz):
δ = 10,30 (s, 2H, NCHN); 8,42 (s, 2H, NCHCHN); 8,38 (s, 2H, NCHCHN); 7,71 (d, 4H, J = 8,4 Hz, arom. CH); 7,51 (d, 4H, J = 8,4 Hz, arom. CH); 6,89 (s, 2H, NCH₂N); 2,41 (s, 6H, p-CH₃ von C₆H₂)

### 3.4 Darstellung von 1,1'-Dibenzyl-3,3'-methylen-diimidazoliumdibromid 19

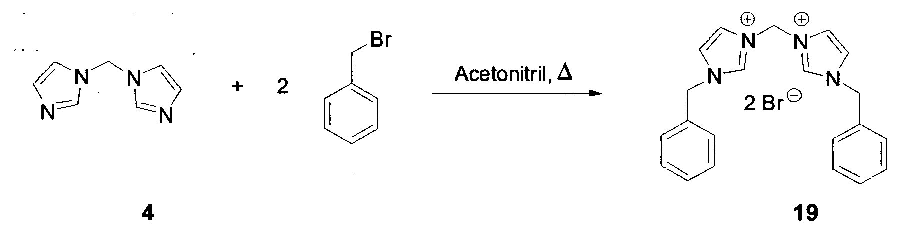

Zu 0,0034 mol 1,1'-Methylendiimidazol **4** werden in einem ACE-Druckrohr 2 mL Benzylbromid in 8 mL Tetrahydrofuran gegeben und 4 Tage bei Raumtemperatur gerührt. Der ausgefallene Feststoff wird mit Tetrahydrofuran gewaschen und danach in Acetonitril aufgenommen, nochmals mit 1 mL Benzylbromid versetzt und 24 Stunden bei 60 °C, 3 Tage bei Raumtemperatur und weitere 30 Stunden bei 80 °C gerührt. Der erhaltene Feststoff wird abfiltriert, erneut mit Tetrahydrofuran gewaschen und getrocknet. Es entsteht ein weißer Feststoff **19**.

| | |
|---|---|
| Summenformel: C₂₁H₂₂N₄Br₂ | M = 490,234 g/mol |
| Ausbeute: 0,771 g (46,3 % d. Th.) | |
| Schmelzpunkt: Zersetzung bei > 248 °C | |

**¹H** (ppm, d₆-DMSO, 300,13 MHz):
δ = 9,68 (s, 2H, NCHN); 8,11 (s, 2H, NCHCHN); 7,93 (s, 2H, NCHCHN); 7,44 (m, 10H, J = 5,0 Hz, arom. CH); 6,71 (s, 2H, NCH₂N); 5,52 (s, 4H, N-CH₂-C₆H₅)

### 4 Carbenkomplexe

### 4.1 Biscarbenkomplexe

### A) (1,1'-Dimethyl-3,3'-methylendiimidazolin-2,2'-diyliden)platin(II)dibromid 20

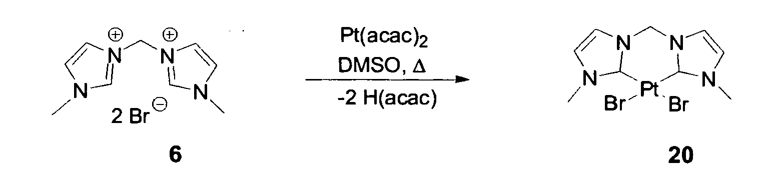

0,5 mmol Platin(II)acetylacetonat (0,197 g) werden in 3 mL Dimethylsulfoxid vorgelegt und auf 100 °C erwärmt. Dazu wird mit Hilfe einer Spritzenpumpe über 13 Stunden eine Lösung von 0,5 mmol 1,1'-Dimethyl-3,3'-methylen-diimidazoliumdibromid **6** (0,169 g) in 20 mL Dimethylsulfoxid zugegeben. Das gesamte Reaktionsgemisch wird weitere 2 Stunden bei 100 °C gerührt. Danach wird das Lösungsmittel bei 70 °C im Vakuum entfernt und der entstehende Feststoff zweimal mit wenig Wasser und zweimal mit wenig Tetrahydrofuran gewaschen. Der weiße Feststoff **20** ist noch zu trocknen.

| | |
|---|---|
| **Summenformel:** C₉H₁₂N₄PtBr₂ | M = 531,112 g/mol |
| **Ausbeute:** 0,179 g (67,4 % d. Th.) | |
| **Schmelzpunkt:** Zersetzung bei > 380 °C | |

**¹H** (ppm, d₆-DMSO, 300,13 MHz):
δ = 7,53 (d, 2H, J = 2,0 Hz, NCHCHN); 7,31 (d, 2H, J = 2,0 Hz, NCHCHN); 6,10 (AB, 1H, J = 13,1 Hz, NCH₂N); 5,96 (AB, 1H, J = 13,1 Hz, NCH₂N); 3,84 (s, 6H, CH₃-Gruppe)

### B) (1,1'-Dimethyl-3,3'-methylendiimidazolin-2,2'-diyliden)platin(II)diacetat 21

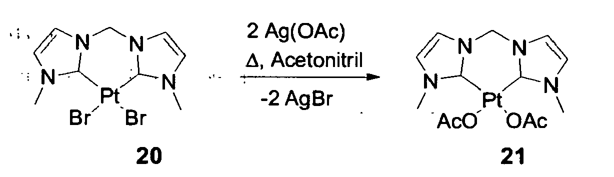

Zu 0,19 mmol (1,1'-Dimethyl-3,3'-methylendiimidazolin-2,2'-diyliden)platin(II)dibromid **20** (0,100 g) werden 0,38 mmol Silberacetat (0,063 g) in 5 mL Acetonitril gegeben. Das Gemisch wird unter Lichtausschluss 8 Stunden bei 60 °C gerührt. Das ausfallende Silberbromid sowie das nicht umgesetzte Edukt werden abfiltriert und das Lösungsmittel wird im Vakuum entfernt. Es entsteht ein weißer Feststoff **21.**

| | |
|---|---|
| **Summenformel:** C₁₃H₁₈N₄O₄Pt | M = 489,392 g/mol |
| **Ausbeute:** 0,057 g (61,3 % d. Th.) | |
| **Schmelzpunkt:** Zersetzung bei > 310 °C | |

**¹H** (ppm, d₆-DMSO, 300,13 MHz):
δ = 7,60 (d, 2H, J = 1,9 Hz, NCHCHN); 7,37 (d, 2H, J = 1,9 Hz, NCHCHN); 6,12 (s, 2H, NCH₂N); 3,78 (s, 6H, CH₃-Gruppe); 1,89 (s, 6H, CH₃COO)

### C) (1,1'-Diisopropyl-3,3'-methylendiimidazolin-2,2'-diyliden)platin(II)dibromid 22

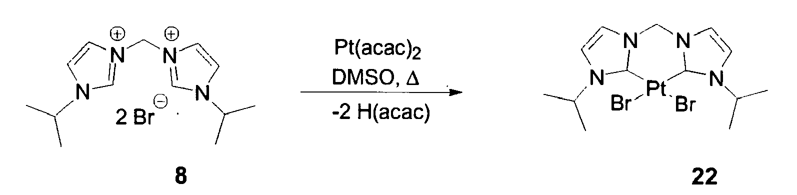

0,75 mmol Platin(II)acetylacetonat (0,295 g) werden mit 0,75 mmol 1,1'-Diisopropyl-3,3'-methylen-diimidazoliumdibromid **8** (0,296 g) in einem Schlenkrohr vereinigt. Es werden 6 mL Dimethylsulfoxid zugesetzt und das Reaktionsgemisch ist für 2 Stunden bei 60 °C zu rühren, danach 2 Stunden bei 80 °C und weitere 5 Stunden bei 110 °C. Das Lösungsmittel wird bei 70 °C im Vakuum entfernt, der ausfallende Feststoff wird mit wenig Methanol und Tetrahydrofuran gewaschen und danach getrocknet. Es entsteht ein weißer Feststoff **22.**

| | |
|---|---|
| **Summenformel:** C₁₃H₂₀N₄PtBr₂ | M = 587,216 g/mol |
| **Ausbeute:** 0,368 g (83,6 % d. Th.) | |
| **Schmelzpunkt:** Zersetzung bei > 270 °C | |

**¹H** (ppm, d₆-DMSO, 300,13 MHz):
δ = 7,55 (d, 2H, J = 2,1 Hz, NCHCHN); 7,51 (d, 2H, J = 2,1 Hz, NCHCHN); 6,05 (AB, 1H, J = 13,1 Hz, NCH₂N); 5,96 (AB, 1H, J = 13,1 Hz, NCH₂N); 5,53 (sept, 2H, J = 6,7 Hz, (CH₃)₂CHN); 1,44 (d, 6H, J = 6,7 Hz, CH₃-Gruppe); 1,19 (d, 6H, J = 6,7 Hz, CH₃-Gruppe)

### D) (1,1'-Diisopropyl-3,3'-methylendiimidazolin-2,2'-diyliden)platin(II)diiodid 23

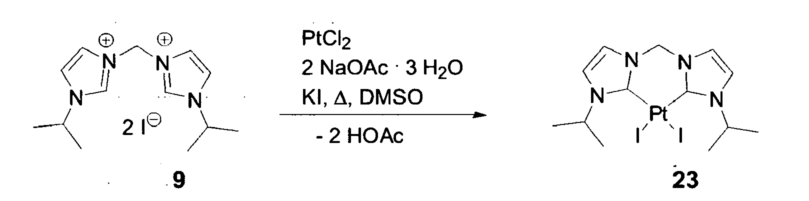

0,25 mmol Platin(II)chlorid (0,066 g) und 0,25 mmol 1,1'-Diisopropyl-3,3'-methylendiimidazoliumdiiodid **9** (0,122 g), sowie 0,5 mmol Natriumacetat-Trihydrat (0,068 g) und 0,5 mmol Kaliumiodid (0,083 g) werden mit 5 mL Dimethylsulfoxid in einem Schlenkrohr 3 Stunden bei 60 °C, 3 Stunden bei 80 °C und weitere 3 Stunden bei 110 °C gerührt. Dann wird das Lösungsmittel bei 70 °C im Vakuum entfernt und der entstandene Feststoff wird mit Methanol und Tetrahydrofuran gewaschen und getrocknet. Es entsteht ein weißer Feststoff **23.**

| | |
|---|---|
| **Summenformel:** C₁₃H₂₀N₄PtI₂ | M = 681,207 g/mol |
| **Ausbeute:** 0,116 g (68,1 % d. Th.) | |
| **Schmelzpunkt:** Zersetzung bei > 340 °C | |

**¹H** (ppm, d₆-DMSO, 300,13 MHz):
δ = 7,56 (d, 2H, J = 2,1 Hz, NCHCHN); 7,51 (d, 2H, J = 2,2 Hz, NCHCHN); 6,07 (AB, 1H, J = 13,1 Hz, NCH₂N); 5,98 (AB, 1H, J = 13,1 Hz, NCH₂N); 5,47 (sept, 2H, J = 6,8 Hz, (CH₃)₂CHN); 1,46 (d, 6H, J = 6,7 Hz, CH₃-Gruppe); 1,17 (d, 6H, J = 6,8 Hz, CH₃-Gruppe)

### E) (1,1'-Diisopropyl-3,3'-methylendiimidazolin-2,2'-diyliden)platin(II)diacetat 24

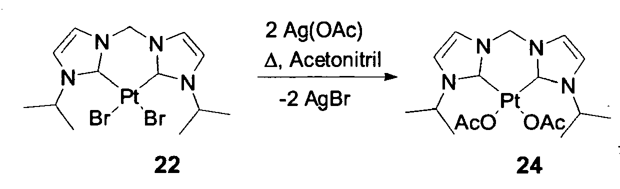

Zu 0,43 mmol (1,1'-Diisopropyl-3,3'-methylendiimidazolin-2,2'-diyliden)platin(II)dibromid **22** (0,250 g) werden 0,86 mmol Silberacetat (0,143 g) in 6 mL Acetonitril gegeben. Das Gemisch wird unter Lichtausschluss 8 Stunden bei 60 °C gerührt. Das ausfallende Silberbromid wird abfiltriert und das Lösungsmittel wird im Vakuum entfernt. Es entsteht ein weißer Feststoff **24.**

| | |
|---|---|
| **Summenformel:** C₁₇H₂₆N₄O₄Pt | M = 545,496 g/mol |
| **Ausbeute:** 0,225 g (95,9 % d. Th.) | |
| **Schmelzpunkt:** Zersetzung bei > 130 °C | |

**¹H** (ppm, d₆-DMSO, 300, 13 MHz):
δ = 7,52 (d, 2H, J = 1,8 Hz, NCHCHN); 7,47 (d, 2H, J = 2,0 Hz, NCHCHN); 6,08 (AB, 1 H, J = 12,8 Hz, NCH₂N); 5,90 (AB, 1 H, J = 12,8 Hz, NCH₂N); 5,10 (sept, 2H, J = 6,6 Hz, (CH₃)₂CHN); 1,75 (s, 6H, CH₃COO); 1,34 (d, 6H, J = 6,5 Hz, CH₃-Gruppe); 1,25 (d, 6H, J = 6,6 Hz, CH₃-Gruppe)

### F) (1,1'-Dicyclohexyl-3,3'-methylendiimidazolin-2,2'-diyliden)platin(II)dibromid 25

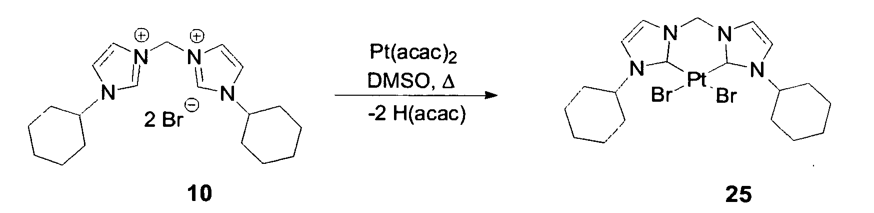

0,75 mmol Platin(II)acetylacetonat (0,295 g) werden mit 0,75 mmol 1,1'-Dicyclohexyl-3,3'-methylen-diimidazoliumdibromid **10** (0,356 g) in einem Schlenkrohr vereinigt. Es werden 6 mL Dimethylsulfoxid zugesetzt und das Reaktionsgemisch ist für 2 Stunden bei 60 °C zu rühren, danach 2 Stunden bei 80 °C und weitere 5 Stunden bei 110 °C. Das Lösungsmittel wird bei 70 °C im Vakuum entfernt, der ausfallende Feststoff wird mit wenig Methanol und Tetrahydrofuran gewaschen und danach getrocknet. Es entsteht ein weißer Feststoff **25.**

| | |
|---|---|
| **Summenformel:** C₁₉H₂₈N₄PtBr₂ | M = 667,34 g/mol |
| **Ausbeute:** 0,294 g (58,7 % d. Th.) | |
| **Schmelzpunkt:** Zersetzung bei > 340 °C | |

**¹H** (ppm, d₆-DMSO, 300,13 MHz):
δ = 7,53 (s, 2H, NCHCHN); 7,51 (s, 2H, NCHCHN); 6,05 (AB, 1 H, J = 13,1 Hz, NCH₂N); 5,96 (AB, 1H, J = 13,0 Hz, NCH₂N); 5,13 (t, 2H, J = 11,6 Hz, CH von Cyclohexyl-Ring); 2,12 (d, 4H, J = 10,5 Hz, CH₂ von Cyclohexyl-Ring); 1,80 (d, 4H, J = 13,1 Hz, CH₂ von Cyclohexyl-Ring); 1,50 (d, 4H, J = 11,9 Hz, CH₂ von Cyclohexyl-Ring); 1,34 (t, 4H, J = 12,2 Hz, CH₂ von Cyclohexyl-Ring); 1,21 (t, 4H, J = 13,1 Hz, CH₂ von Cyclohexyl-Ring)

### G) (1,1'-Dicyclohexyl-3,3'-methylendiimidazolin-2,2'-diyliden)platin(II)diiodid 26

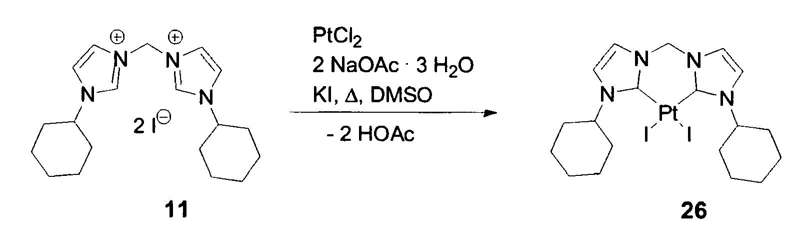

0,4 mmol Platin(II)chlorid (0,106 g) und 0,4 mmol 1,1'-Dicyclohexyl-3,3'-methylen-diimidazoliumdiiodid **11** (0,227 g), sowie 0,8 mmol Natriumacetat-Trihydrat (0,109 g) und 0,8 mmol Kaliumiodid (0,133 g) werden mit 5 mL Dimethylsulfoxid in einem Schlenkrohr 2 Stunden bei 60 °C, 2 Stunden bei 80 °C und weitere 5 Stunden bei 110 °C gerührt. Dann wird das Lösungsmittel bei 70 °C im Vakuum entfernt und der entstandene Feststoff wird mit Methanol und Tetrahydrofuran gewaschen und getrocknet. Es entsteht ein weißer Feststoff **26.**

| | |
|---|---|
| **Summenformel:** C₁₉H₂₈N₄PtI₂ | M = 761,332 g/mol |
| **Ausbeute:** 0,221 g (72,6 % d. Th.) | |
| **Schmelzpunkt:** Zersetzung bei > 382 °C | |

**¹H** (ppm, d₆-DMSO, 300,13 MHz):
δ = 7,59 (s, 2H, NCHCHN); 7,57 (s, 2H, NCHCHN); 6,11 (AB, 1H, J = 13,2 Hz, NCH₂N); 5,99 (AB, 1H, J = 13,2 Hz, NCH₂N); 5,21 (t, 2H, J = 11,6 Hz, CH von Cyclohexyl-Ring); 2,13 (d, 4H, J = 10,9 Hz, CH₂ von Cyclohexyl-Ring); 1,84 (d, 4H, J = 13,0 Hz, CH₂ von Cyclohexyl-Ring); 1,59 (d, 4H, J = 11,9 Hz, CH₂ von Cyclohexyl-Ring); 1,39 (t, 4H, J = 11,8 Hz, CH₂ von Cyclohexyl-Ring); 1,28 (t, 4H, J = 12,6 Hz, CH₂ von Cyclohexyl-Ring)

### H) (1,1'-Dicyclohexyl-3,3'-methylendümidazolin-2,2'-diyliden)platin(II)diacetat 27

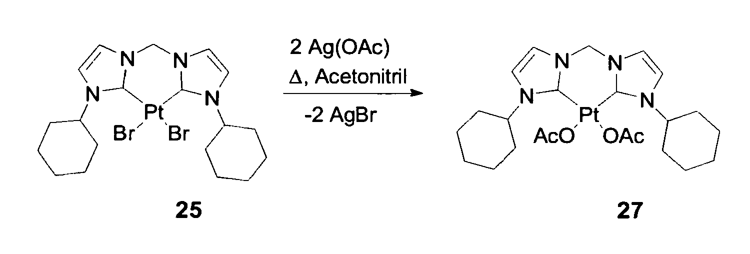

Zu 0,30 mmol (1,1'-Dicyclohexyl-3,3'-methylendiimidazolin-2,2'-diyliden)platin(II)-dibromid **25** (0,200 g) werden 0,60 mmol Silberacetat (0,100 g) in 7 mL Acetonitril gegeben. Das Gemisch wird unter Lichtausschluss 8 Stunden bei 60 °C gerührt. Das ausfallende Silberbromid wird abfiltriert und das Lösungsmittel wird im Vakuum entfernt. Es entsteht ein weißer Feststoff **27.**

| | |
|---|---|
| **Summenformel:** C₂₃H₃₄N₄O₄Pt | M = 625,62 g/mol |
| **Ausbeute:** 0,186 g (99,1 % d. Th.) | |
| **Schmelzpunkt:** Zersetzung bei > 320 °C | |

**¹H** (ppm, d₆-DMSO, 300,13 MHz):
δ = 7,51 (s, 2H, NCHCHN); 7,48 (s, 2H, NCHCHN); 6,07 (AB, 1H, J = 12,9 Hz, NCH₂N); 5,91 (AB, 1H, J = 12,8 Hz, NCH₂N); 4,73 (t, 2H, J = 11,7 Hz, CH von Cyclohexyl-Ring); 1,75 (s, 6H, CH₃COO); 1,67 (d, 4H, J = 11,8 Hz, CH₂ von Cyclohexyl-Ring); 1,62 (d, 4H, J = 11,2 Hz, CH₂ von Cyclohexyl-Ring); 1,56 (d, 4H, J = 11,0 Hz, CH₂ von Cyclohexyl-Ring); 1,38 (t, 4H, J = 12,3 Hz, CH₂ von Cyclohexyl-Ring); 1,20 (t, 4H, J = 11,9 Hz, CH₂ von Cyclohexyl-Ring)

### I) (1,1'-Di-n-butyl-3,3'-methylendiimidazolin-2,2'-diyliden)platin(II)dibromid 28

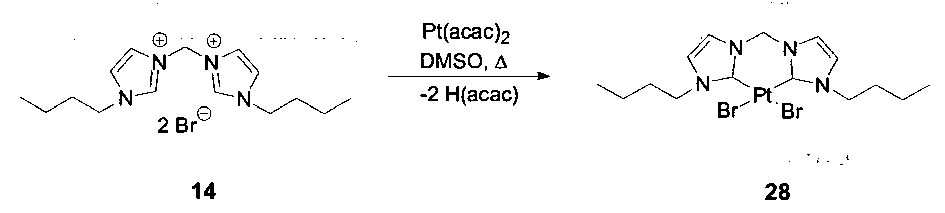

0,75 mmol Platin(II)acetylacetonat (0,295 g) werden mit 0,75 mmol 1,1'-Di-n-butyl-3,3'-methylen-diimidazoliumdibromid **14** (0,317 g) in einem Schlenkrohr vereinigt. Es werden 6 mL Dimethylsulfoxid zugesetzt und das Reaktionsgemisch ist für 2 Stunden bei 60 °C zu rühren, danach 2 Stunden bei 80 °C und weitere 5 Stunden bei 110 °C. Das Lösungsmittel wird bei 70 °C im Vakuum entfernt, der ausfallende Feststoff wird mit wenig Methanol und Tetrahydrofuran gewaschen und danach getrocknet. Es entsteht ein weißer Feststoff **28.**

| | |
|---|---|
| **Summenformel:** C₁₅H₂₄N₄PtBr₂ | M = 615,268 g/mol |
| **Ausbeute:** 0,316 g (68,5 % d. Th.) | |
| **Schmelzpunkt:** 221,0 °C | |

**¹H** (ppm, d₆-DMSO, 300,13 MHz):
δ = 7,52 (d, 2H, J = 1,9 Hz, NCHCHN); 7,38 (d, 2H, J = 1,9 Hz, NCHCHN); 6,08 (AB, 1 H, J = 13,1 Hz, NCH₂N); 5,97 (AB, 1 H, J = 13,1 Hz, NCH₂N); 4,80 (m, 2H, J = 7,3 Hz, N-CH₂-CH₂-CH₂-CH₃); 3,97 (m, 2H, J = 7,1 Hz, N-CH₂-CH₂-CH₂-CH₃); 1,73 (quint, 4H, J = 7,1 Hz, N-CH₂-CH₂-CH₂-CH₃); 1,17 (sext, 4H, J = 7,2 Hz, N-CH₂-CH₂-CH₂-CH₃); 0,86 (t, 6H, J = 7,3 Hz, N-CH₂-CH₂-CH₂-CH₃)

### J) (1,1'-Di-n-butyl-3,3'-methylendiimidazolin-2,2'-diyliden)platin(II)diiodid 29

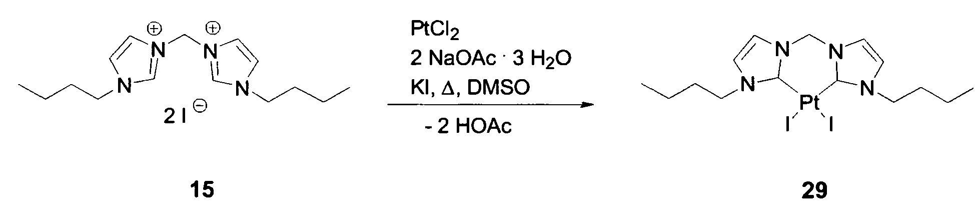

0,5 mmol Platin(II)chlorid (0,133 g) und 0,5 mmol 1,1'-Di-n-butyl-3,3'-methylen-diimidazoliumdiiodid **15** (0,258 g), sowie 1 mmol Natriumacetat-Trihydrat (0,136 g) und 1 mmol Kaliumiodid (0,166 g) werden mit 5 mL Dimethylsulfoxid in einem Schlenkrohr 2 Stunden bei 60 °C, 2 Stunden bei 80 °C und weitere 5 Stunden bei 110 °C gerührt. Dann wird das Lösungsmittel bei 70 °C im Vakuum entfernt und der entstandene Feststoff wird mit Methanol und Tetrahydrofuran gewaschen und getrocknet. Es entsteht ein weißer Feststoff **29.**

| | |
|---|---|
| **Summenformel:** C₁₅H₂₄N₄PtI₂ | M = 709,260 g/mol |
| **Ausbeute:** 0,232 g (65,4 % d. Th.) | |
| **Schmelzpunkt:** 249,8 °C | |

**¹H** (ppm, d₆-DMSO, 300,13 MHz):
δ = 7,51 (d, 2H, J = 1,8 Hz, NCHCHN); 7,37 (d, 2H, J = 1,9 Hz, NCHCHN); 6,10 (AB, 1 H, J = 13,0 Hz, NCH₂N); 5,94 (AB, 1 H, J = 13,0 Hz, NCH₂N); 4,83 (m, 2H, J = 7,5 Hz, N-CH₂-CH₂-CH₂-CH₃); 3,96 (m, 2H, J = 6,6 Hz, N-CH₂-CH₂-CH₂-CH₃); 1,74 (quint, 4H, J = 7,2 Hz, N-CH₂-CH₂-CH₂-CH₃); 1,18 (sext, 4H, J = 7,2 Hz, N-CH₂-CH₂-CH₂-CH₃); 0,86 (t, 6H, J = 7,4 Hz, N-CH₂-CH₂-CH₂-CH₃)

### K) (1,1'-Di-n-butyl-3,3'-methylendiimidazolin-2,2'-diyliden)platin(II)diacetat 30

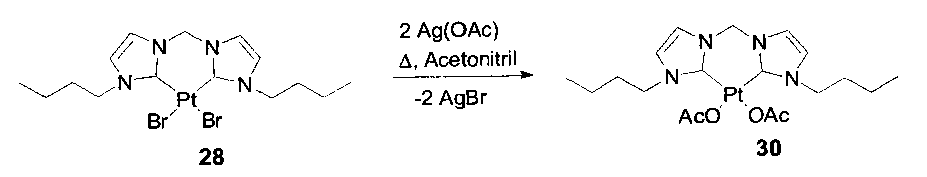

Zu 0,16 mmol (1,1'-Di-n-butyl-3,3'-methylendiimidazolin-2,2'-diyliden)platin(II)dibromid **28** (0,100 g) werden 0,32 mmol Silberacetat (0,054 g) in 5 mL Acetonitril gegeben. Das Gemisch wird unter Lichtausschluss 8 Stunden bei 60 °C gerührt. Das ausfallende Silberbromid wird abfiltriert und das Lösungsmittel wird im Vakuum entfernt. Es entsteht ein weißer Feststoff **30.**

| | |
|---|---|
| **Summenformel:** C₁₉H₃₀N₄O₄Pt | M = 573,548 g/mol |
| **Ausbeute:** 0,093 g (99,9 % d. Th.) | |

**¹H** (ppm, d₆-DMSO, 300,13 MHz):
δ = 7,32 (s, 2H, NCHCHN); 7,14 (s, 2H, NCHCHN); 5,92 (AB, 1H, J = 13,2 Hz, NCH₂N); 5,67 (AB, 1 H, J = 13,2 Hz, NCH₂N); 4,07 (m, 2H, J = 7,1 Hz, N-CH₂-CH₂-CH₂-CH₃); 3,77 (m, 2H, J = 7,0 Hz, N-CH₂-CH₂-CH₂-CH₃); 1,58 (s, 6H, CH₃COO); 1,52 (quint, 4H, J = 5,6 Hz, N-CH₂-CH₂-CH₂-CH₃); 1,03 (sext, 4H, J = 6,8 Hz, N-CH₂-CH₂-CH₂-CH3); 0,68 (t, 6H, J = 7,3 Hz, N-CH₂-CH₂-CH₂-CH₃)

### L) (1,1'-Dibenzyl-3,3'-methylendiimidazolin-2,2'-diyliden)platin(II)dibromid 31

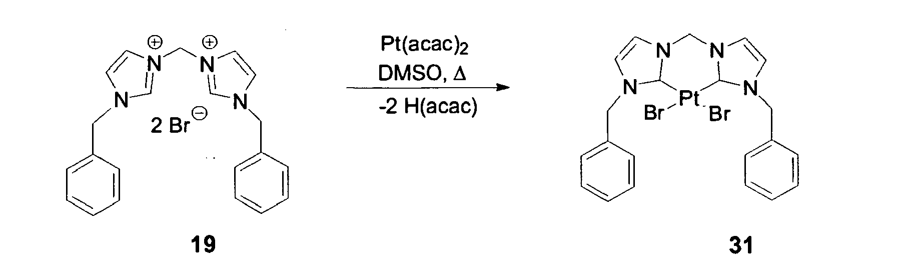

0,408 mmol Platin(II)acetylacetonat (0,160 g) werden mit 0,408 mmol 1,1'-Dibenzyl-3,3'-methylen-diimidazoliumdibromid **19** (0,200 g) in einem Schlenkrohr vereinigt. Es werden 5 mL Dimethylsulfoxid zugesetzt und das Reaktionsgemisch ist für 2 Stunden bei 60 °C zu rühren, danach 2 Stunden bei 80 °C und weitere 5 Stunden bei 110 °C. Das Lösungsmittel wird bei 70 °C im Vakuum entfernt, der ausfallende Feststoff wird mit wenig Methanol und Tetrahydrofuran gewaschen und danach getrocknet. Es entsteht ein weißer Feststoff **31.**

| | |
|---|---|
| **Summenformel:** C₂₁H₂₀N₄PtBr₂ | M = 683,296 g/mol |
| **Ausbeute:** 0,205 g (73,5 % d. Th.) | |
| **Schmelzpunkt:** Zersetzung bei > 260 °C | |

**¹H** (ppm, d₆-DMSO, 300,13 MHz):
δ = 7,54 (d, 2H, J = 2,0 Hz, NCHCHN); 7,30 (s, 10H, arom. CH); 7,23 (d, 2H, J = 1,9 Hz, NCHCHN); 6,15 (AB, 1 H, J = 13,1 Hz, NCH₂N); 6,06 (AB, 1H, J = 13,0 Hz, NCH₂N); 6,08 (AB, 2H, J = 14,7 Hz, NCH₂Ph); 5,28 (AB, 2H, J = 14,7 Hz, NCH₂Ph)

### M) (1,1'-Di-(2,4,6-trimethylphenyl)-3,3'-methylendiimidazolin-2,2'-diyliden)platin(II)dibromid 32

Literaturstelle: Strassner, Th. et al.; Synthesis, Structure and Stability of New PtII-Bis(N-Heterocyclic Carbene) Complexes. Eur. J. Inorg. Chem. 2006, 1268-1274

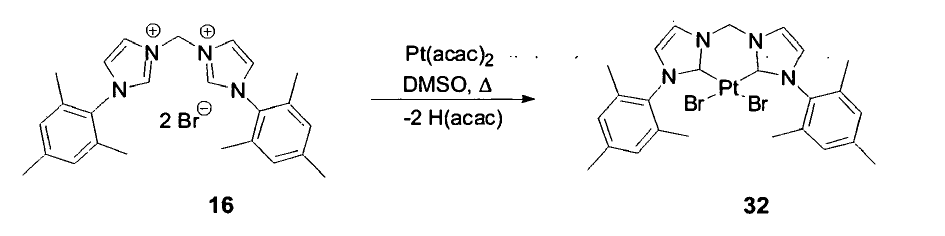

0,5 mmol Platin(II)acetylacetonat (0,197 g) werden mit 0,5 mmol 1,1'-Di-(2,4,6-trimethylphenyl)-3,3'-methylendiimidazoliumdibromid **16** (0,273 g) in einem Schlenkrohr vereinigt. Es werden 5 mL Dimethylsulfoxid zugesetzt und das Reaktionsgemisch ist für 2 Stunden bei 80 °C zu rühren, danach 2 Stunden bei 100 °C und weitere 2 Stunden bei 130 °C. Das Lösungsmittel wird bei 70 °C im Vakuum entfernt, der ausfallende Feststoff wird mit wenig Methanol und Tetrahydrofuran gewaschen und danach getrocknet. Es entsteht ein weißer Feststoff **32.**

| | |
|---|---|
| **Summenformel:** C₂₅H₂₈N₄PtBr₂ | M = 739,400 g/mol |
| **Ausbeute:** 0,158 g (42,7 % d. Th.) | |
| **Schmelzpunkt:** Zersetzung bei > 400 °C | |

**¹H** (ppm, d₆-DMSO, 300,13 MHz):
δ = 7,78 (s, 2H, NCHCHN); 7,29 (s, 2H, NCHCHN); 6,89 (d, 4H, J = 12,6 Hz, arom. CH); 6,32 (AB, 1H, J = 13,1 Hz, NCH₂N); 6,15 (AB, 1H, J = 13,1 Hz, NCH₂N); 2,26 (s, 6H, para-CH₃); 2,08 (s, 6H, ortho-CH₃); 2,00 (s, 6H, ortho-CH₃)

### N) (1, 1'-Di-(2,4,6-trimethylphenyl)-3,3'-methylendiimidazolin-2,2'-diyliden)platin(II)diiodid 33

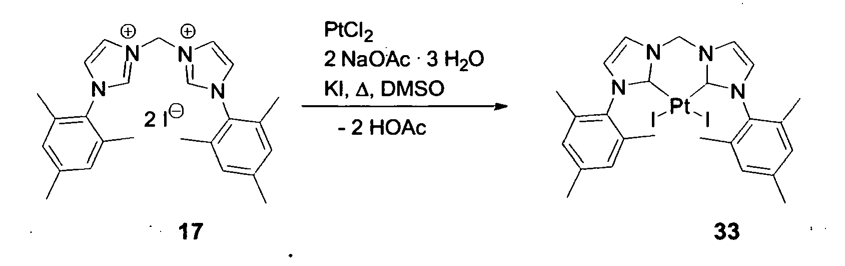

0,31 mmol Platin(II)chlorid (0,083 g) und 0,31 mmol 1,1'-Di-(2,4,6-trimethylphenyl)-3,3'-methylendiimidazoliumdiiodid **17** (0,200 g), sowie 0,62 mmol Natriumacetat-Trihydrat (0,084 g) und 0,62 mmol Kaliumiodid (0,103 g) werden mit 4 mL Dimethylsulfoxid in einem Schlenkrohr 2 Stunden bei 80 °C, 2 Stunden bei 100 °C und weitere 2 Stunden bei 130 °C gerührt. Dann wird das Lösungsmittel bei 70 °C im Vakuum entfernt und der entstandene Feststoff wird mit Methanol und Tetrahydrofuran gewaschen und getrocknet. Es entsteht ein weißer Feststoff **33.**

| | |
|---|---|
| **Summenformel:** C₂₅H₂₈N₄PtI₂ | M = 833,392 g/mol |
| **Ausbeute:** 0,215 g (83,2 % d. Th.) | |
| **Schmelzpunkt:** Zersetzung bei > 370 °C | |

**¹H** (ppm, d₆-DMSO, 300,13 MHz):
δ = 7,80 (d, 2H, J = 1,9 Hz, NCHCHN); 7,32 (d, 2H, J = 1,9 Hz, NCHCHN); 6,94 (s, 4H, arom. CH); 6,33 (AB, 1 H, J = 13,1 Hz, NCH₂N); 6,15 (AB, 1H, J = 13,0 Hz, NCH₂N); 2,27 (s, 6H, para-CH₃); 2,08 (s, 6H, ortho-CH₃); 2,04 (s, 6H, ortho-CH₃)

### O) (1,1'-Di-(2,4,6-trimethylphenyl)-3,3'-methylendiimidazolin-2,2'-diyliden)platin(II)diacetat 34

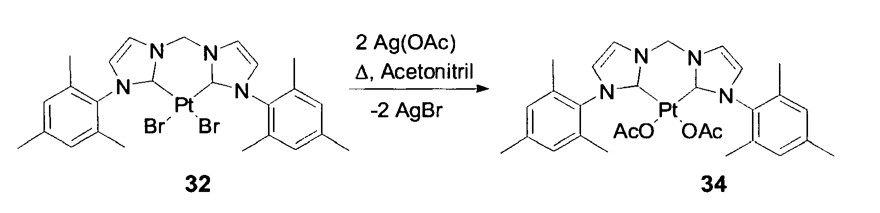

Zu 0,135 mmol (1,1'-Di-(2,4,6-trimethylphenyl)-3,3'-methylendiimidazolin-2,2'-diyliden)platin(II)dibromid **32** (0,100 g) werden 0,27 mmol Silberacetat (0,045 g) in 5 mL Acetonitril gegeben. Das Gemisch wird unter Lichtausschluss 8 Stunden bei 60 °C gerührt. Das ausfallende Silberbromid und nicht umgesetzte Edukte werden abfiltriert, und das Lösungsmittel wird im Vakuum entfernt. Es entsteht ein weißer Feststoff **34.**

| | |
|---|---|
| **Summenformel:** C₂₉H₃₄N₄O₄Pt | M = 697,680 g/mol |
| **Ausbeute:** 0,027 g (28,7 % d. Th.) | |

**¹H** (ppm, d₆-DMSO, 300,13 MHz):
δ = 7,81 (s, 2H, NCHCHN); 7,34 (s, 2H, NCHCHN); 6,96 (s, 4H, arom. CH); 6,37 (AB, 2H, J = 13,1 Hz, NCH₂N); 2,27 (s, 6H, para-CH₃); 2,02 (s, 12H, ortho-CH₃); 1,20 (s, 6H, CH₃COO)

### P) (1,1'-Dimethyl-3,3'-o-phenylendimethylen-diimidazolin-2,2'-diyliden)platin(II)-dichlorid 35

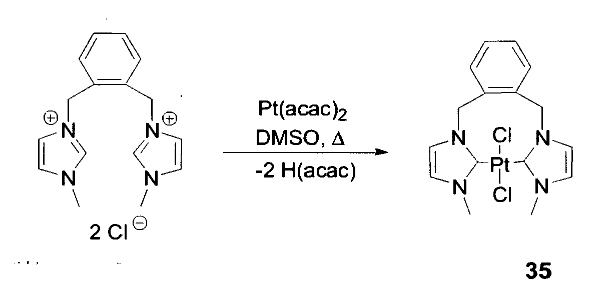

0,737 mmol 1,1'-Dimethyl-3,3'-o-phenylendimethylen-diimidazoliumdichlorid (0,250 g) werden mit 0,737 mmol Platin(II)acetylacetonat (0,290 g) und 7 mL Dimethylsulfoxid vereinigt. Das Reaktionsgemisch wird 3 Stunden bei 80 °C, 3 Stunden bei 100 °C und weitere 4 Stunden bei 120 °C gerührt. Das Dimethylsulfoxid wird im Vakuum bei 70 °C entfernt und der zurückgebliebene Feststoff wird zweimal mit jeweils 3 mL Methanol gewaschen. Es wird ein weißer Feststoff 35 erhalten.

| | |
|---|---|
| Summenformel:**C₁₆H₁₈N₄PtCl₂** | **M = 532,322 g/mol** |
| Ausbeute: **0,272 g (69,3 % d. Th.)** | |
| Schmelzpunkt: **Zersetzung bei > 390 °C** | |

**¹H** (ppm, d₆-DMSO, 300,13 MHz):
δ = 7,85 (m, 2H, J = 3,5 Hz, arom. CH-Gruppen); 7,59 (d, 2H, J = 2,0 Hz, NCHCHN); 7,42 (m, 2H, J = 3,5 Hz, arom. CH-Gruppen); 7,24 (d, 2H, J = 2,0 Hz, NCHCHN); 6,60 (AB, 2H, J = 14,2 Hz, NCH₂-C₆H₄-CH₂N); 5,00 (AB, 2H, J = 14,2 Hz, NCH₂-C₆H₄-CH₂N); 3,88 (s, 6H, CH₃-Gruppe)

### 4.2 Homoleptische Tetracarbenkomplexe

### A) Bis-(1,1'-dimethyl-3,3'-methylendiimidazolin-2,2'-diyliden)palladium(II)diiodid 36

(Fehlhammer, W. P. et al.; Homoleptic carbene complexes. VI. Bis{1,1'-methylene-3,3'-dialkyl-diimidazolin-2,2'-diylidene}palladium chelate complexes by the free carbene route. Journal of Organometallic Chemistry 1995, 490, (1-2), 149-153; Herrmann, W. A. et al.; N-heterocyclic carbenes. 20. Homoleptic chelating N-heterocyclic carbene complexes of palladium and nickel. Journal of Organometallic Chemistry 1999, 575, (1), 80-86)

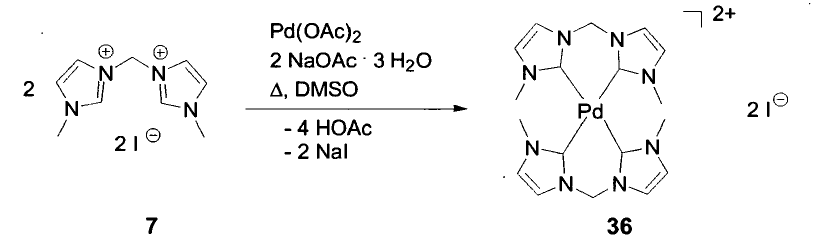

0,25 mmol Palladium(II)acetat (0,056 g) und 0,625 mmol 1,1'-Dimethyl-3,3'-methylen-diimidazoliumdiiodid **7** (0,270 g), sowie 0,5 mmol Natriumacetat-Trihydrat (0,068 g) werden mit 6 mL Dimethylsulfoxid in einem Schlenkrohr 2 Stunden bei 60 °C, 2 Stunden bei 80 °C und 1 Stunde bei 110 °C gerührt. Es werden bei 110 °C nochmals 0,5 mmol Natriumacetat-Trihydrat (0,068 g) zugegeben und weitere 5 Stunden bei 110 °C gerührt. Dann wird das Lösungsmittel bei 70 °C im Vakuum entfernt und der entstandene Feststoff wird mit wenig Wasser, wenig kaltem Methanol und Tetrahydrofuran gewaschen und getrocknet. Es entsteht ein weißer Feststoff **36.**

| | |
|---|---|
| **Summenformel:** C₁₈H₂₄N₈PdI₂ | M = 712,672 g/mol |
| **Ausbeute:** 0,096 g (53,9 % d. Th.) | |
| **Schmelzpunkt:** Zersetzung bei > 347 °C | |

**¹H** (ppm, d₆-DMSO, 300,13 MHz): δ = 7,75 (d, 4H, J = 1,8 Hz, NCHCHN); 7,44 (d, 4H, J = 1,8 Hz, NCHCHN); 6,75 (AB, 2H, J = 13,1 Hz, NCH₂N); 6,50 (AB, 2H, J = 13,1 Hz, NCH₂N); 3,37 (s, 12H, CH₃-Gruppe)

### B) Bis-(1,1'-dimethyl-3,3'-methylendiimidazolin-2,2'-diyliden)platin(II)diiodid 37a,b

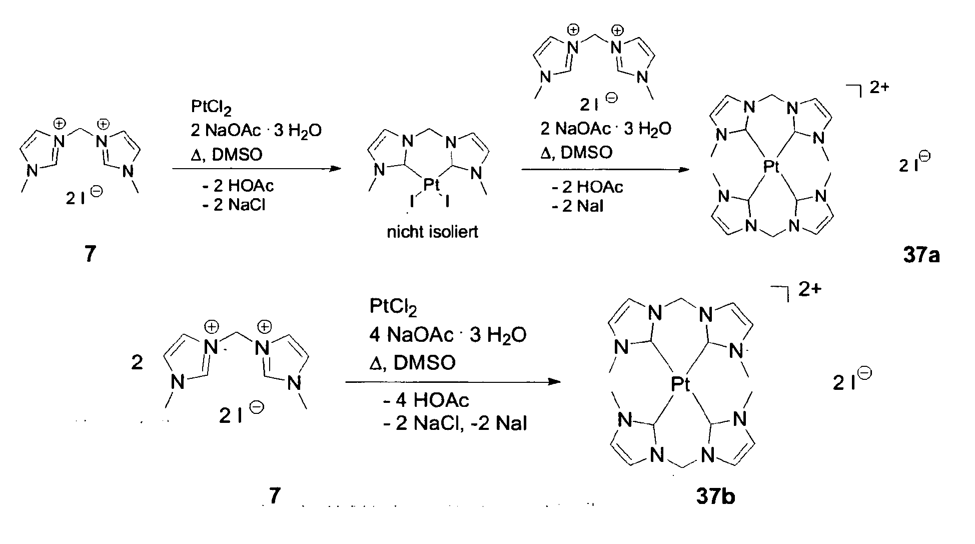

### Methode A:

0,5 mmol Platin(II)chlorid (0,133 g) und 0,5 mmol 1,1'-Dimethyl-3,3'-methylen-diimidazoliumdiiodid **7** (0,216 g), sowie 1 mmol Natriumacetat-Trihydrat (0,136 g) werden mit 5 mL Dimethylsulfoxid in einem Schlenkrohr 3 Stunden bei 60 °C, 3 Stunden bei 80 °C und weitere 3 Stunden bei 110 °C gerührt. Es werden dann bei Raumtemperatur nochmals 0,75 mmol 1,1'-Dimethyl-3,3'-methylen-diimidazoliumdiiodid **7** (0,324 g) und 1 mmol Natriumacetat-Trihydrat (0,136 g) zum Reaktionsgemisch gegeben. Es wird erneut das obige Temperaturprogramm durchgeführt. Dann wird das Lösungsmittel bei 70 °C im Vakuum entfernt und der entstandene Feststoff wird mit 10 mL Wasser und 5 mL Tetrahydrofuran gewaschen und getrocknet. Es entsteht ein weißer Feststoff **37a.**

### Methode B:

0,25 mmol Platin(II)chlorid (0,066 g) und 0,625 mmol 1,1'-Dimethyl-3,3'-methylen-diimidazoliumdiiodid **7** (0,270 g), sowie 0,5 mmol Natriumacetat-Trihydrat (0,068 g) werden mit 5 mL Dimethylsulfoxid in einem Schlenkrohr 2 Stunden bei 60 °C, 2 Stunden bei 80 °C und 1 Stunde bei 110 °C gerührt. Es werden bei 110 °C nochmals 0,5 mmol Natriumacetat-Trihydrat (0,068 g) zugegeben und weitere 5 Stunden bei 110 °C gerührt. Dann wird das Lösungsmittel bei 70 °C im Vakuum entfernt und der entstandene Feststoff wird mit 10 mL Wasser und 5 mL Tetrahydrofuran gewaschen und getrocknet. Es entsteht ein weißer Feststoff **37b.**

Die Analytik für 37a und 37b ergab gleichermaßen die unten aufgeführten Ergebnisse.

| | | |
|---|---|---|
| **Summenformel:** | C₁₈H₂₄N₈PtI₂ | M = 801,330 g/mol |
| **Ausbeute:** | *Methode A:* 0,320 g (79,9 % d. Th.) | |
| | *Methode B:* 0,137 g (68,4 % d.Th.) | |
| **Schmelzpunkt:** | Zersetzung bei > 360 °C | |

**¹H** (ppm, d₆-DMSO, 300,13 MHz):
δ = 7,75 (d, 4H, J = 1,8 Hz, NCHCHN); 7,47 (d, 4H, J = 1,8 Hz, NCHCHN); 6,54 (AB, 2H, J = 13,2 Hz, NCH₂N); 6,43 (AB, 2H, J = 13,2 Hz, NCH₂N); 3,32 (s, 12H, CH₃-Gruppe)

### C) Bis-(1,1'-diisopropyl-3,3'-methylendiimidazolin-2,2'-diyliden)palladium(II)diiodid 38

(Albrecht, M. et al.; Synthesis and structural analysis of palladium biscarbene complexes derived from bisimidazolium ligand precursors. Inorg. Chim. Acta 359 (2006), 1929-1938)

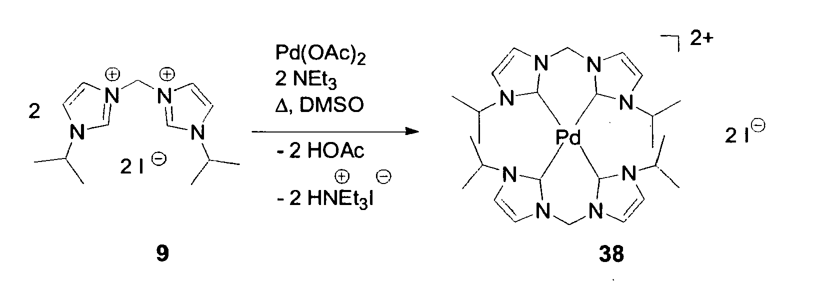

0,61 mmol 1,1'-Diisopropyl-3,3'-methylen-diimidazoliumdiiodid **9** (0,300 g) werden mit 1,54 mmol Triethylamin (0,155 g; 0,21 mL) in 5 mL Dimethylsulfoxid für 30 min bei Raumtemperatur gerührt. Es sind 0,305 mmol Palladium(II)diacetat (0,069 g) zuzugeben und weitere 3 Stunden bei Raumtemperatur zu rühren. Danach wird 18 Stunden bei 50 °C und 1 Stunde bei 150 °C gerührt. Das Dimethylsulfoxid wird im Vakuum bei 70 °C entfernt, der zurückgebliebene Feststoff wird zweimal mit je 2 mL Wasser und zweimal mit je 2 mL Methanol gewaschen und getrocknet. Es wird ein ockerfarbener Feststoff **38** erhalten.

| | |
|---|---|
| Summenformel:**C₂₆H₄₀N₈PdI₂** | **M = 824,88 g/mol** |
| Ausbeute: **0,110 g (43,7 % d. Th.)** | |
| Schmelzpunkt: **Zersetzung bei > 342 °C** | |

**¹H** (ppm, d₆-DMSO, 300,13 MHz):
δ = 7,80 (d, 4H, J = 1,8 Hz, NCHCHN); 7,63 (d, 4H, J = 1,8 Hz, NCHCHN); 6,59 (AB, 2H, J = 13,6 Hz, NCH₂N); 6,49 (AB, 2H, J = 13,4 Hz, NCH₂N); 3,88 (sept, 4H, J = 6,6 Hz, (CH₃)₂CHN); 1,26 (d, 12H, J = 6,8 Hz, CH₃-Gruppe); 1,15 (d, 12H, J = 6,6 Hz, CH₃-Gruppe)

### D) Bis-(1,1'-diisopropyl-3,3'-methylendiimidazolin-2,2'-diyliden)platin(II)diiodid 39a,b

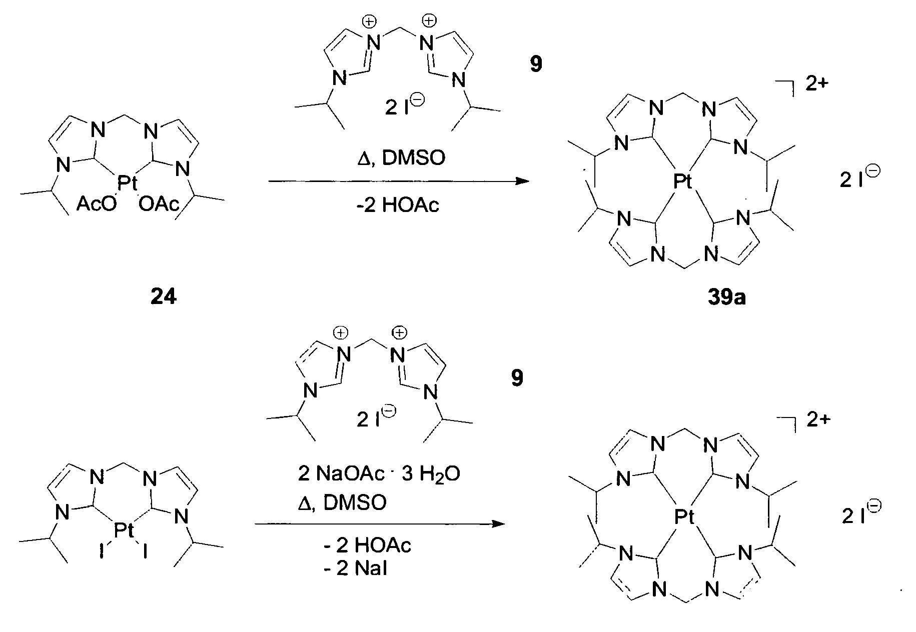

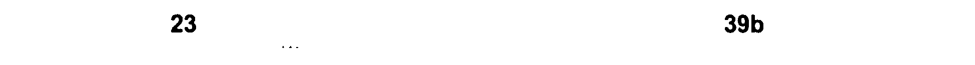

### Methode A:

0,22 mmol (1,1'-Diisopropyl-3,3'-methylendiimidazolin-2,2'-diyliden)platin(II)diacetat 24 (0,120 g) werden mit 0,22 mmol 1,1'-Diisopropyl-3,3'-methylen-diimidazoliumdiiodid 9 (0,107 g) versetzt, in 4 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der zurückgebliebene Feststoff wird zweimal mit jeweils 3 mL Wasser gewaschen. Es wird ein weißer Feststoff 39a erhalten.

### Methode B:

0,10 mmol (1,1'-Diisopropyl-3,3'-methylendiimidazolin-2,2'-diyliden)platin(II)diiodid 23 (0,070 g) und 0,10 mmol 1,1'-Diisopropyl-3,3'-methylen-diimidazoliumdiiodid 9 (0,050 g) werden zusammen mit 0,20 mmol Natriumacetat-Trihydrat (0,027 g) in 3 mL Dimethylsulfoxid gelöst. Das Gemisch ist 2 Stunden bei 60 °C, 2 Stunden bei 80 °C und weitere 5 Stunden bei 110 °C zu rühren. Das Dimethylsulfoxid wird im Vakuum bei 70 °C entfernt und der zurückgebliebene Feststoff wird zweimal in einem Methanol-Tetrahydrofuran-Gemisch gewaschen. Es wird ein weißer Feststoff 39b erhalten. Die Analytik für 39a und 39b ergab gleichermaßen die unten aufgeführten Ergebnisse.

| | | |
|---|---|---|
| Summenformel:**C₂₆H₄₀N₈PtI₂** | | **M = 913,538 g/mol** |
| Ausbeute: | ***Methode A:* 0,060 g (29,9 % d. Th.)** | |
| | ***Methode B:* 0,020 g (21,9 % d. Th.)** | |
| Schmelzpunkt: **Zersetzung bei > 350 °C** | | |

**¹H** (ppm, d₆-DMSO, 300,13 MHz):
δ = 7,80 (d, 4H, J = 1,8 Hz, NCHCHN); 7,67 (d, 4H, J = 1,9 Hz, NCHCHN); 6,52 (AB,
2H, J = 13,5 Hz, NCH₂N); 6,33 (AB, 2H, J = 13,4 Hz, NCH₂N); 3,90 (sept, 4H, J = 6,6 Hz, (CH₃)₂CHN); 1,28 (d, 12H, J = 6,8 Hz, CH₃-Gruppe); 1,12 (d, 12H, J = 6,6 Hz, CH₃-Gruppe)

### E) Bis-(1,1'-diisopropyl-3,3'-methylendiimidazolin-2,2'-diyliden)platin(II)dibromid 40

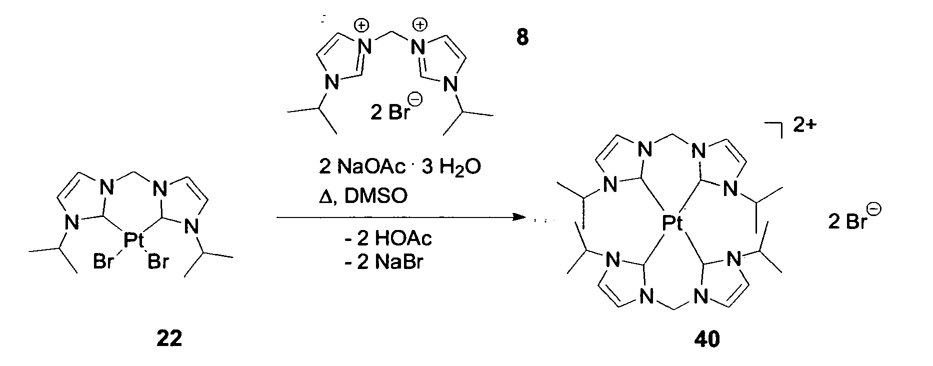

0,14 mmol (1,1'-Diisopropyl-3,3'-methylendiimidazolin-2,2'-diyliden)platin(II)dibromid 22 (0,080 g) und 0,14 mmol 1,1'-Diisopropyl-3,3'-methylen-diimidazoliumdibromid 8 (0,054 g) werden zusammen mit 0,28 mmol Natriumacetat-Trihydrat (0,037 g) in 4 mL Dimethylsulfoxid gelöst. Das Gemisch ist 2 Stunden bei 60 °C, 2 Stunden bei 80 °C und weitere 5 Stunden bei 110 °C zu rühren. Das Dimethylsulfoxid wird im Vakuum bei 70 °C entfernt und der zurückgebliebene Feststoff wird zweimal in einem Methanol-Tetrahydrofuran-Gemisch gewaschen. Es wird ein weißer Feststoff 40 erhalten.

| | |
|---|---|
| Summenformel:**C₂₆H₄₀N₈PtBr₂** | **M = 819,546 g/mol** |
| Ausbeute: **0,034 g (28,6 % d. Th.)** | |
| Schmelzpunkt: **Zersetzung bei > 390 °C** | |

**¹H** (ppm, d₆-DMSO, 300,13 MHz):
δ = 7,86 (s, 4H, NCHCHN); 7,70 (s, 4H, NCHCHN); 6,64 (AB, 2H, J = 13,3 Hz, NCH₂N); 6,35 (AB, 2H, J = 13,3 Hz, NCH₂N); 3,91 (sept, 4H, J = 6,6 Hz, (CH₃)₂CHN); 1,29 (d, 12H, J = 6,7 Hz, CH₃-Gruppe); 1,14 (d, 12H, J = 6,5 Hz, CH₃-Gruppe)

### F) Bis-(1,1'-di-n-butyl-3,3'-methylendiimidazolin-2,2'-diyliden)platin(II)diiodid 41

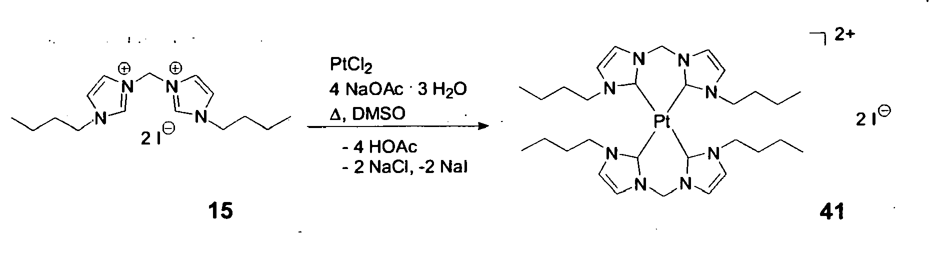

0,5 mmol Platin(II)chlorid (0,133 g) und 1,25 mmol 1,1'-Di-n-butyl-3,3'-methylen-diimidazoliumdiiodid **15** (0,645 g), sowie 1 mmol Natriumacetat-Trihydrat (0,136 g) werden mit 8 mL Dimethylsulfoxid in einem Schlenkrohr 2 Stunden bei 60 °C, 2 Stunden bei 80 °C und 1 Stunde bei 110 °C gerührt. Es werden bei 110 °C nochmals 1 mmol Natriumacetat-Trihydrat (0,136 g) zugegeben und weitere 5 Stunden bei 110 °C gerührt. Dann wird das Lösungsmittel bei 70 °C im Vakuum entfernt und der entstandene Feststoff wird zweimal mit je 3 mL Methanol und 3 mL Tetrahydrofuran gewaschen und getrocknet. Es entsteht ein weißer Feststoff **41.**

| | |
|---|---|
| **Summenformel:** C₃₀H₄₈N₈PtI₂ | M = 969,642 g/mol |
| **Ausbeute:** 0,136 g (28,1 % d. Th.) | |
| **Schmelzpunkt:** Zersetzung bei > 370 °C | |

**¹H** (ppm, d₆-DMSO, 300,13 MHz):
δ = 7,87 (s, 4H, NCHCHN); 7,63 (s, 4H, NCHCHN); 6,80 (AB, 2H, J = 13,4 Hz, NCH₂N); 6,17 (AB, 2H, J = 13,3 Hz, NCH₂N); 3,81 (m, 4H, J = 6,8 Hz, N-CH₂-CH₂-CH₂-CH₃); 3,23 (m, 4H, J = 6,9 Hz, N-CH₂-CH₂-CH₂-CH₃); 1,56 (quint, 8H, J = 7,2 Hz, N-CH₂-CH₂-CH₂-CH₃); 0,98 (sext, 8H, J = 7,4 Hz, N-CH₂-CH₂-CH₂-CH₃); 0,70 (t, 12H, J = 7,2 Hz, N-CH₂-CH₂-CH₂-CH₃)

### G) Bis-(1,1'-dicyclohexyl-3,3'-methylendiimidazolin-2,2'-diyliden)platin(II)diiodid 42

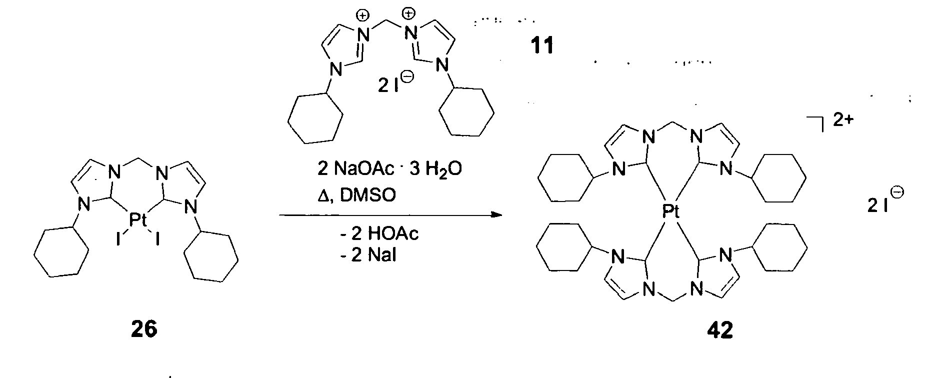

0,105 mmol (1,1'-Dicyclohexyl-3,3'-methylendiimidazolin-2,2'-diyliden)platin(II)diiodid 26 (0,080 g) und 0,105 mmol 1,1'-Dicyclohexyl-3,3'-methylen-diimidazoliumdiiodid 11 (0,060 g) werden zusammen mit 0,21 mmol Natriumacetat-Trihydrat (0,029 g) in 4 mL Dimethylsulfoxid gelöst. Das Gemisch ist 2 Stunden bei 60 °C, 2 Stunden bei 80 °C und weitere 5 Stunden bei 110 °C zu rühren. Das Dimethylsulfoxid wird im Vakuum bei 70 °C entfernt und der zurückgebliebene Feststoff wird zweimal in einem Methanol-Tetrahydrofuran-Gemisch gewaschen. Es wird ein weißer Feststoff 42 erhalten.

| | |
|---|---|
| Summenformel:**C₃₈H₅₆N₈PtI₂** | **M = 1073,786 g/mol** |
| Ausbeute: **0,028 g (24,8 % d. Th.)** | |
| Schmelzpunkt: **Zersetzung bei > 393 °C** | |

**¹H** (ppm, d₆-DMSO, 300,13 MHz):
δ = 7,89 (s, 4H, NCHCHN); 7,70 (s, 4H, NCHCHN); 6,68 (AB, 2H, J = 13,4 Hz, NCH₂N); 6,11 (AB, 2H, J = 13,7 Hz, NCH₂N); 3,34 (t, 4H, J = 11,8 Hz, CH von Cyclohexyl-Ring); 1,81 (d, 8H, J = 12,1 Hz, CH₂ von Cyclohexyl-Ring); 1,68 (d, 8H, J = 11,7 Hz, CH₂ von Cyclohexyl-Ring); 1,35 (d, 8H, J = 11,5 Hz, CH₂ von Cyclohexyl-Ring); 1,15 (t, 8H, J = 11,9 Hz, CH₂ von Cyclohexyl-Ring); 0,84 (t, 8H, J = 12,1 Hz, CH₂ von Cyclohexyl-Ring)

### 4.3 Heteroleptische Tetracarbenkomplexe

### A) (1,1'-Diisopropyl-3,3'-methylendiimidazolin-2,2'-diyliden)(1",1"'-dimethyl-3",3"'-methylendiimidazolin-2",2"'-diyliden)platin(II)diiodid 43a,b

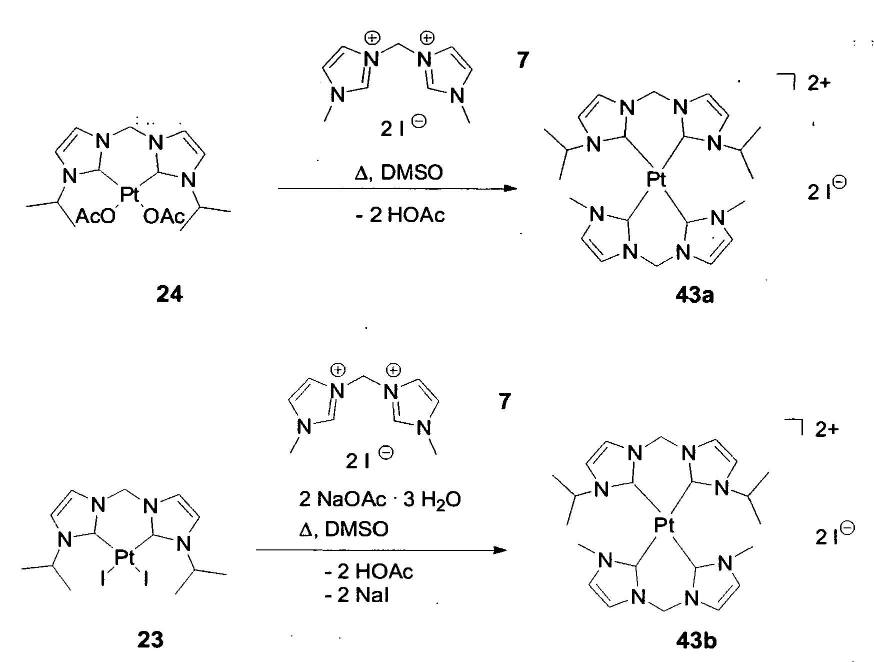

### Methode A:

0,13 mmol (1,1'-Diisopropyl-3,3'-methylendiimidazolin-2,2'-diyliden)platin(II)diacetat **24** (0,070 g) werden mit 0,13 mmol 1,1'-Dimethyl-3,3'-methylen-diimidazoliumdiiodid 7 (0,055 g) versetzt, in 3 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der zurückgebliebene Feststoff wird zweimal mit jeweils 1 mL Methanol gewaschen. Es wird ein weißer Feststoff 43a erhalten.

### Methode B:

0,13 mmol (1,1'-Diisopropyl-3,3'-methylendiimidazolin-2,2'-diyliden)platin(II)diiodid **23** (0,089 g) werden zusammen mit 0,13 mmol 1,1'-Dimethyl-3,3'-methylen-diimidazoliumdiiodid **7** (0,055 g) und 0,26 mmol Natriumacetat-Trihydrat in 3 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der entstandene Feststoff wird zweimal mit jeweils 1 mL Methanol gewaschen. Es wird ein weißer Feststoff **43b** erhalten.

Die Analytik für 43a und 43b ergab gleichermaßen die unten aufgeführten Ergebnisse.

| | | |
|---|---|---|
| Summenformel:**C₂₂H₃₂N₈PtI₂** | | **M = 857,434 g/mol** |
| Ausbeute: | ***Methode A:* 0,039 g (35,0 % d. Th.)** | |
| | ***Methode B:* 0,017 g (15,3 % d. Th.)** | |
| Schmelzpunkt: **Zersetzung bei > 360 °C** | | |

**¹H** (ppm, d₆-DMSO, 300,13 MHz):
δ = 7,80 (d, 2H, J = 1,8 Hz, NCHCHN); 7,75 (d, 2H, J = 1,8 Hz, NCHCHN); 7,71 (d, 2H, J = 1,9 Hz, NCHCHN); 7,47 (d, 2H, J = 1,7 Hz, NCHCHN); 6,58 (AB, 1H, J = 13,1 Hz, NCH₂N); 6,47 (AB, 1 H, J = 13,6 Hz, NCH₂N); 6,43 (AB, 1 H, J = 13,3 Hz, NCH₂N); 6,35 (AB, 1 H, J = 13,4 Hz, NCH₂N); 3,97 (sept, 2H, J = 6,6 Hz, (CH₃)₂CHN); 3,29 (s, 6H, CH₃-Gruppe); 1,28 (d, 6H, J = 6,8 Hz, CH₃-Gruppe); 1,10 (d, 6H, J = 6,6 Hz, CH₃-Gruppe)

### B) (1,1'-Dicyclohexyl-3,3'-methylendiimidazolin-2,2'-diyliden)(1",1"'-diisopropyl-3",3"'-methylendiimidazolin-2",2"'-diyliden)platin(II)diiodid 44

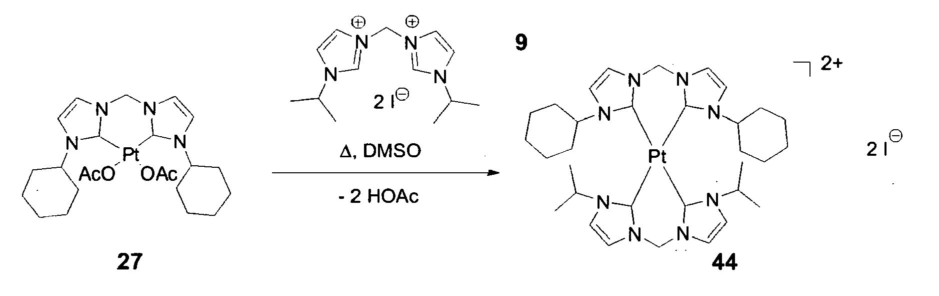

0,16 mmol (1,1'-Dicyclohexyl-3,3'-methylendiimidazolin-2,2'-diyliden)platin(II)diacetat **27** (0,100 g) werden zusammen mit 0,16 mmol 1,1'-Diisopropyl-3,3'-methylen-diimidazoliumdiiodid **9** (0,078 g) in 4 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der entstandene Feststoff wird zweimal in einem Methanol-Tetrahydrofuran-Gemisch gewaschen. Es wird ein weißer Feststoff **44** erhalten.

| | |
|---|---|
| Summenformel:**C₃₂H₄₈N₈PtI₂** | **M = 993,662 g/mol** |
| Ausbeute: **0,087 g (54,7 % d. Th.)** | |
| Schmelzpunkt: **Zersetzung bei > 343 °C** | |

**¹H** (ppm, d₆-DMSO, 300,13 MHz):
δ = 7,88 (d, 2H, J = 1,8 Hz, NCHCHN); 7,80 (d, 2H, J = 2,0 Hz, NCHCHN); 7,73 (d, 2H, J = 2,0 Hz, NCHCHN); 7,63 (d, 2H, J = 1,8 Hz, NCHCHN); 6,60 (AB, 1H, J = 13,5 Hz, NCH₂N); 6,51 (AB, 1 H, J = 13,4 Hz, NCH₂N); 6,39 (AB, 1 H, J = 13,5 Hz, NCH₂N); 6,05 (AB, 1 H, J = 13,3 Hz, NCH₂N); 3,98 (sept, 2H, J = 6,6 Hz, (CH₃)₂CHN); 3,25 (t, 2H, J = 11,9 Hz, CH von Cyclohexyl-Ring); 1,85 (d, 4H, J = 12,4 Hz, CH₂ von Cyclohexyl-Ring); 1,75 (d, 4H, J = 11,3 Hz, CH₂ von Cyclohexyl-Ring); 1,68 (d, 4H, J = 11,4 Hz, CH₂ von Cyclohexyl-Ring); 1,55 (t, 4H, J = 11,9 Hz, CH₂ von Cyclohexyl-Ring); 1,28 (d, 6H, J = 6,8 Hz, CH₃ von ⁱProp); 1,15 (d, 6H, J = 6,5 Hz, CH₃ von ⁱProp); 1,12 (t, 4H, J = 12,0 Hz, CH₂ von Cyclohexyl-Ring)

### C) (1,1'-Diisopropyl-3,3'-methylendiimidazolin-2,2'-diyliden)(1",1"'-di-n-butyl-3",3"'-methylendiimidazolin-2",2"'-diyliden)platin(II)diiodid 45

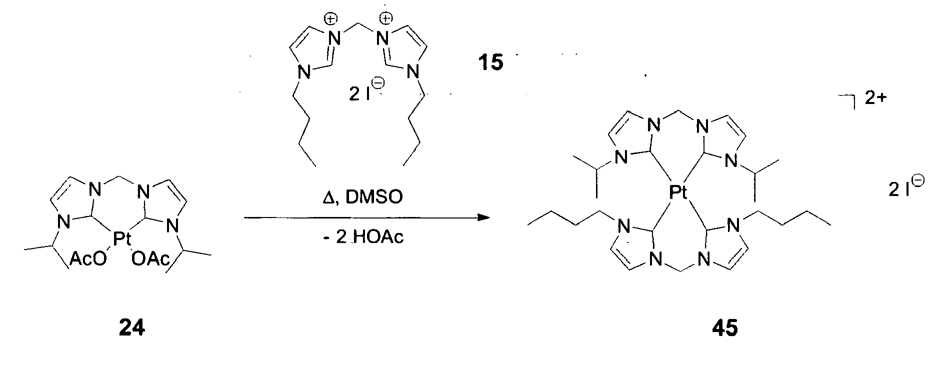

0,18 mmol (1,1'-Diisopropyl-3,3'-methylendiimidazolin-2,2'-diyliden)platin(II)diacetat **24** (0,100 g) werden zusammen mit 0,18 mmol 1,1'-Di-n-butyl-3,3'-methylen-diimidazoliumdiiodid **15** (0,094 g) in 4 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der entstandene Feststoff wird zweimal in einem Methanol-Tetrahydrofuran-Gemisch gewaschen. Es wird ein weißer Feststoff **45** erhalten.

| | |
|---|---|
| Summenformel:**C₂₈H₄₄N₈PtI₂** | **M = 941,590 g/mol** |
| Ausbeute: **0,085 g (50,2 % d. Th.)** | |
| Schmelzpunkt: **Zersetzung bei > 347 °C** | |

**¹H** (ppm, d₆-DMSO, 300,13 MHz):
δ = 7,89 (s, 2H, NCHCHN); 7,84 (s, 2H, NCHCHN); 7,81 (s, 2H, NCHCHN); 7,64 (s, 2H, NCHCHN); 6,59 (AB, 1H, J = 13,5 Hz, NCH₂N); 6,56 (AB, 1 H, J = 13,2 Hz, NCH₂N); 6,43 (AB, 1 H, J = 13,4 Hz, NCH₂N); 6,20 (AB, 1 H, J = 13,3 Hz, NCH₂N); 4,00 (sept, 2H, J = 6,6 Hz, (CH₃)₂CHN); 3,89 (m, 2H, J = 6,6 Hz, N-CH₂-CH₂-CH₂-CH₃); 3,24 (m, 2H, J = 6,6 Hz, N-CH₂-CH₂-CH₂-CH₃); 1,57 (quint, 4H, J = 7,2 Hz, N-CH₂-CH₂-CH₂-CH₃); 1,31 (d, 6H, J = 6,7 Hz, CH₃ von ⁱProp); 1,17 (d, 6H, J = 6,5 Hz, CH₃ von ⁱProp); 0,97 (sext, 4H, J = 6,9 Hz, N-CH₂-CH₂-CH₂-CH₃); 0,78 (t, 6H, J = 7,2 Hz, N-CH₂-CH₂-CH₂-CH₃)

### D) (1,1'-Dicyclohexyl-3,3'-methylendiimidazolin-2,2'-diyliden)(1",1"'-dimethyl-3",3"'-methylendiimidazolin-2",2"'-diyliden)platin(II)diiodid 46

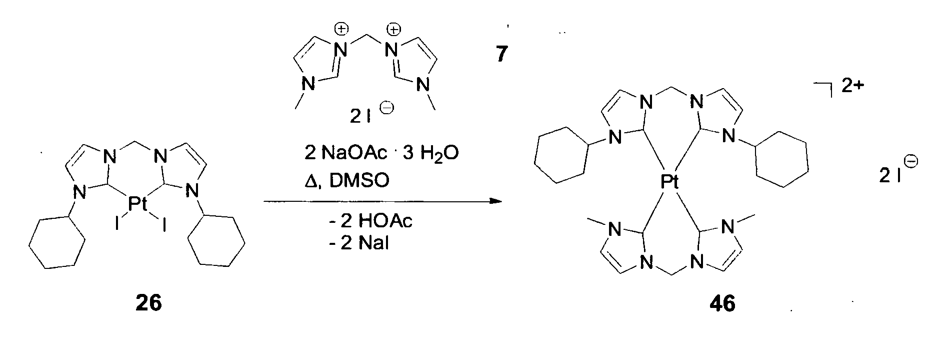

0,11 mmol (1,1'-Dicyclohexyl-3,3'-methylendiimidazolin-2,2'-diyliden)platin(II)diiodid **26** (0,080 g) werden zusammen mit 0,11 mmol 1,1'-Dimethyl-3,3'-methylen-diimidazoliumdiiodid **7** (0,045 g) und 0,21 mmol Natriumacetat-Trihydrat (0,029 g) in 3 mL Dimethylsulfoxid gelöst und 2 Stunden bei 60 °C, 2 Stunden bei 80 °C und weitere 5 Stunden bei 110 °C gerührt. Das Dimethylsulfoxid wird im Vakuum bei 70 °C entfernt und der entstandene Feststoff wird zweimal in einem Methanol-Tetrahydrofuran-Gemisch gewaschen. Es wird ein weißer Feststoff **46** erhalten.

| | |
|---|---|
| Summenformel:**C₂₈H₄₀N₈PtI₂** | **M = 937,558 g/mol** |
| Ausbeute: **0,065 g (63,0 % d. Th.)** | |
| Schmelzpunkt: **Zersetzung bei > 375 °C** | |

**¹H** (ppm, d₆-DMSO, 300,13 MHz):
δ = 7,84 (s, 2H, NCHCHN); 7,81 (s, 2H, NCHCHN); 7,67 (s, 2H, NCHCHN); 7,52 (s, 2H, NCHCHN); 6,66 (AB, 1 H, J = 13,1 Hz, NCH₂N); 6,63 (AB, 1 H, J = 13,4 Hz, NCH₂N); 6,52 (AB, 1 H, J = 13,2 Hz, NCH₂N); 6,15 (AB, 1 H, J = 13,4 Hz, NCH₂N); 3,59 (t, 2H, J = 12,5 Hz, CH von Cyclohexyl-Ring); 3,35 (s, 6H, CH₃ von Me); 1,85 (d, 4H, J = 12,5 Hz, CH₂ von Cyclohexyl-Ring); 1,76 (d, 4H, J = 10,1 Hz, CH₂ von Cyclohexyl-Ring); 1,67 (d, 4H, J = 10,9 Hz, CH₂ von Cyclohexyl-Ring); 1,37 (t, 4H, J = 9,5 Hz, CH₂ von Cyclohexyl-Ring); 1,12 (t, 4H, J = 9,6 Hz, CH₂ von Cyclohexyl-Ring)

### E) (1,1'-Dibenzyl-3,3'-methylendiimidazolin-2,2'-diyliden)(1",1"'-dimethyl-3",3"'-methylendiimidazolin-2",2"'-diyliden)platin(II)dibromid 47

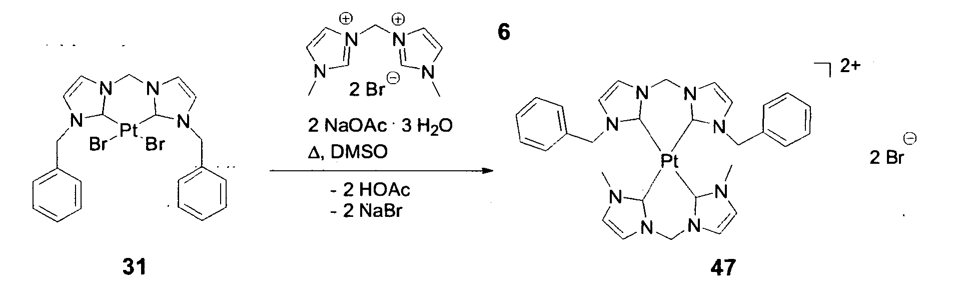

0,12 mmol (1,1'-Dibenzyl-3,3'-methylendiimidazolin-2,2'-diyliden)platin(II)dibromid **31** (0,080 g) werden mit 0,12 mmol 1,1'-Dimethyl-3,3'-methylen-diimidazoliumdibromid **6** (0,040 g) und 0,24 mmol Natriumacetat-Trihydrat (0,033 g) in einem Schlenkrohr vereinigt. Es werden 4 mL Dimethylsulfoxid zugesetzt und das Reaktionsgemisch ist für 2 Stunden bei 60 °C zu rühren, danach 2 Stunden bei 80 °C und weitere 5 Stunden bei 110 °C. Das Lösungsmittel wird bei 70 °C im Vakuum entfernt, der ausfallende Feststoff wird zweimal in einem Methanol-Tetrahydrofuran-Gemisch gewaschen und getrocknet. Es entsteht ein weißer Feststoff **47.**

| | |
|---|---|
| **Summenformel:** C₃₀H₃₂N₈PtBr₂ | M = 859,522 g/mol |
| **Ausbeute:** 0,028 g (27,1 % d. Th.) | |
| **Schmelzpunkt:** Zersetzung bei > 341 °C | |

**¹H** (ppm, d₆-DMSO, 300,13 MHz):
δ = 7,79 (d, 2H, J = 1,8 Hz, NCHCHN); 7,77 (d, 2H, J = 1,8 Hz, NCHCHN); 7,51 (d, 2H, J = 1,9 Hz, NCHCHN); 7,47 (d, 2H, J = 1,8 Hz, NCHCHN); 7,28 (d, 6H, J = 7,4 Hz, arom. CH); 7,08 (d, 4H, J = 6,1 Hz, arom. CH); 6,68 (AB, 1 H, J = 13,1 Hz, NCH₂N); 6,51 (AB, 1 H, J = 13,1 Hz, NCH₂N); 6,48 (AB, 1H, J = 13,4 Hz, NCH₂N); 6,23 (AB, 1H, J = 13,4 Hz, NCH₂N); 5,03 (AB, 2H, J = 14,3 Hz, NCH₂Ph); 4,63 (AB, 2H, J = 14,3 Hz, NCH₂Ph); 3,33 (s, 6H, CH₃)

### F) (1,1'-Di-(2,4,6-Trimethylphenyl)-3,3'-methylendiimidazolin-2,2'-diyliden)(1",1"'-dimethyl-3",3"'-methylendiimidazolin-2",2"'-diyliden)platin(II)dibromid 48

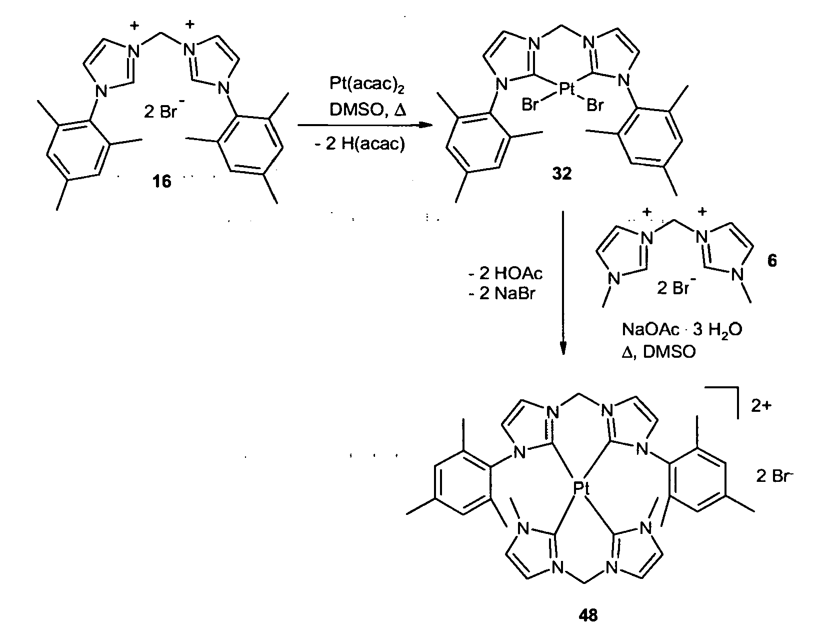

0,55 mmol Platin(II)acetylacetonat (0,216 g) und 0,55 mmol 1,1'-Di-(2,4,6-trimethylphenyl)-3,3'-methylendiimidazoliumdibromid **16** (0,300 g) werden mit 5 mL Dimethylsulfoxid in einem Schlenkrohr 2 Stunden bei 80 °C, 2 Stunden bei 100 °C und weitere 2 Stunden bei 130 °C gerührt. Das Reaktionsgemisch wird auf 60 °C abgekühlt. Es werden 0,275 mmol 1,1'-Dimethyl-3,3'-methylen-diimidazolium-dibromid **6** (0,093 g) und 0,55 mmol Natriumacetat-Trihydrat (0,075 g) zum Reaktionsgemisch gegeben und mit 2 mL Dimethylsulfoxid nachgespült. Die Mischung wird 2 Stunden bei 60 °C, 14 Stunden bei 80 °C, 4 Stunden bei 110 °C und 2 Stunden bei 130 °C gerührt. Dann wird das Lösungsmittel bei 70 °C im Vakuum entfernt, der entstandene Feststoff mit einem Methanol-Tetrahydrofuran-Gemisch gewaschen und im Vakuum getrocknet. Es entsteht ein weißer Feststoff **48.**

| | |
|---|---|
| **Summenformel:** | C₃₄H₄₀N₈PtBr₂ |
| **Molare Masse:** | 915,626 g/mol |
| **Ausbeute:** | 0,082 g (32,6 % d. Th.) |
| **Schmelzpunkt:** | Zersetzung bei > 400 °C |

**¹H**-NMR (ppm, d₆-DMSO, 300,13 MHz):
δ = 7,78 (s, 2H, NCHCHN von Mes-Ligand); 7,75 (s, 2H, NCHCHN von Me-Ligand); 7,48 (s, 2H, NCHCHN von Me-Ligand); 7,28 (s, 2H, NCHCHN von Mes-Ligand); 6,92 (s, 2H, arom. CH); 6,87 (s, 2H, arom. CH); 6,55 (AB, 1H, J = 13,1 Hz, NCH2N von Me-Ligand); 6,44 (AB, 1 H, J = 13,1 Hz, NCH₂N von Me-Ligand); 6,33 (AB, 1 H, J = 13,0 Hz, NCH₂N von Mes-Ligand); 6,15 (AB, 1H, J = 12,9 Hz, NCH₂N von Mes-Ligand); 3,32 (s, 6H, CH₃ von Me-Ligand); 2,26 (s, 6H, p-CH₃); 2,08 (s, 6H, o-CH₃); 2,00 (s, 6H, o-CH₃).

### 5. Synthese von höher N-substituierten Imidazolen

### Arbeitsvorschriften:

Die folgenden Verbindungen wurden in Anlehnung an die genannten Literaturvorschriften (Pilarski, B., Liebigs Annalen der Chemie 1983, (6), 1078-1080.; Starikova, O. V.; Dolgushin, G. V.; Larina, L. I.; Ushakov, P. E.; Komarova, T. N.; Lopyrev, V. A., Russian Journal of Organic Chemistry (Translation of Zhurnal Organicheskoi Khimii) 2003, 39 (10), 1467-1470.) synthetisiert.

### 1-Methylbenzimidazol 51

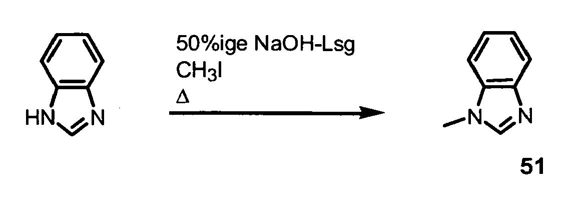

In einem Zweihalskolben mit Rückflusskühler und Rührer werden 0,05 mol Benzimidazol (5,907 g) mit 15 mL 50%iger Natronlauge und 0,055 mol Methyliodid (7,807 g; 3,42 mL) versetzt. Die Reaktionsmischung wird 3 Minuten bei Raumtemperatur gerührt, bis die Mischung fest wird. Danach wird auf 30 - 40 °C erwärmt um die Mischung zu verflüssigen. Die Temperatur wird insgesamt 12 Minuten beibehalten. Nach dem Abkühlen wird das Reaktionsgemisch dreimal mit jeweils 15 mL Dichlormethan extrahiert, danach mit Wasser gewaschen und über Natriumsulfat getrocknet. Das Lösungsmittel wird am Rotationsverdampfer entfernt. Es entsteht eine farblose Flüssigkeit **51.**

| | | |
|---|---|---|
| **Summenformel:** | C₈H₈N₂ | M = 132,164 g/mol |
| **Ausbeute:** | 5,432 g (82,2 % d. Th.) | |

**¹H-NMR** (ppm, d₆-DMSO, 300,13 MHz):
δ = 8,20 (s, 1 H, NCHN); 7,69 (dd, 1 H, ³J_{HH} = 7,0 Hz, ⁵J_{HH} = 1,2 Hz, arom. CH); 7,55 (dd, 1 H, ³J_{HH} = 7,1 Hz, ⁵J_{HH} = 1,2 Hz, arom. CH); 7,25 (m, 2H, ³J_{HH} = 7,2 Hz, ⁵J_{HH} = 1,3 Hz, arom. CH); 3,84 (s, 3H, CH₃-Gruppe)

| **Elementaranalyse** für C₈H₈N₂: | | | |
|---|---|---|---|
| | C | H | N |
| berechnet | 72,70 % | 6,10 % | 21,20 % |
| gefunden | 70,93 % | 6,17 % | 21,04 % |

### 1-iso-Propylbenzimidazol 54

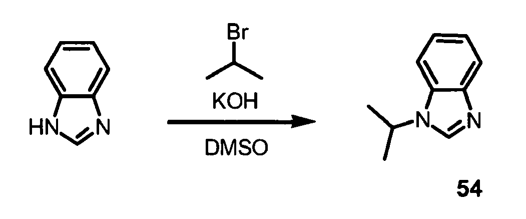

0,2 mol Benzimidazol (23,628 g) werden in 55 mL Dimethylsulfoxid gelöst. Zu dieser Mischung werden 0,3 mol gepulvertes Kaliumhydroxid (16,832 g) gegeben und 30 Minuten gerührt. Danach werden 0,2 mol *iso*-Propylbromid (24,598 g; 18,8 mL) zugetropft, dabei wird das Gemisch mit einem Wasserbad gekühlt. Nach 2 Stunden Rühren wird das Reaktionsgemisch mit Wasser gequencht, mit Dichlormethan extrahiert, mit Wasser gewaschen und die organische Phase über Magnesiumsulfat getrocknet. Danach wird das Lösungsmittel am Rotationsverdampfer entfernt. Es entsteht eine farblose Flüssigkeit **54.**

| | | |
|---|---|---|
| **Summenformel:** | C₁₀H₁₂N₂ | M = 160,226 g/mol |
| **Ausbeute:** | 26,082 g (81,4 % d. Th.) | |

**¹H-NMR** (ppm, d₆-DMSO, 300,13 MHz):
δ = 8,34 (s, 1 H, NCHN); 7,65 (m, 2H, ³J_{HH} = 6,0 Hz, ⁵J_{HH} = 1,5 Hz, arom. CH); 7,22 (m, 2H, ³J_{HH} = 6,0 Hz, ⁵J_{HH} = 1,4 Hz, arom. CH); 4,75 (sept, 1 H, J = 6,8 Hz, NCH(CH₃)₂); 1,54 (d, 6H, J = 6,8 Hz, CH₃-Gruppe)

| **Elementaranalyse** für C₁₀H₁₂N₂: | | | |
|---|---|---|---|
| | C | H | N |
| berechnet | 74,96 % | 7,55 % | 17,49 % |
| gefunden | 72,86 % | 7,47 % | 17,49 % |

### 6. Synthese von Bisbenzimidazolen

### 1,1'-Methylenbis(3-methyl-1H-benzo[d]imidazolium)dibromid 58

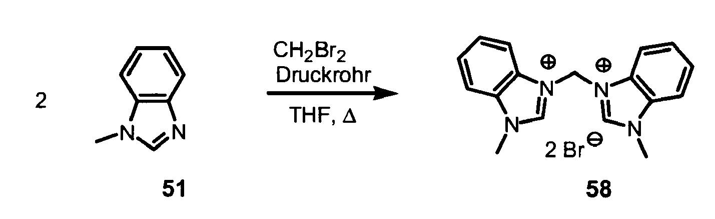

0,015 mol 1-Methylbenzimidazol **51** (2,000 g) werden in einem Druckrohr in 5 mL Tetrahydrofuran gelöst und mit 0,0075 mol Dibrommethan (1,304 g; 0,53 mL) versetzt. Das Reaktionsgemisch wird 3 Tage bei 110 °C gerührt. Der ausfallende Feststoff wird abfiltriert und dreimal mit 5 mL Tetrahydrofuran gewaschen. Danach wird das Produkt im Vakuum getrocknet. Es entsteht ein weißer Feststoff **58.**

| | | |
|---|---|---|
| **Summenformel:** | C₁₇H₁₈N₄Br₂ | M = 438,162 g/mol |
| **Ausbeute:** | 2,497 g (76,0 % d. Th.) | |
| **Schmelzpunkt:** | Zersetzung bei > 250 °C | |

**¹H-NMR** (ppm, d₆-DMSO, 300,13 MHz):
δ = 10,32 (s, 2H, NCHN); 8,42 (dd, 2H, ³J_{HH} = 7,1 Hz, ⁵J_{HH} = 1,7 Hz, arom. CH); 8,09 (dd, 2H, ³J_{HH} = 7,1 Hz, ⁵J_{HH} = 2,0 Hz, arom. CH); 7,78 (m, 4H, J = 7,0 Hz, arom. CH); 7,50 (s, 2H, NCH₂N); 4,16 (s, 6H, CH₃-Gruppe)

| **Elementaranalyse** für C₁₇H₁₈N₄Br₂: | | | |
|---|---|---|---|
| | C | H | N |
| berechnet | 46,60 % | 4,14 % | 12,79 % |
| gefunden | 45,99 % | 4,23 % | 12,56 % |

### 1,1'-Methylenbis(3-methyl-1H-benzo[d]imidazolium)diiodid 59

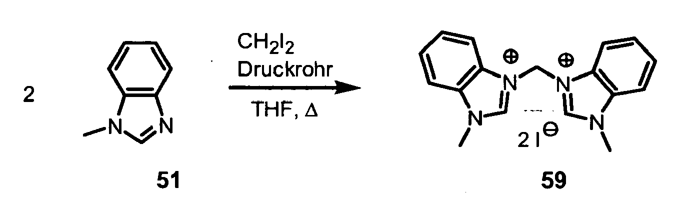

0,015 mol 1-Methylbenzimidazol **51** (2,000 g) werden in einem Druckrohr in 5 mL Tetrahydrofuran gelöst und mit 0,0075 mol Diiodmethan (2,027 g; 0,61 mL) versetzt. Das Reaktionsgemisch wird 3 Tage bei 110 °C gerührt. Der ausfallende Feststoff wird abfiltriert und dreimal mit 5 mL Tetrahydrofuran gewaschen. Danach wird das Produkt im Vakuum getrocknet. Es entsteht ein weißer Feststoff **59.**

| | | |
|---|---|---|
| **Summenformel:** | C₁₇H₁₈N₄I₂ | M = 532,154 g/mol |
| **Ausbeute:** | 3,408 g (85,4 % d. Th.) | |
| **Schmelzpunkt:** | Zersetzung bei > 255 °C | |

**¹H-NMR** (ppm, d₆-DMSO, 300,13 MHz):
δ = 10,19 (s, 2H, NCHN); 8,38 (dd, 2H, ³J_{HH} = 7,3 Hz, ⁵J_{HH} = 1,4 Hz, arom. CH); 8,10 (dd, 2H, ³J_{HH} = 7,0 Hz, ⁵J_{HH} = 1,7 Hz, arom. CH); 7,80 (m, 4H, ³J_{HH} = 6,3 Hz, ⁵J_{HH} = 1,2 Hz, arom. CH); 7,44 (s, 2H, NCH₂N); 4,16 (s, 6H, CH₃-Gruppe)

| **Elementaranalyse** für C₁₇H₁₈N₄I₂: | | | |
|---|---|---|---|
| | C | H | N |
| berechnet | 38,37 % | 3,41 % | 10,53 % |
| gefunden | 38,35 % | 3,31 % | 10,45 % |

### 1,1'-Methylenbis(3-iso-propyl-1H-benzo[d]imidazolium)dibromid 61

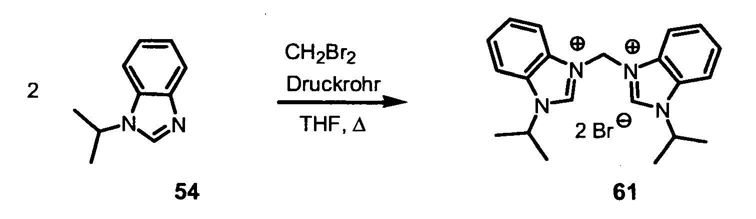

0,0187 mol 1-*iso*-Propylbenzimidazol **54** (3,000 g) werden in einem Druckrohr in 8 mL Tetrahydrofuran gelöst und mit 0,0094 mol Dibrommethan (1,627 g; 0,66 mL) versetzt. Das Reaktionsgemisch wird 3 Tage bei 110 °C gerührt. Der ausfallende Feststoff wird abfiltriert und dreimal mit 5 mL Tetrahydrofuran gewaschen. Danach wird das Produkt im Vakuum getrocknet. Es entsteht ein weißer Feststoff **61.**

| | | |
|---|---|---|
| **Summenformel:** | C₂₁H₂₆N₄Br₂ | M = 494,266 g/mol |
| **Ausbeute:** | 3,021 g (65,3 % d. Th.) | |
| **Schmelzpunkt:** | 283 °C | |

**¹H-NMR** (ppm, d₆-DMSO, 300,13 MHz):
δ = 10,67 (s, 2H, NCHN); 8,46 (d, 2H, J = 7,9 Hz, arom. CH); 8,21 (d, 2H, J = 7,8 Hz, arom. CH); 7,77 (m, 4H, ³J_{HH} = 7,2 Hz, ⁵J_{HH} = 1,2 Hz, arom. CH); 7,39 (s, 2H, NCH₂N); 5,14 (sept, 2H, J = 6,6 Hz, NCH(CH₃)₂); 1,68 (d, 12H, J = 6,6 Hz, CH₃-Gruppe)

| **Elementaranalyse** für C₂₁H₂₆N₄Br₂: | | | |
|---|---|---|---|
| | C | H | N |
| berechnet | 51,03 % | 5,30 % | 11,34 % |
| gefunden | 51,18 % | 5,33 % | 11,41 % |

### 7. Weitere Biscarbenkomplexe

### (1,1'-Dimethyl-3,3'-methylendiimidazolin-2,2'-diyliden)platin(II)ditrifluoracetat 77

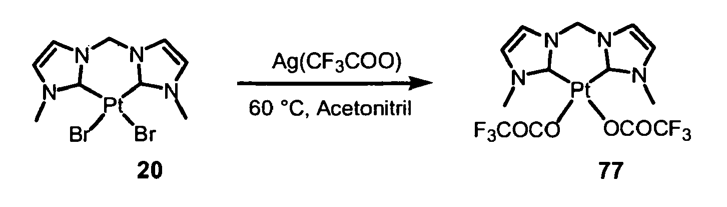

Zu 0,56 mmol (1,1'-Dimethyl-3,3'-methylendiimidazolin-2,2'-diyliden)platin(II)dibromid **20** (0,300 g) werden 1,13 mmol Silbertrifluoracetat (0,250 g) in 12 mL Acetonitril gegeben. Das Gemisch wird unter Lichtausschluss 15 Stunden bei 60 °C gerührt. Das ausfallende Silberbromid wird abfiltriert und das Lösungsmittel wird im Vakuum entfernt. Es entsteht ein gelber Feststoff **77.**

| | | |
|---|---|---|
| **Summenformel:** | C₁₃H₁₂N₄O₄F₆Pt | M = 597,344 g/mol |
| **Ausbeute:** | 0,351 g (100 % d. Th.) | |
| **Schmelzpunkt:** | Zersetzung bei > 400 °C | |

**¹H-NMR** (ppm, d₆-DMSO, 300,13 MHz):
δ = 7,60 (d, 2H, J = 1,8 Hz, NCHCHN); 7,38 (d, 2H, J = 1,7 Hz, NCHCHN); 6,12 (s, 2H, NCH₂N); 3,67 (s, 6H, CH₃-Gruppe)
**¹⁹F-NMR** (ppm, d₆-DMSO, 282,4 MHz):
δ = -73,55 (CF₃COO)

| **Elementaranalyse** für C₁₃H₁₂N₄O₄F₆Pt: | | | |
|---|---|---|---|
| | C | H | N |
| berechnet | 26,14 % | 2,02 % | 9,38 % |
| gefunden | 25,12 % | 1,96 % | 8,42 % |

### (1,1'-Dimethyl-3,3'-methylendiimidazolin-2,2'-diyliden)platin(II)ditetrafluorborat 78

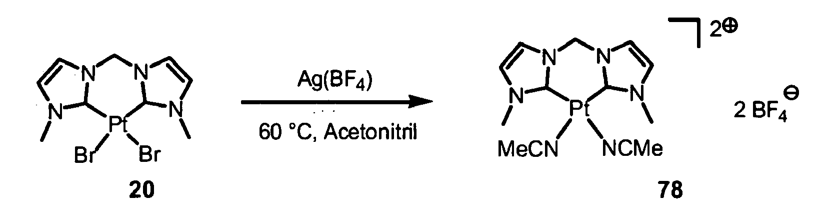

Zu 0,38 mmol (1,1'-Dimethyl-3,3'-methylendiimidazolin-2,2'-diyliden)platin(II)dibromid **20** (0,200 g) werden 0,75 mmol Silbertetrafluorborat (0,147 g) in 6 mL Acetonitril gegeben. Das Gemisch wird unter Lichtausschluss 8 Stunden bei 60 °C gerührt. Das ausfallende Silberbromid wird abfiltriert und das Lösungsmittel wird im Vakuum entfernt. Es entsteht ein weißer Feststoff **78**. Das Produkt ist unter Argon zu lagern.

| | | |
|---|---|---|
| **Summenformel:** | C₉H₁₂N₄B₂F₈Pt | M = 544,910 g/mol |
| **Ausbeute:** | 0,220 g (100 % d. Th.) | |
| **Schmelzpunkt:** | Zersetzung bei > 190 °C | |

**¹H-NMR** (ppm, d₆-DMSO, 300,13 MHz):
δ = 7,72 (s, 2H, NCHCHN); 7,53 (d, 2H, J = 1,6 Hz, NCHCHN); 6,30 (s, 2H, NCH₂N); 3,88 (s, 6H, CH₃-Gruppe)
**¹⁹F-NMR** (ppm, d₆-DMSO, 282,4 MHz):
δ = -148,24 (BF₄)

| **Elementaranalyse** für C₉H₁₂N₄B₂F₈Pt: | | | |
|---|---|---|---|
| | C | H | N |
| berechnet | 19,84 % | 2,22 % | 10,28 % |
| gefunden | 24,82 % | 2,88 % | 12,79 % |

### 1,1'-Methylenbis(3-methylbenzimidazolin-2-yliden)platin(II)dibromid 79

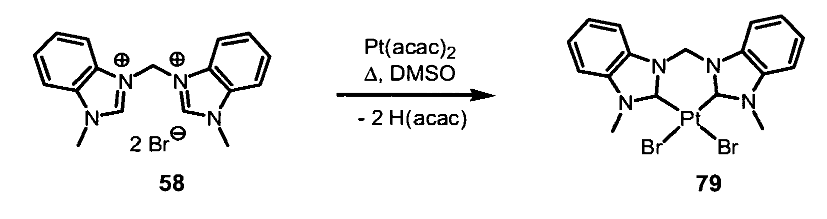

0,57 mmol Platin(II)acetylacetonat (0,224 g) werden mit 0,57 mmol 1,1'-Methylenbis (3-methyl-1*H*-benzo[*d*]imidazolium)dibromid **58** (0,250 g) in einem Schlenkrohr vereinigt. Es werden 5 mL Dimethylsulfoxid zugesetzt und das Reaktionsgemisch ist für 4 Stunden bei 60 °C, 15 Stunden bei 80 °C, 4 Stunden bei 110 °C und weitere 5 Stunden bei 130 °C zu rühren. Das Lösungsmittel wird bei 70 °C im Vakuum entfernt, der ausfallende Feststoff wird zweimal mit 3 mL Methanol, danach zweimal mit 3 mL Tetrahydrofuran gewaschen und im Vakuum getrocknet. Es entsteht ein weißer Feststoff **79.**

| | | |
|---|---|---|
| **Summenformel:** | C₁₇H₁₆N₄PtBr₂ | M = 631,224 g/mol |
| **Ausbeute:** | 0,230 g (63,9 % d. Th.) | |
| **Schmelzpunkt:** | Zersetzung bei > 400 °C | |

**¹H-NMR** (ppm, d₆-DMSO, 300,13 MHz):
δ = 8,32 (d, 2H, J = 7,8 Hz, arom. CH); 7,80 (d, 2H, J = 7,7 Hz, arom. CH); 7,58 (m, 4H, ³J_{HH} = 7,6 Hz, ⁵J_{HH} = 1,3 Hz, arom. CH); 7,27 (AB, 1H, J = 14,0 Hz, NCH₂N); 6,57 (AB, 1 H, J = 14,0 Hz, NCH₂N); 4,17 (s, 6H, CH₃-Gruppe)

| **Elementaranalyse** für C₁₇H₁₆N₄PtBr₂: | | | |
|---|---|---|---|
| | C | H | N |
| berechnet | 32,35 % | 2,56 % | 8,88 % |
| gefunden | 31,39 % | 2,44 % | 8,58 % |

### 1,1'-Methylenbis(3-iso-propylbenzimidazolin-2-yliden)platin(II)dibromid 80

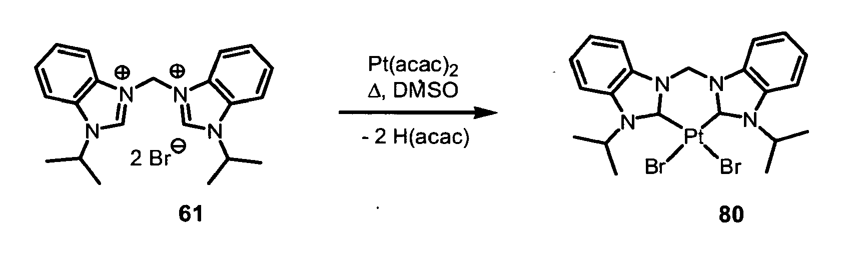

2,0 mmol Platin(II)acetylacetonat (0,787 g) werden mit 2,0 mmol 1,1'-Methylenbis (3-*iso*-propyl-1*H*-benzo[*d*]imidazolium)dibromid **61** (0,989 g) in einem Schlenkrohr vereinigt. Es werden 15 mL Dimethylsulfoxid zugesetzt und das Reaktionsgemisch ist für 4 Stunden bei 60 °C, 20 Stunden bei 80 °C, 4 Stunden bei 110 °C und weitere 5 Stunden bei 130 °C zu rühren. Das Lösungsmittel wird bei 70 °C im Vakuum entfernt, der ausfallende Feststoff wird einmal mit 6 mL Wasser, einmal mit 6 mL Methanol, danach zweimal mit 6 mL Tetrahydrofuran gewaschen und im Vakuum getrocknet. Es entsteht ein weißer Feststoff **80.**

| | | |
|---|---|---|
| **Summenformel:** | C₂₁H₂₄N₄PtBr₂ | M = 687,328 g/mol |
| **Ausbeute:** | 0,873 g (63,5 % d. Th.) | |
| **Schmelzpunkt:** | 377 °C | |

**¹H-NMR** (ppm, d₆-DMSO, 300,13 MHz):
δ = 8,32 (d, 2H, J = 7,9 Hz, arom. CH); 8,00 (d, 2H, J = 8,1 Hz, arom. CH); 7,48 (m, 4H, J = 7,4 Hz, arom. CH); 7,24 (AB, 1 H, J = 14,0 Hz, NCH₂N); 6,55 (AB, 1 H, J = 13,9 Hz, NCH₂N); 6,00 (sept, 2H, J = 7,1 Hz, NCH(CH₃)₂); 1,86 (d, 6H, J = 6,9 Hz, CH₃-Gruppe); 1,51 (d, 6H, J = 7,1 Hz, CH₃-Gruppe)

| **Elementaranalyse** für C₂₁H₂₄N₄PtBr₂0,8 DMSO: | | | | |
|---|---|---|---|---|
| | C | H | N | S |
| berechnet | 36,20 % | 3,87 % | 7,47 % | 3,42 % |
| gefunden | 36,52 % | 3,90 % | 7,34 % | 3,52 % |

### 1,1'-Methylenbis(3-iso-propylbenzimidazolin-2-yliden)platin(II)diacetat 81

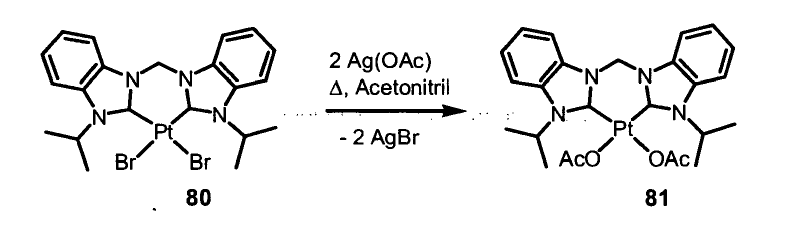

Zu 0,29 mmol 1,1'-Methylenbis(3-*iso*-propylbenzimidazolin-2-yliden)platin(II)dibromid **80** (0,200 g) werden 0,58 mmol Silberacetat (0,097 g) in 7 mL Acetonitril gegeben. Das Gemisch wird unter Lichtausschluss 8 Stunden bei 60 °C gerührt. Das ausfallende Silberbromid, sowie nicht umgesetzte Edukte, werden abfiltriert und das Lösungsmittel wird im Vakuum entfernt. Es entsteht ein weißer Feststoff **81.**

| | | |
|---|---|---|
| **Summenformel:** | C₂₅H₃₀N₄O₄Pt | M = 645,608 g/mol |
| **Ausbeute:** | 0,032 g (17,1 % d. Th.) | |

**¹H-NMR** (ppm, d₆-DMSO, 300,13 MHz):
δ = 8,17 (d, 2H, J = 8,0 Hz, arom. CH); 7,83 (d, 2H, J = 8,0 Hz, arom. CH); 7,39 (t, 2H, J = 7,6 Hz, arom. CH); 7,29 (t, 2H, J = 7,4 Hz, arom. CH); 7,14 (AB, 1H, J = 13,7 Hz, NCH₂N); 6,28 (AB, 1H, J = 13,9 Hz, NCH₂N); 5,52 (sept, 2H, J = 7,0 Hz, NCH(CH₃)₂); 1,80 (s, 6H, CH₃-Gruppe von OAc); 1,61 (d, 6H, J = 6,9 Hz, CH₃-Gruppe); 1,41 (d, 6H, J = 7,0 Hz, CH₃-Gruppe)

### 8. Weitere homoleptische Tetracarbenkomplexe

### Bis-(1,1'-dimethyl-3,3'-methylendiimidazolin-2,2'-diyliden)platin(II)dibromid 82

(Zeller, A., Dissertation, TU München, **2005**.)

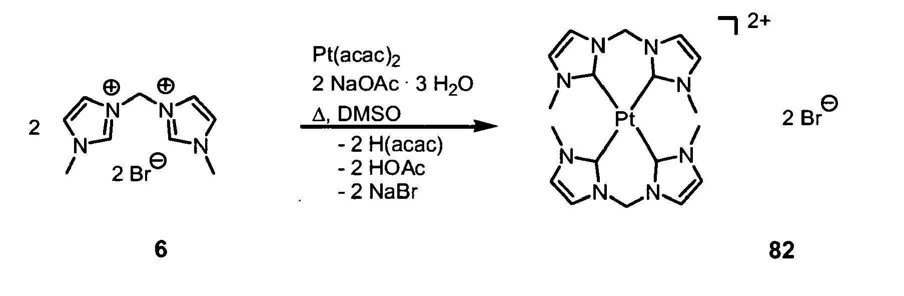

2,5 mmol Platin(II)acetylacetonat (0,983 g) und 5,92 mmol 1,1'-Dimethyl-3,3'-methylen-diimidazoliumdibromid **6** (2,000 g) werden in 20 mL Dimethylsulfoxid gelöst und 4 Stunden bei 60 °C sowie 5 Stunden bei 80 °C gerührt. Bei einer Temperatur von 80 °C werden 5 mmol Natriumacetat-Trihydrat (0,680 g) zugegeben und weitere 19 Stunden bei 80 °C, sowie 4 Stunden bei 110 °C gerührt. Dann wird das Lösungsmittel bei 70 °C im Vakuum entfernt und der entstandene Feststoff wird nacheinander mit 2 mL Methanol, 2 mL Tetrahydrofuran und 2 mL Wasser gewaschen und im Vakuum getrocknet. Es entsteht ein weißer Feststoff **82.**

| | | |
|---|---|---|
| **Summenformel:** | C₁₈H₂₄N₈PtBr₂ | M = 707,338 g/mol |
| **Ausbeute:** | 1,348 g (76,2 % d. Th.) | |
| **Schmelzpunkt:** | Zersetzung bei > 400 °C | |

**¹H-NMR** (ppm, d₆-DMSO, 300,13 MHz):
δ = 7,76 (d, 4H, J = 1,8 Hz, NCHCHN); 7,48 (d, 4H, J = 1,8 Hz, NCHCHN); 6,55 (AB, 2H, J = 13,1 Hz, NCH₂N); 6,45 (AB, 2H, J = 13,2 Hz, NCH₂N); 3,33 (s, 12H, CH₃-Gruppe)

| **Elementaranalyse** für C₁₈H₂₄N₈PtBr₂: | | | |
|---|---|---|---|
| | C | H | N |
| berechnet | 30,56 % | 3,42 % | 15,85 % |
| gefunden | 30,51 % | 3,26 % | 15,71 % |

### Bis-(1,1'-Dimethyl-3,3'-methylendiimidazolin-2,2'-diyliden)platin(II)diacetat 83

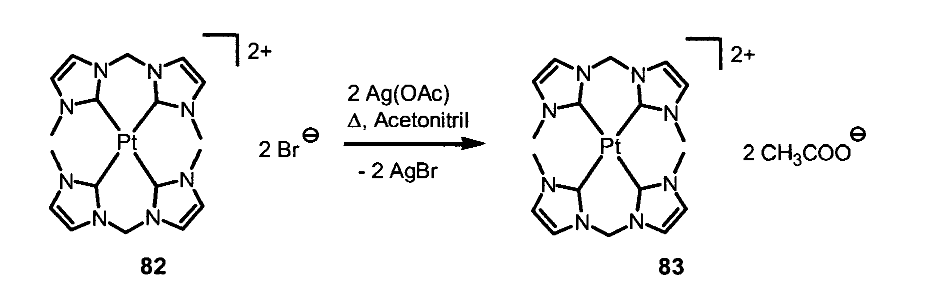

Zu 0,28 mmol Bis-(1,1'-Dimethyl-3,3'-methylendiimidazolin-2,2'-diyliden)platin(II)-dibromid **82** (0,200 g) werden 0,57 mmol Silberacetat (0,094 g) in 6 mL Acetonitril gegeben. Das Gemisch wird unter Lichtausschluss 8 Stunden bei 60 °C gerührt. Das ausfallende Silberbromid, sowie nicht umgesetzte Edukte, werden abfiltriert und das Lösungsmittel wird im Vakuum entfernt. Es entsteht ein weißer Feststoff **83.**

| | | |
|---|---|---|
| **Summenformel:** | C₂₂H₃₀N₈O₄Pt | M = 665,618 g/mol |
| **Ausbeute:** | 0,014 g (7,5 % d. Th.) | |

**¹H-NMR** (ppm, d₆-DMSO, 300,13 MHz):
δ = 7,83 (s, 4H, NCHCHN); 7,48 (s, 4H, NCHCHN); 6,62 (AB, 2H, J = 12,9 Hz, NCH₂N); 6,47 (AB, 2H, J = 12,5 Hz, NCH₂N); 3,33 (s, 12H, CH₃-Gruppe); 1,63 (s, 6H, CH₃COO)

### Bis-(1,1'-Dimethyl-3,3'-methylendiimidazolin-2,2'-diyliden)platin(II)di-trifluoracetat 84

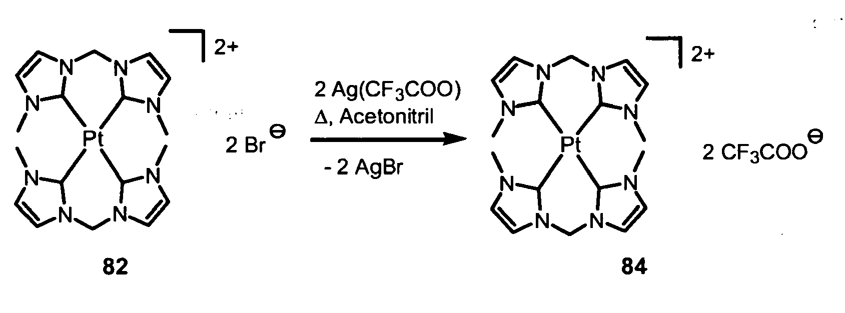

Zu 0,35 mmol Bis-(1,1'-Dimethyl-3,3'-methylendiimidazolin-2,2'-diyliden)platin(II)-dibromid **82** (0,250 g) werden 0,71 mmol Silbertrifluoracetat (0,156 g) in 6 mL Acetonitril gegeben. Das Gemisch wird unter Lichtausschluss 9 Stunden bei 60 °C gerührt. Das ausfallende Silberbromid, sowie nicht umgesetzte Edukte, werden abfiltriert und das Lösungsmittel wird im Vakuum entfernt. Es entsteht ein weißer Feststoff **84.**

| | | |
|---|---|---|
| **Summenformel:** | C₂₂H₂₄N₈O₄F₆Pt | M = 773,570 g/mol |
| **Ausbeute:** | 0,089 g (32,9 % d. Th.) | |
| **Schmelzpunkt:** | Zersetzung bei > 400 °C | |

**¹H-NMR** (ppm, d₆-DMSO, 300,13 MHz):
δ = 7,75 (d, 4H, J = 1,9 Hz, NCHCHN); 7,47 (d, 4H, J = 1,9 Hz, NCHCHN); 6,45 (s, 4H, NCH₂N); 3,32 (s, 12H, CH₃-Gruppe)
**¹⁹F-NMR** (ppm, d₆-DMSO, 282,4 MHz):
δ = -73,39 (CF₃COO)

| **Elementaranalyse** für C₂₂H₂₄N₈O₄F₆Pt: | | | |
|---|---|---|---|
| | C | H | N |
| berechnet | 34,16 % | 3,13 % | 14,49 % |
| gefunden | 32,78 % | 2,93 % | 13,85 % |

### Bis-(1,1'-Dimethyl-3,3'-methylendiimidazolin-2,2'-diyliden)platin(II)ditetrafluoroborat 85

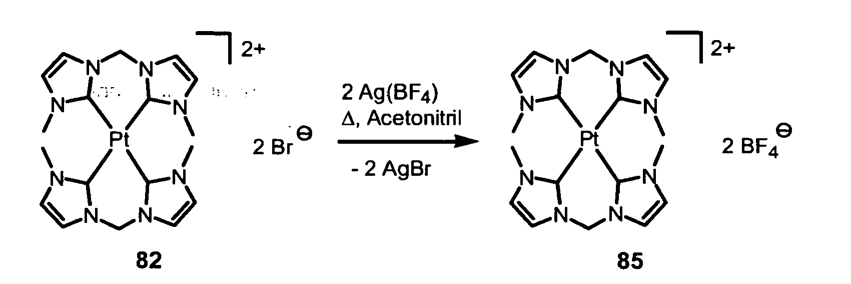

Zu 0,35 mmol Bis-(1,1'-Dimethyl-3,3'-methylendiimidazolin-2,2'-diyliden)platin(II)-dibromid **82** (0,250 g) werden 0,71 mmol Silbertetrafluoroborat (0,138 g) in 6 mL Acetonitril gegeben. Das Gemisch wird unter Lichtausschluss 9 Stunden bei 60 °C gerührt. Das ausfallende Silberbromid, sowie nicht umgesetzte Edukte, werden abfiltriert und das Lösungsmittel wird im Vakuum entfernt. Es entsteht ein weißer Feststoff **85.**

| | | |
|---|---|---|
| **Summenformel:** | C₁₈H₂₄N₈B₂F₈Pt | M = 721,152 g/mol |
| **Ausbeute:** | 0,141 g (55,9 % d. Th.) | |
| **Schmelzpunkt:** | Zersetzung bei > 400 °C | |

**¹H-NMR** (ppm, d₆-DMSO, 300,13 MHz):
δ = 7,75 (d, 4H, J = 1,9 Hz, NCHCHN); 7,48 (d, 4H, J = 1,9 Hz, NCHCHN); 6,49 (AB, 2H, J = 12,9 Hz, NCH₂N); 6,44 (AB, 2H, J = 12,9 Hz, NCH₂N); 3,33 (s, 12H, CH₃-Gruppe)
**¹⁹F-NMR** (ppm, d₆-DMSO, 282,4 MHz):
δ = -148,18, -148,24 (BF₄)

| **Elementaranalyse** für C₁₈H₂₄N₈B₂F₈Pt: | | | |
|---|---|---|---|
| | C | H | N |
| berechnet | 29,98 % | 3,35 % | 15,54 % |
| gefunden | 28,28 % | 3,03 % | 14,47 % |

### 9. weitere heteroleptische Tetracarbenkomplexe

### (1,1'-Dimethyl-3,3'-methylendiimidazolin-2,2'-diyliden)(1",1"'-dimethyl-3",3"'-methylendibenzimidazolin-2",2"'-diyliden)platin(II)diiodid 86

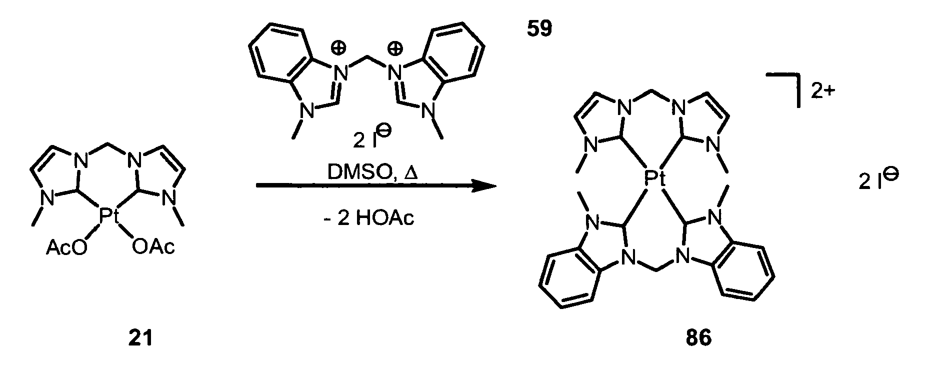

0,43 mmol (1,1'-Dimethyl-3,3'-methylendiimidazolin-2,2'-diyliden)platin(II)diacetat **21** (0,211 g) werden mit 0,43 mmol 1,1'-Methylenbis(3-methyl-1*H*-benzo[*d*]imidazolium)-diiodid **59** (0,229 g) in einem Schlenkrohr vereinigt. Es werden 5 mL Dimethylsulfoxid zugesetzt und das Reaktionsgemisch ist für 3 Stunden bei 50 °C zu rühren und danach 1 Stunde bei 60 °C. Das Lösungsmittel wird bei 70 °C im Vakuum entfernt, der ausfallende Feststoff wird zweimal mit 3 mL Methanol, danach zweimal mit 3 mL Tetrahydrofuran und einmal mit 3 mL Wasser gewaschen und im Vakuum getrocknet. Es entsteht ein weißer Feststoff **86.**

| | | |
|---|---|---|
| **Summenformel:** | C₂₆H₂₈N₈PtI₂ | M = 901,442 g/mol |
| **Ausbeute:** | 0,065 g (16,8 % d. Th.) | |
| **Schmelzpunkt:** | Zersetzung bei > 365 °C | |

**¹H-NMR** (ppm, d₆-DMSO, 300,13 MHz):
δ = 8,40 (d, 2H, ³J_{HH} = 8,1 Hz, arom. CH); 7,84 (d, 2H, J = 1,7 Hz, NCHCHN); 7,75 (d, 2H, ³J_{HH} = 7,8 Hz, arom. CH); 7,58 (m, 4H, ³J_{HH} = 7,2 Hz, arom. CH); 7,54 (d, 2H, J = 1,8 Hz, NCHCHN); 7,45 (s, 1 H, NCH₂N); 6,97 (AB, 1 H, J = 14,0 Hz, NCH₂N); 6,68 (AB, 1 H, J = 13,1 Hz, NCH₂N); 6,54 (AB, 1H, J = 13,3 Hz, NCH₂N); 3,59 (s, 6H, CH₃-Gruppe); 3,38 (s, 6H, CH₃-Gruppe)

| **Elementaranalyse** für C₂₆H₂₈N₈PtI₂: | | | |
|---|---|---|---|
| | C | H | N |
| berechnet | 34,64 % | 3,13 % | 12,43 % |
| gefunden | 30,51 % | 2,87 % | 10,53 % |

### 9. Photolumineszenz-Daten

Um die erfindungsgemäßen Übergangsmetallcarbenkomplexe weiter im verdünnten Festkörper zu charakterisieren, werden entsprechende PVA-Filme enthaltend 2 Gew.-% des jeweiligen Übergangsmetallkomplexes in PVA hergestellt. Für den PVA-Film werden jeweils 2 mg Übergangsmetallcarbenkomplex (37b, 42, 44, 45, 46) pro 1 ml 10%ige (Massenprozent) PVA-Lösung (PVA in voll entsalztem Wasser (VE-Wasser)) gelöst und mit einem 60 µm Rakel ein Film auf einen Objektträger Quarzglas) ausgestrichen. Der Film wird anschließend getrocknet. Die Photolumineszenz-Daten der entsprechenden Übergangsmetallcarbenkomplexe werden an den erhaltenen Filmen ermittelt.

In Tabelle 1 sind die Photolumineszenz-Quantenausbeuten (QY) und die Farbkoordinaten (X_{RGB} und Y_{RGB}) ausgewählter Übergangsmetallcarbenkomplexe der allgemeinen Formel II (2 Gew.-% des jeweiligen Übergangsmetallkomplexes in PVA (Polyvinylalkohol)-Filmen auf Quarzglas) zusammengefasst:

| Beispiel | Ex [nm]¹⁾ | X_{RGB}²⁾ | Y_{RGB}³⁾ | EM [nm]⁴⁾ | QY⁵⁾ |
|---|---|---|---|---|---|
| 37b | 307 | 0,165 | 0,072 | 386 | 45 |
| 44 | 307 | 0,174 | 0,114 | 386 | 7 |
| 45 | 307 | 0,171 | 0,105 | 386 | 40 |
| 46 | 307 | 0,168 | 0,087 | 387 | 39 |
| 42 | 307 | 0,174 | 0,121 | 386 | 6 |

| | | | | | |
|---|---|---|---|---|---|
| 1) Anregungswellenlänge 2) CIE-Koordinaten bei Raumtemperatur 3) CIE-Koordinaten bei Raumtemperatur 4) Emissionswellenlänge 5) Quantenausbeute, Bestrahlung unter N₂ | | | | | |

## Patentansprüche

1. Verwendung von Übergangsmetallcarbenkomplexen ausgewählt aus Übergangsmetallcarbenkomplexen der allgemeinen Formeln I und II in organischen Leuchtdioden 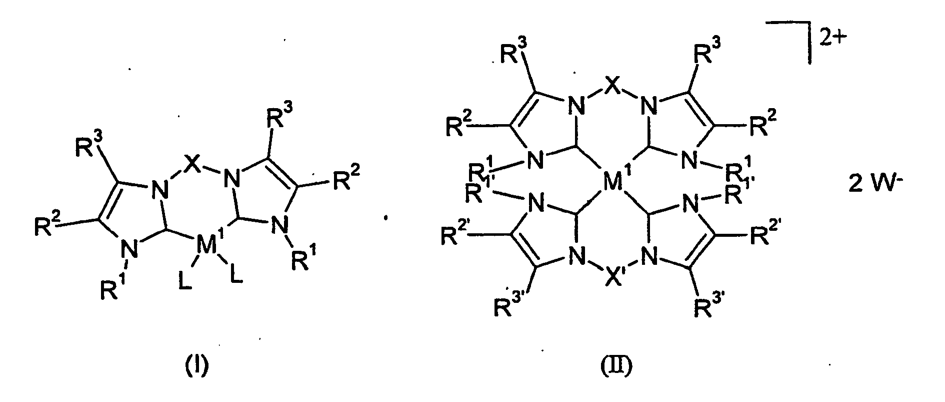 worin die Symbole die folgenden Bedeutungen aufweisen:
M¹ Pt(II), Pd(II);
L monodentater monoanionischer Ligand;
R¹, R^{1'} jeweils unabhängig voneinander Wasserstoff, Alkyl, Cycloalkyl, Aryl, Heteroaryl, Aralkyl;
R², R³, R^{2'} R^{3'} jeweils unabhängig voneinander Wasserstoff, Alkyl, Aryl; oder R² und R³ oder R^{2'} und R^{3'} bilden jeweils gemeinsam eine Brücke aus 3, 4 oder 5 Kohlenstoffatomen, die gesättigt oder ein oder zweifach ungesättigt sein kann und gegebenenfalls mit einem oder mehreren C₁- bis C₆-Alkylresten substituiert sein kann;
X, X' unabhängig voneinander Alkylen, 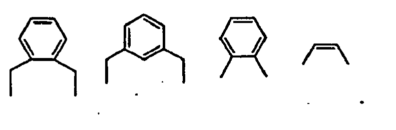
W⁻ monoanionisches Gegenion,
wobei die Übergangsmetallcarbenkomplexe der Formeln (I) und (II) keine Cyclometallierung der Carbenliganden über ein weiteres Kohlenstoff- oder Heteroatom aufweisen.

2. Verwendung nach Anspruch 1, **dadurch gekennzeichnet, dass** die Symbole und Reste R¹, R², R³, R^{1'}, R^{2'}, R³', X, X^{'}, M¹, L und W in den Übergangsmetallcarbenkomplexen der Formeln I und II die folgenden Bedeutungen aufweisen:
M¹ Pt(II); Pd(II), bevorzugt Pt(II);
L unabhängig voneinander ausgewählt aus Halogeniden, Pseudohalogenideen⁻, Alkoxy, CF₃COO⁻ und OAc⁻, bevorzugt Br⁻, I⁻, CF₃COO⁻ und OAc⁻
R¹, R^{1'} unabhängig voneinander Wasserstoff, C₁-C₄-Alkyl, Cyclohexyl, 2,4,6Trimethylphenyl oder Benzyl, bevorzugt Methyl, Iso-Propyl, n-Butyl;
R^{2'} R^{3'} R^{2'}, R^{3'} Wasserstoff;
oder R² und R³ oder R^{2'} und R^{3'} bilden jeweils gemeinsam eine Brücke aus 4 Kohlenstoffatomen, die gesättigt oder ein oder zweifach ungesättigt sein kann und gegebenenfalls mit einem oder mehreren C₁- bis C₆-Alkylresten substituiert sein kann, bevorzugt eine unsubstituierte zweifach ungesättigte Brücke aus 4 Kohlenstoffatomen, die die folgende Struktur aufweist: 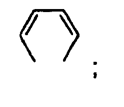
X, X' unabhängig voneinander (CR⁴₂)ₙ, 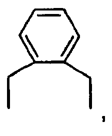 wobei R⁴ H, Alkyl und n 1 bis 3 bedeuten, bevorzugt CH₂, 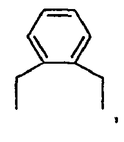 besonders bevorzugt CH₂;
W Halogenid, Pseudohalogenid oder OAc⁻, bevorzugt Cl⁻, Br⁻ , I⁻, CN⁻, OAc⁻, besonders bevorzugt Br⁻ oder I⁻.

3. Verwendung nach Anspruch 1 oder 2, **dadurch gekennzeichnet, dass** ein Übergangsmetallcarbenkomplex der allgemeinen Formel I verwendet wird, worin bedeuten:
M¹ Pt(II), Pd(II);
X CH₂, 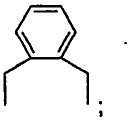
R¹ CH₃, iso-Propyl, n-Butyl, Cyclohexyl, Benzyl, 2,4,6-Trimethylphenyl;
L Br⁻, I⁻, OAc⁻ oder CF₃COO⁻.

4. Verwendung nach Anspruch 1 oder 2, **dadurch gekennzeichnet, dass** ein homoleptischer Übergangsmetallcarbenkompfex der allgemeinen Formel II eingesetzt wird, worin bedeuten:
M¹ Pt(II), Pd(II);
X, X^{'} jeweils CH₂;
R¹, R^{1'} jeweils CH₃, iso-Proypl, n-Butyl, Cyclohexyl, Benzyl oder 2,4,6-Trimethylphenyl;
W⁻ Br⁻ oder I⁻.

5. Verwendung nach Anspruch 1 oder 2, **dadurch gekennzeichnet, dass** ein heteroleptischer Übergangsmetallcarbenkomplex der allgemeinen Formel II eingesetzt wird, worin bedeuten:
M¹ Pt(II), Pd(II);
X, X' jeweils CH₂;
R¹, R^{1'} unabhängig voneinander Methyl, iso-Propyl, n-Butyl, Benzyl, Cyclohexyl, 2,4,6-Trimethylphenyl, wobei die Bedeutungen von R¹ und R^{1'} unterschiedlich sind;
R², R³, R^{2'}, R^{3'} jeweils H;
oder R² und R³ oder R^{2'} und R^{3'} bilden jeweils gemeinsam eine Brücke aus 4 Kohlenstoffatomen, die die folgende Struktur aufweist: 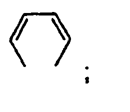
W Br⁻ oder I⁻.

6. Organische Leuchtdiode enthaltend mindestens einen Übergangsmetalicarbenkomplex der allgemeinen Formel I und/oder II gemäß einem der Ansprüche 1 bis 5.

7. Organische Leuchtdiode nach Anspruch 6, **dadurch gekennzeichnet, dass** der mindestens eine Übergangsmetallcarbenkomplex der allgemeinen Formel I und/oder II in der Licht-emittierenden Schicht, einer Blockschicht für Elektronen, einer Blockschicht für Excitonen und/oder einer Blockschicht für Löcher vorliegt.

8. Licht-emittierende Schicht enthaltend mindestens einen Übergangsmetallcarbenkomplex der allgemeinen Formeln I und/oder II gemäß einem der Ansprüche 1 bis 5.

9. Organische Leuchtdiode enthaltend mindestens eine Licht-emittierende Schicht gemäß Anspruch 8.

10. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 6, 7 oder 9.

## Claims

1. The use of transition metal-carbene complexes selected from transition metal-carbene complexes of the general formulae I and II in organic light-emitting diodes 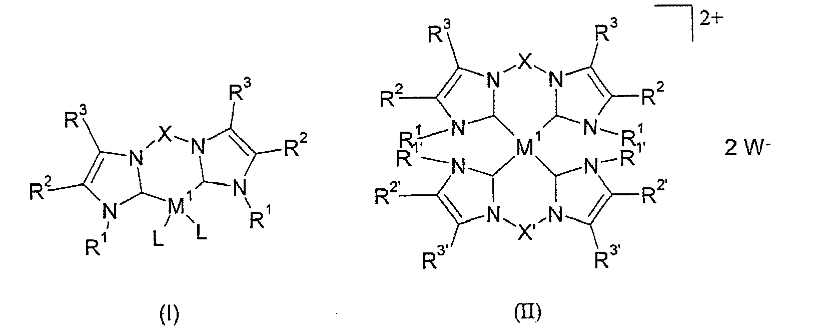 in which the symbols are each defined as follows:
M¹ is Pt(II), Pd(II);
L is a monodentate monoanionic ligand;
R¹, R^{1'} are each independently hydrogen, alkyl, cycloalkyl, aryl, heteroaryl, aralkyl;
R², R³, R^{2'}, R^{3'} are each independently hydrogen, alkyl, aryl;
or R² and R³ or R^{2'} and R^{3'} in each case together form a bridge which is composed of 3, 4 or 5 carbon atoms, may be saturated or mono- or diunsaturated and may optionally be substituted by one or more C₁- to C₆-alkyl radicals;
X, X' are each independently alkylene, 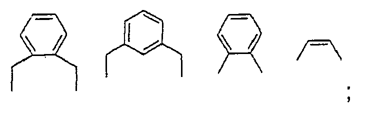
W⁻ is a monoanionic counterion,
where the transition metal-carbene complexes of the formulae (I) and (II) do not have any cyclometalation of the carbene ligands via a further carbon atom or heteroatom.

2. The use according to claim 1, wherein the symbols and radicals R¹, R², R³, R^{1'}, R^{2'}, R^{3'} X, X', M¹, L and W⁻ in the transition metal-carbene complexes of the formulae I and II are each defined as follows:
M¹ is Pt(II), Pd(II), preferably Pt(II);
L are each independently selected from halides, pseudohalides⁻, alkoxy, CF₃COO⁻ and OAc⁻, preferably Br⁻, I⁻, CF₃COO⁻ and OAc⁻,
R¹, R^{1'} are each independently hydrogen, C₁-C₄-alkyl, cyclohexyl, 2,4,6-trimethylphenyl or benzyl, preferably methyl, isopropyl, n-butyl;
R², R³, R^{2'}, R^{3'} are each hydrogen;
or R² and R³ or R^{2'} and R^{3'} in each case together form a bridge which is composed of 4 carbon atoms, may be saturated or mono- or diunsaturated and may optionally be substituted by one or more C₁- to C₆-alkyl radicals, preferably an unsubstituted diunsaturated bridge which is composed of 4 carbon atoms and has the following structure: 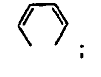
X, X' are each independently (CR⁴₂)ₙ, 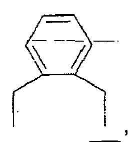 where R⁴ is H, alkyl and n is from 1 to 3, preferably CH₂, 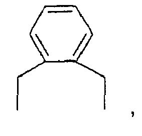 more preferably CH₂;
W⁻ is halide, pseudohalide or OAc⁻, preferably Cl⁻, Br⁻, I⁻, CN⁻, OAc⁻, more preferably Br⁻ or I⁻.

3. The use according to claim 1 or 2, wherein a transition metal-carbene complex of the general formula I is used in which:
M¹ is Pt(II), Pd(II);
X is CH₂, 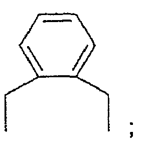
R¹ is CH₃, isopropyl, n-butyl, cyclohexyl, benzyl, 2,4,6-trimethylphenyl;
L is Br⁻, I⁻, OAc or CF₃COO⁻.

4. The use according to claim 1 or 2, wherein a homoleptic transition metal-carbene complex of the general formula II is used in which:
M¹ is Pt(II), Pd(II);
X, X' are each CH₂;
R¹, R^{1'} are each CH₃, isopropyl, n-butyl, cyclohexyl, benzyl or 2,4,6-trimethylphenyl;
W⁻ is Br⁻ or I⁻.

5. The use according to claim 1 or 2, wherein a heteroleptic transition metal-carbene complex of the general formula II is used in which:
M¹ is Pt(II), Pd(II);
X, X' are each CH₂;
R¹, R^{1'} are each independently methyl, isopropyl, n-butyl, benzyl, cyclohexyl, 2,4,6-trimethylphenyl, where the definitions of R¹ and R^{1'} are different;
R², R³, R^{2'}, R^{3'} are each H;
or R² and R³ or R^{2'} and R^{3'} in each case together form a bridge which is composed of 4 carbon atoms and has the following structure: 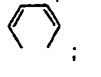
W⁻ is Br⁻ or I⁻.

6. An organic light-emitting diode comprising at least one transition metal-carbene complex of the general formula I and/or II according to any of claims 1 to 5.

7. The organic light-emitting diode according to claim 6, wherein the at least one transition metal-carbene complex of the general formula I and/or II is present in the light-emitting layer, a blocking layer for electrons, a blocking layer for excitons and/or a blocking layer for holes.

8. A light-emitting layer comprising at least one transition metal-carbene complex of the general formulae I and/or II according to any of claims 1 to 5.

9. An organic light-emitting diode comprising at least one light-emitting layer according to claim 8.

10. A device selected from the group consisting of stationary visual display units such as visual display units of computers, televisions, visual display units in printers, kitchen appliances, and also advertising panels, illuminations, information panels and mobile visual display units such as visual display units in cellphones, laptops, digital cameras, vehicles and destination displays on buses and trains, comprising at least one organic light-emitting diode according to claim 6, 7 or 9.

## Revendications

1. Utilisation de complexes carbéniques de métaux de transition choisis parmi les complexes carbéniques de métaux de transition de formules générales I et II dans des diodes électroluminescentes organiques 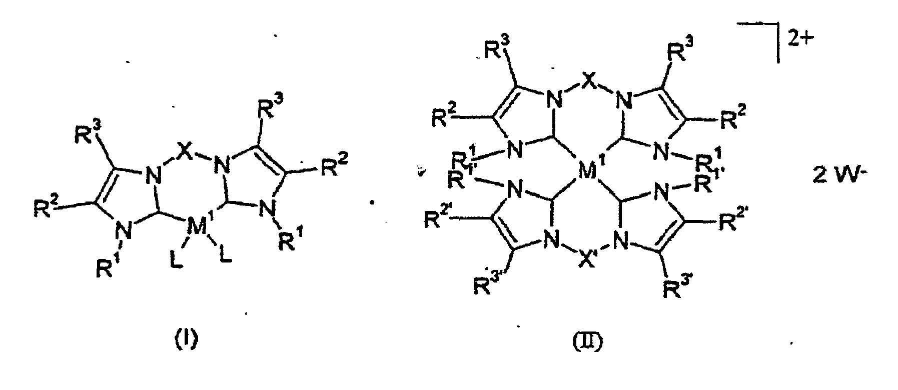 dans lesquelles les symboles ont les significations suivantes :
M¹ Pt (II), Pd (II) ;
L ligand monoanionique monodentate ;
R¹, R¹' à chaque fois indépendamment les uns des autres hydrogène, alkyle, cycloalkyle, aryle, hétéroaryle, aralkyle ;
R², R³, R²' R³' à chaque fois indépendamment les uns des autres hydrogène, alkyle, aryle;
ou R² et R³ ou R², et R³' forment à chaque fois ensemble un pont à partir de 3, 4 ou 5 atomes de carbone, qui peut être saturé ou une ou deux fois insaturé, et qui peut éventuellement être substitué avec un ou plusieurs radicaux alkyle en C₁ à C₆ ;
X, X' indépendamment l'un de l'autre alkylène, 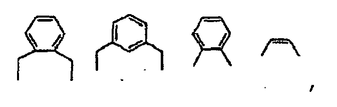
W⁻ un contre-ion monoanionique,
les complexes carbéniques de métaux de transition de formules (I) et (II) ne présentant pas de cyclométallisation des ligands carbène par un atome de carbone ou un hétéroatome supplémentaire.

2. Utilisation selon la revendication 1, **caractérisée en ce que** les symboles et les radicaux R¹, R², R³, R¹', R²', R³', X, X', M¹, L et W⁻ dans les complexes carbéniques de métaux de transition de formules I et II présentent les significations suivantes :
M¹ Pt (II), Pd (II), de préférence Pt (II) ;
L choisis indépendamment les uns des autres parmi les halogénures, les pseudohalogénures, alcoxy, CF₃COO⁻ et OAc⁻, de préférence Br⁻, I⁻, CF₃COO⁻ et OAc⁻ ;
R¹, R¹' indépendamment les uns des autres hydrogène, alkyle en C₁-C₄, cyclohexyle, 2,4,6-triméthylphényle ou benzyle, de préférence méthyle, iso-propyle, n-butyle ;
R², R³, R²', R³' hydrogène ;
ou R² et R³ ou R²' et R³' forment à chaque fois ensemble un pont à partir de 4 atomes de carbone, qui peut être saturé ou une ou deux fois insaturé, et qui peut éventuellement être substitué avec un ou plusieurs radicaux alkyle en C₁ à C₆, de préférence un pont non substitué deux fois insaturé à partir de 4 atomes de carbone, qui présente la structure suivante : 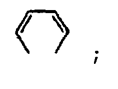
X, X' indépendamment l'un de l'autre (CR⁴₂)ₙ, 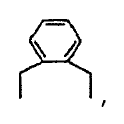 R⁴ signifiant H, alkyle et n signifiant 1 à 3, de préférence CH₂, 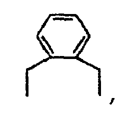 de manière particulièrement préférée CH₂ ;
W⁻ halogénure, pseudohalogénure ou OAc⁻, de préférence Cl⁻, Br⁻, I⁻, CN⁻, OAc⁻, de manière particulièrement préférée Br⁻ ou I⁻.

3. Utilisation selon la revendication 1 ou 2, **caractérisée en ce qu'**un complexe carbénique de métal de transition de formule générale I est utilisé, dans laquelle les variables signifient :
M¹ Pt (II), Pd (II) ;
X CH₂, 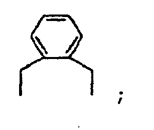
R¹ CH₃, iso-propyle, n-butyle, cyclohexyle, benzyle, 2,4,6-triméthylphényle ;
L Br⁻, I⁻, OAc⁻ ou CF₃COO⁻.

4. Utilisation selon la revendication 1 ou 2, **caractérisée en ce qu'**un complexe carbénique de métal de transition homoleptique de formule générale II est utilisé, dans laquelle les variables signifient :
M¹ Pt (II), Pd (II) ;
X, X' à chaque fois CH₂ ;
R¹, R¹' à chaque fois CH₃, iso-propyle, n-butyle, cyclohexyle, benzyle ou 2,4,6-triméthylphényle ;
W⁻ Br⁻ ou I⁻.

5. Utilisation selon la revendication 1 ou 2, **caractérisée en ce qu'**un complexe carbénique de métal de transition hétéroleptique de formule générale II est utilisé, dans laquelle les variables signifient :
M¹ Pt (II), Pd (II) ;
X, X' à chaque fois CH₂ ;
R¹, R¹' indépendamment les uns des autres méthyle, iso-propyle, n-butyle, benzyle, cyclohexyle, 2,4,6-triméthylphényle, les significations de R¹ et R¹' étant différentes ;
R², R³, R²', R³' à chaque fois H ;
ou R² et R³ ou R²' et R³' forment à chaque fois ensemble un pont à partir de 4 atomes de carbone, qui présente la structure suivante : 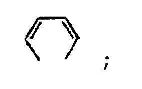
W⁻ Br⁻ ou I⁻.

6. Diode électroluminescente organique contenant au moins un complexe carbénique de métal de transition de formule générale I et/ou II selon l'une quelconque des revendications 1 à 5.

7. Diode électroluminescente organique selon la revendication 6, **caractérisée en ce que** le ou les complexes carbéniques de métaux de transition de formule générale I et/ou II sont présents dans la couche électroluminescente, dans une couche de blocage pour électrons, dans une couche de blocage pour excitons et/ou dans une couche de blocage pour trous.

8. Couche électroluminescente contenant au moins un complexe carbénique de métal de transition de formule générale I et/ou II selon l'une quelconque des revendications 1 à 5.

9. Diode électroluminescente organique contenant au moins une couche électroluminescente selon la revendication 8.

10. Dispositif choisi dans le groupe constitué des écrans stationnaires tels que les écrans d'ordinateur, de télévision, les écrans d'imprimantes, les appareils de cuisine, ainsi que les panneaux publicitaires, les éclairages, les panneaux indicateurs, et les écrans mobiles tels que les écrans dans les téléphones portables, ordinateurs portables, appareil-photos numériques, véhicules, ainsi que les indicateurs de destination dans les bus et les trains, contenant au moins une diode électroluminescente organique selon la revendication 6, 7 ou 9.
